(19) Europäisches Patentamt
European Patent Office
Office européen des brevets

(11) EP 1 580 235 A1

(12) # EUROPEAN PATENT APPLICATION
published in accordance with Art. 158(3) EPC

(43) Date of publication:
**28.09.2005 Bulletin 2005/39**

(21) Application number: **03768377.8**

(22) Date of filing: **26.12.2003**

(51) Int Cl.[7]: **C08L 63/00**, C08J 5/24

(86) International application number:
**PCT/JP2003/017070**

(87) International publication number:
**WO 2004/067631 (12.08.2004 Gazette 2004/33)**

(84) Designated Contracting States:
**AT BE BG CH CY CZ DE DK EE ES FI FR GB GR HU IE IT LI LU MC NL PT RO SE SI SK TR**

(30) Priority: **27.12.2002 JP 2002381838**
**27.12.2002 JP 2002381897**
**27.12.2002 JP 2002381914**
**26.12.2003 JP 2003432554**

(71) Applicant: **TDK Corporation**
**Tokyo 103-8272 (JP)**

(72) Inventors:
- **TAKAYA, Minoru**
**Chuo-ku, Tokyo 103-8272 (JP)**
- **ENDO, Toshikazu**
**Chuo-ku, Tokyo 103-8272 (JP)**
- **KAWABATA, Kenichi**
**Chuo-ku, Tokyo 103-8272 (JP)**

(74) Representative: **Grünecker, Kinkeldey, Stockmair & Schwanhäusser Anwaltssozietät**
**Maximilianstrasse 58**
**80538 München (DE)**

(54) **RESIN COMPOSITION, CURED RESIN, CURED RESIN SHEET, LAMINATE, PREPREG, ELECTRONIC PART, AND MULTILAYER SUBSTRATE**

(57) The invention provides electronic parts which comprise a composite dielectric layer composed of an organic insulating material and a dielectric ceramic powder having a larger relative dielectric constant than the organic insulating material, and which also comprise conductive element sections forming inductor elements, etc., wherein the organic insulating material comprises a cured resin obtained by curing reaction of an epoxy resin with an active ester compound obtained by reaction between a compound with two or more carboxyl groups and a compound with a phenolic hydroxyl group. The dielectric ceramic powders of the described electronic parts have larger relative dielectric constants than the organic insulating materials, and the organic insulating materials have low dielectric loss tangents. It is possible to adequately reduce time-dependent dielectric constant changes in the high-frequency range of 100 MHz and above even with prolonged use at high temperatures of 100°C and higher, while it is also possible to satisfactorily prevent deformation and other damage to the electronic parts during their handling.

***Fig.2***

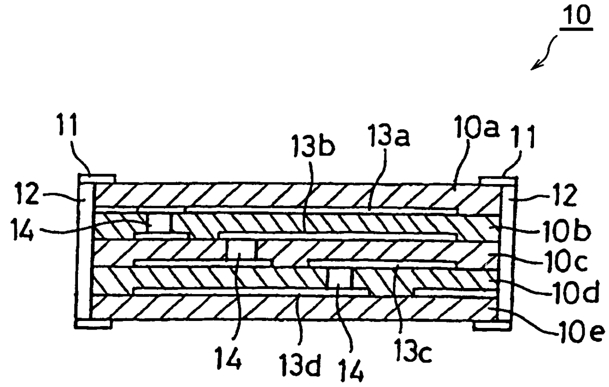


EP 1 580 235 A1

## Description

### Technical Field

The present invention relates to a resin composition, a cured resin, a sheet-like cured resin, a laminated body, a prepreg, electronic parts and multilayer boards, and more specifically, it relates to a resin composition, a cured resin, a sheet-like cured resin, a laminated body, a prepreg, electronic parts and multilayer boards which are useful in the high-frequency range of 100 MHz and above.

### Background Art

The rapid increase in communication of information in recent years has led to a strong demand for smaller and more lightweight communicating devices and a concomitant demand for smaller and more lightweight electronic parts. At the same time, electromagnetic waves in the high-frequency range of the gigahertz band have come to be utilized for portable mobile communications and satellite communications.

In order to handle such high-frequency electromagnetic waves, it is essential for electronic parts to have low energy loss and transmission loss. Specifically, electronic parts undergo transmission loss during the course of transmission, known as dielectric loss, and this transmission loss is undesirable because it results in energy waste from the electronic parts in the form of heat and can result in heat buildup in the electronic part.

Transmission loss is generally expressed by the following formula:

$$\text{Transmission loss} = \text{Coefficient} \times \text{Frequency} \times (\text{Dielectric constant})^{1/2} \times \text{Dielectric loss tangent}$$

In order to reduce transmission loss, therefore, it is necessary to lower the dielectric constant and dielectric loss tangent.

However, achieving smaller and more lightweight electronic parts requires an increase in electrostatic capacitance per unit area, and thus a smaller electrode area.

Capacitance is generally expressed by the following formula:

$$\text{Capacitance} = \text{Dielectric constant in vacuum} \times \text{relative dielectric constant of material} \times \text{electrode area}/\text{insulating layer thickness}$$

In order to increase capacitance, therefore, it is necessary to increase the relative dielectric constant.

Consequently, in order to achieve reduced transmission loss in the high-frequency range as well as a smaller and more lightweight electronic part, it is desirable to utilize a material with a satisfactory balance between higher dielectric constant and lower dielectric loss tangent.

Commonly known materials with high dielectric constants include polyvinylidene fluoride, trifluoroethylene-tetrafluoroethylene copolymer, cyano group-containing polymers and the like, but they cannot be considered suitable for use as insulating materials for electronic parts because of inherent problems from the standpoint of frequency characteristics, low dielectric loss tangent and heat resistance.

As materials with low dielectric constants there are known various types of resins including thermoplastic resins such as polyolefins, vinyl chloride resins, fluorine resins, syndiotactic polystyrene and aromatic polyester resins, as well as unsaturated polyester resins, polyimide resins, epoxy resins, bismaleimidetriazine resins (BT resins), crosslinking polyphenylene oxide, curable polyphenylene oxide, polyvinylbenzyl ether resins, benzocyclobutene resins and the like, but these are not only unsuited for utilization of electromagnetic waves in the high-frequency range as mentioned above, but at the current time they fail to satisfy all of the basic aspects of performance required for electronic parts, such as heat resistance, thin-film workability, chemical resistance, insulation, low dielectric loss tangent and low moisture absorption, while it is currently difficult to realize both high dielectric constants and low dielectric loss tangents when using such resins alone.

As a means of satisfying the basic aspects of performance required for electronic parts while achieving a high dielectric constant and low dielectric loss tangent in a composite dielectric layer, there is known the technique of dispersing a dielectric ceramic powder into a polyvinylbenzyl ether compound, as the insulating material composing a

composite dielectric layer for electronic parts (Japanese Unexamined Patent Publication No. 2001-247733).

**Disclosure of the Invention**

The present inventors have found that there still exists room for improvement in the properties of electronic parts employing the composite dielectric layer described in the aforementioned prior art publication.

Specifically, although electronic parts employing the composite dielectric layer described in this prior art publication exhibit a high dielectric constant and low dielectric loss tangent, there is still room for improvement in terms of the flexural strength and the dielectric properties when used at high temperatures. That is, the handling properties and consistency of performance with high temperature use of the aforementioned prior art electronic parts are still in need of improvement.

In addition, despite the satisfactory electrical properties, such as the dielectric constant and dielectric loss tangent (tanδ), of the composite dielectric layer in electronic parts employing the composite dielectric layer described in the aforementioned prior art publication, such materials exhibit no superiority in terms of strength. Much room for improvement has therefore existed from the standpoint of the strength of the electronic parts described in the aforementioned publication.

Furthermore, the above-mentioned composite dielectric layer does not exhibit sufficient flexural strength or flexural modulus, and can therefore also be improved from the viewpoint of its adhesion with copper foils (peel strength, etc.).

Moreover, the above-mentioned composite dielectric layer is also in need of improvement of other properties since, for example, its glass transition temperature, which corresponds to heat resistance, is not sufficiently high. This is true even when reinforcing fibers are distributed in the composite dielectric layer.

It is an object of the present invention to provide a resin composition, a cured resin, a sheet-like cured resin, a laminated body, a prepreg, electronic parts and multilayer boards, whereby electronic parts with adequately improved properties can be achieved.

In order to achieve the object stated above, the present invention provides a resin composition comprising a curable mixture containing an epoxy resin and an active ester compound obtained by reaction between a compound with a phenolic hydroxyl group and a compound with two or more groups which form ester bonds by reaction with the phenolic hydroxyl group, with a dielectric ceramic powder distributed in the curable mixture.

The epoxy resin and active ester compound in the resin composition of the invention yield a high-molecularized reaction product upon reaction (curing reaction). Consequently, the aforementioned curable mixture containing the epoxy resin and active ester compound is a curable mixture which is converted to a matrix resin by the reaction, such that the dielectric ceramic powder is dispersed in the matrix resin after the curing reaction.

Since the reaction product has a low dielectric constant and dielectric loss tangent, and dielectric ceramic powder is dispersed in the reaction product, the cured resin composition as a whole exhibits a high dielectric constant and low dielectric loss tangent in the high-frequency gigahertz range. In addition, since an active ester compound is used for curing of the epoxy resin, no hydroxyl groups are produced by ring opening of the epoxy groups during the curing reaction, and the dielectric properties are therefore less affected by temperature or humidity.

Furthermore, since the reaction product of the epoxy resin and active ester compound has a larger molecular weight than the aforementioned polyvinylbenzyl ethers and also permits introduction of a crosslinked structure, the cured resin composition of the invention exhibits high heat resistance with an increased glass transition temperature or kick-off temperature. Also, since it contains an epoxy resin which has excellent cohesion with substrates such as metal foils, the resin composition of the invention exhibits excellent adhesion for metal foils.

According to the invention, the active ester compound is preferably an aromatic active ester compound represented by the following general formula (1).

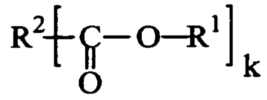

··· (1)

[wherein k represents an integer of 2-4, $R^1$ represents naphthyl optionally having at least one substituent selected from the group consisting of halogen atoms and alkyl groups, or phenyl optionally having at least one substituent selected from the group consisting of halogen atoms, alkyl groups and phenyl groups (where the phenyl groups may be optionally substituted with halogen atoms and/or alkyl groups), and $R^2$ represents a divalent to tetravalent group containing 1 to 3 aromatic rings (where the aromatic rings may be optionally substituted with halogen atoms and/or alkyl groups), with the proviso that when $R^2$ contains more than one aromatic ring, the aromatic rings either form fused rings or are bonded

by at least one bond selected from the group consisting of ether bonds, thioether bonds, sulfone bonds, carbonyl bonds and single bonds.]

By using the aforementioned aromatic active ester compound as the active ester compound, not only is the dielectric constant higher and the dielectric loss tangent lower in the high-frequency gigahertz range, but the heat resistance, glass transition temperature and kick-off temperature are further increased due to the presence of the aromatic ring.

The dielectric ceramic powder is a metal oxide powder comprising at least one metal selected from the group consisting of magnesium, silicon, aluminum, titanium, zinc, calcium, strontium, zirconium, barium, tin, neodymium, bismuth, lithium, samarium and tantalum, and it is preferably a metal oxide powder having a dielectric constant of 3.7-300 and a Q value of 500-100,000. These dielectric constant and Q values are the values in the gigahertz band, and according to the invention, the gigahertz band is the high-frequency band from 100 MHz to 10 GHz. The content of the dielectric ceramic powder is preferably 5-185 parts by volume with respect to 100 parts by volume as the total of the epoxy resin and the active ester compound. By using such a dielectric ceramic powder, and with a dielectric ceramic powder content in the aforementioned specified range, it is possible to increase the degree of higher dielectric constant and lower dielectric loss tangent. This results in a resin composition viscosity for suitable manageability.

The resin composition of the invention preferably further comprises a polyarylate. The polyarylate comprises a plurality of repeating units represented by -X-Y composed of structural unit X and structural unit Y (The plurality of each of the structural units X and structural units Y may be the same or different.), where the structural unit X is preferably a phthaloyl group, isophthaloyl group or terephthaloyl group represented by the following formula (2) (wherein the number of moles of terephthaloyl groups constitutes less than 40 mole percent of the total moles of the phthaloyl, isophthaloyl and terephthaloyl groups), and the structural unit Y is preferably a divalent group represented by the following general formula (3).

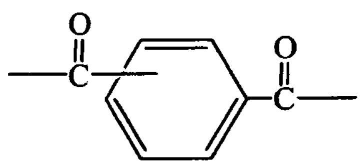 ··· (2)

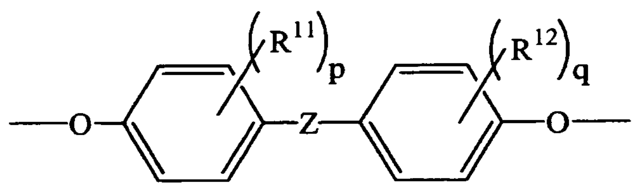 ··· (3)

In these formulas, $R^{11}$ and $R^{12}$ each independently represent C1-4 alkyl, alkoxy or a halogen, Z represents a single bond, ether bond, thioether bond, sulfone bond or carbonyl bond, and p and q each independently represent an integer of 0-4, with the proviso that when more than one $R^{11}$, $R^{12}$ and Z are present in the polyarylate, $R^{11}$, $R^{12}$ and Z may be the same or different. Most preferably, $R^{11}$ and $R^{12}$ are both methyl and Z is a single bond. Addition of the polyarylate to the resin composition will increase the flexibility and pliability in the B stage state, thus resulting in satisfactory handling properties.

When the resin composition comprises a polyarylate, the content of the dielectric ceramic powder is preferably 5-185 parts by volume with respect to 100 parts by volume as the total of the epoxy resin, active ester compound and polyarylate. With a dielectric ceramic powder content in the aforementioned specified range, it is possible to further increase the dielectric constant and further reduce the dielectric loss tangent. This results in a resin composition viscosity for suitable manageability.

One or more additives selected from the group consisting of coupling agents, curing accelerators, flame retardants, flexibilizers and organic solvents may also be added to the resin composition of the invention, and when a coupling agent is added, at least a portion of the coupling agent is preferably bonded or adsorbed onto the surface of the dielectric ceramic powder.

Addition of a coupling agent can improve the wettability or interfacial adhesion of the dielectric ceramic powder in the resin composition before or after curing, while a curing accelerator will speed the curing reaction between the epoxy resin and active ester compound. Addition of a flame retardant can improve the flame retardance, and addition of a flexibilizer can enhance the handling properties of the resin composition before and after curing, while also ameliorating the fragility of the cured composition for better toughness.

The invention also provides a cured resin obtained by partially completing the curing reaction between the epoxy resin and active ester compound in the aforementioned resin composition, and a sheet-like cured resin comprising the aforementioned cured resin shaped into the form of a sheet. The sheet-like cured resin may have a thickness of 5-200 μm, and one or both sides of the sheet-like cured resin may be bonded to a metal foil to form a laminated body. It may also be used as a prepreg since the cured resin is a "B stage" resin in which the curing reaction between the epoxy resin and the active ester compound has been partially completed.

The invention still further provides a cured resin obtained by fully completing the curing reaction between the epoxy resin and active ester compound in the aforementioned resin composition, and a sheet-like resin cured resin comprising the aforementioned cured resin shaped into the form of a sheet. The sheet-like cured resin may have a thickness of 5-1000 μm, and one or both sides of the sheet-like cured resin may be bonded to a metal foil to form a laminated body. The cured resin exhibits a high dielectric constant and low dielectric loss tangent in the high-frequency gigahertz range, and the dielectric properties are less affected by temperature or humidity. In addition, it exhibits high heat resistance and a satisfactory glass transition temperature and kick-off temperature. Bonding between the sheet-like cured resin and metal foil in the laminated body is particularly satisfactory.

In order to achieve the objects stated above, the invention provides a prepreg obtained by semi-curing of a resin composition comprising a curable mixture containing an epoxy resin and an active ester compound obtained by reaction between a compound with a phenolic hydroxyl group and a compound with two or more groups which form ester bonds by reaction with the phenolic hydroxyl group, with a dielectric ceramic powder and reinforcing fibers distributed in the curable mixture.

The invention further provides a prepreg comprising a reinforcing fiber fabric consisting of woven reinforcing fibers, and a resin layer formed on both sides of the reinforcing fiber fabric, wherein the resin layer is a resin layer obtained by semi-curing of a resin composition comprising a curable mixture containing an epoxy resin and an active ester compound obtained by reaction between a compound with a phenolic hydroxyl group and a compound with two or more groups which form ester bonds by reaction with the phenolic hydroxyl group, with a dielectric ceramic powder distributed in the curable mixture. The resin layer in the prepreg preferably has a thickness of 5-100 μm, and the reinforcing fiber fabric preferably has a thickness of 20-300 μm.

The epoxy resin and active ester compound in the aforementioned prepreg of the invention are the constituents of the curable mixture. Specifically, the epoxy resin reacts with the active ester compound (curing reaction) to yield a high-molecularized reaction product.

Since the reaction product has a low dielectric constant and dielectric loss tangent, and dielectric ceramic powder is dispersed in the reaction product with reinforcing fibers also distributed therein, the cured prepreg as a whole exhibits a high dielectric constant and low dielectric loss tangent in the high-frequency gigahertz range. In addition, since an active ester compound is used for curing of the epoxy resin, no hydroxyl groups are produced by ring opening of the epoxy groups during the curing reaction, and the dielectric properties are therefore less affected by temperature or humidity.

Furthermore, since the reaction product of the epoxy resin and active ester compound has a larger molecular weight than the aforementioned polyvinylbenzyl ethers and also permits introduction of a crosslinked structure, the cured prepreg of the invention exhibits high heat resistance with an increased glass transition temperature. Also, since it contains an epoxy resin which has excellent cohesion with substrates such as metal foils, the prepreg of the invention exhibits excellent adhesion for metal foils.

According to the invention, the active ester compound is preferably an aromatic active ester compound represented by the following general formula (1).

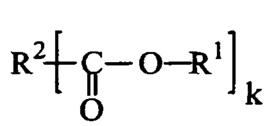 ··· (1)

[wherein k represents an integer of 2-4, $R^1$ represents naphthyl optionally having at least one substituent selected from the group consisting of halogen atoms and alkyl groups, or phenyl optionally having at least one substituent selected from the group consisting of halogen atoms, alkyl groups and phenyl groups (where the phenyl groups may be optionally substituted with halogen atoms and/or alkyl groups), and $R^2$ represents a divalent to tetravalent group containing 1 to 3 aromatic rings (where the aromatic rings may be optionally substituted with halogen atoms and/or alkyl groups), with the proviso that when $R^2$ contains more than one aromatic ring, the aromatic rings either form fused rings or are bonded by at least one bond selected from the group consisting of ether bonds, thioether bonds, sulfone bonds, carbonyl bonds and single bonds.]

By using the aforementioned aromatic active ester compound as the active ester compound, not only is the dielectric constant higher and the dielectric loss tangent lower in the high-frequency gigahertz range, but the glass transition temperature is further increased due to the presence of the aromatic ring.

The dielectric ceramic powder is a metal oxide powder comprising at least one metal selected from the group consisting of magnesium, silicon, aluminum, titanium, zinc, calcium, strontium, zirconium, barium, tin, neodymium, bismuth, lithium, samarium and tantalum, and it is preferably a metal oxide powder having a dielectric constant of 3.7-300 and a Q value of 500-100,000. These dielectric constant and Q values are the values in the gigahertz band, and according to the invention, the gigahertz band is the high-frequency band from 100 MHz to 10 GHz. The content of the dielectric ceramic powder is preferably 5-100 parts by volume with respect to 100 parts by volume as the total of the epoxy resin and the active ester compound. By using such a dielectric ceramic powder, and with a dielectric ceramic powder content in the aforementioned specified range, it is possible to increase the degree of higher dielectric constant and lower dielectric loss tangent. This results in a prepreg viscosity for suitable manageability.

The resin composition of the prepreg of the invention preferably further comprises a polyarylate. The polyarylate comprises a plurality of repeating units represented by -X-Y composed of structural unit X and structural unit Y (The plurality of each of the structural units X and structural units Y may be the same or different.), where the structural unit X is preferably a phthaloyl group, isophthaloyl group or terephthaloyl group represented by the following formula (2) (wherein the number of moles of terephthaloyl groups constitutes less than 40 mole percent of the total moles of the phthaloyl, isophthaloyl and terephthaloyl groups), and the structural unit Y is preferably a divalent group represented by the following general formula (3).

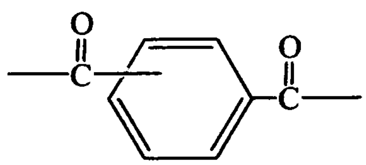

··· (2)

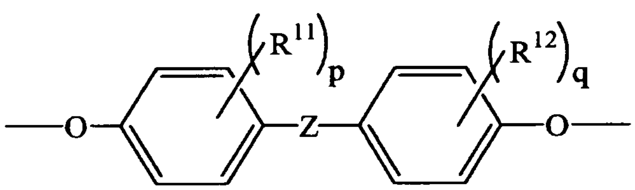

··· (3)

In these formulas, $R^{11}$ and $R^{12}$ each independently represent C1-4 alkyl, alkoxy or a halogen, Z represents a single bond, ether bond, thioether bond, sulfone bond or carbonyl bond, and p and q each independently represent an integer of 0-4, with the proviso that when more than one $R^{11}$, $R^{12}$ and Z are present in the polyarylate, $R^{11}$, $R^{12}$ and Z may be the same or different. Most preferably, $R^{11}$ and $R^{12}$ are both methyl and Z is a single bond. Addition of the polyarylate to the prepreg can add toughness to the prepreg and improve the handling properties.

When the resin composition of the prepreg comprises a polyarylate, the content of the dielectric ceramic powder is preferably 5-100 parts by volume with respect to 100 parts by volume as the total of the epoxy resin, active ester compound and polyarylate. With a dielectric ceramic powder content in the aforementioned specified range, it is possible to further increase the dielectric constant and further reduce the dielectric loss tangent. It also results in a prepreg viscosity for suitable manageability.

One or more additives selected from the group consisting of coupling agents, curing accelerators, flame retardants and flexibilizers may also be added to the resin composition, and when a coupling agent is added, at least a portion of the coupling agent is preferably bonded or adsorbed onto the surface of the dielectric ceramic powder.

Addition of a coupling agent can improve the wettability or interfacial adhesion of the dielectric ceramic powder in the prepreg before or after curing, while a curing accelerator will speed the curing reaction between the epoxy resin and active ester compound. Addition of a flame retardant can improve the flame retardance, and addition of a flexibilizer can enhance the handling properties of the prepreg before and after curing, while also ameliorating the fragility of the cured prepreg for better toughness.

The reinforcing fibers are preferably at least one type of reinforcing fibers selected from the group consisting of E glass fibers, D glass fibers, NE glass fibers, H glass fibers, T glass fibers and aramid fibers. Such reinforcing fibers have excellent dispersability in the resin composition and can increase the strength of the cured prepreg.

The invention further provides a sheet-like cured resin comprising the aforementioned cured prepreg shaped

into the form of a sheet. The sheet-like cured resin may have a thickness of 30-10,000 μm, and one or both sides of the sheet-like cured resin may be bonded to a metal foil to form a laminated body. The sheet-like cured resin exhibits a high dielectric constant and low dielectric loss tangent in the high-frequency gigahertz range, and its dielectric properties are minimally affected by temperature or humidity. It also has high heat resistance and a high glass transition temperature. Bonding between the sheet-like cured resin and metal foil in the aforementioned laminated body in particular is satisfactory.

As a result of continued avid development focused on materials for composite dielectric layers used especially in electronic parts, with the aim of achieving the objects stated above, the present inventors have discovered that the problems described above can be overcome if a dielectric ceramic powder is added to an organic insulating material comprising a specific cured resin, and have succeeded in completing the present invention.

More specifically, the invention relates to electronic parts which are provided with at least one composite dielectric layer containing an organic insulating material and a dielectric ceramic powder having a larger relative dielectric constant than the organic insulating material, and at least one conductive element section formed on the composite dielectric layer and constituting a capacitor element or inductor element, wherein the organic insulating material comprises a cured resin obtained by curing reaction between an epoxy resin and an active ester compound which is itself obtained by reaction between a compound having two or more carboxyl groups and a compound having a phenolic hydroxyl group. The invention may also be characterized by electronic parts which are provided with at least one composite dielectric layer containing an organic insulating material and a dielectric ceramic powder having a larger relative dielectric constant than the organic insulating material, at least one conductive element section formed on the composite dielectric layer, and an electrical element electrically connected to the conductive element section, wherein the organic insulating material comprises a cured resin obtained by curing reaction between an epoxy resin and an active ester compound which is itself obtained by reaction between a compound having two or more carboxyl groups and a compound having a phenolic hydroxyl group. In an electronic part according to the invention, the active ester compound may also be obtained by reaction between a compound having a phenolic hydroxyl group and a compound having two or more groups which react with the phenolic hydroxyl group to form an ester bond. As groups which react with phenolic hydroxyl groups to form ester bonds there may be mentioned carboxyl groups and haloformyl (chloroformyl, etc.) groups.

Since the dielectric ceramic powder in this manner of electronic part has a larger relative dielectric constant than the cured resin-comprising organic insulating material while the organic insulating material has a low dielectric loss tangent, the composite dielectric layer exhibits a high dielectric constant and a low dielectric loss tangent even in the high-frequency gigahertz range. Consequently, transmission loss in the electronic part is reduced and the electronic part can be made smaller and more lightweight. In addition, it is possible to adequately minimize time-dependent changes in the relative dielectric constant in the high-frequency range of 100 MHz and above even with prolonged use at high temperatures of 100°C and higher. Moreover, since the electronic part has increased flexural strength, the handling properties of the electronic part are improved and it becomes possible to satisfactorily prevent damage or deformation of the electronic part.

The active ester compound in the electronic part described above is preferably an aromatic active ester compound represented by the following general formula (1).

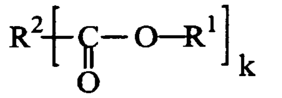

··· (1)

[wherein k represents an integer of 2-4, $R^1$ represents naphthyl optionally having at least one substituent selected from the group consisting of halogen atoms and alkyl groups, or phenyl optionally having at least one substituent selected from the group consisting of halogen atoms, alkyl groups and phenyl groups (where the phenyl groups may be optionally substituted with halogen atoms and/or alkyl groups), and $R^2$ represents a divalent to tetravalent group containing 1 to 3 aromatic rings (where the aromatic rings may be optionally substituted with halogen atoms and/or alkyl groups), with the proviso that when $R^2$ contains more than one aromatic ring, the aromatic rings either form fused rings or are bonded by at least one bond selected from the group consisting of ether bonds, thioether bonds, sulfone bonds, carbonyl bonds and single bonds.]

By using the aforementioned aromatic active ester compound as the active ester compound, not only is the reduction in the dielectric loss tangent of the cured resin in the high-frequency gigahertz range notable, but the heat resistance, glass transition temperature and kick-off temperature are further increased due to the presence of the aromatic ring.

The dielectric ceramic powder in the electronic part described above is a metal oxide powder comprising at

least one metal selected from the group consisting of magnesium, silicon, aluminum, titanium, zinc, calcium, strontium, zirconium, barium, tin, neodymium, bismuth, lithium, samarium and tantalum, and it is preferably a metal oxide powder having a dielectric constant of 3.7-300 and a Q value of 500-100,000. The dielectric ceramic powder is preferably added at 5-185 parts by volume with respect to 100 parts by volume of the organic resin material. These dielectric constant and Q values are the values in the gigahertz band, where according to the invention, the gigahertz band is the high-frequency band from 100 MHz to 10 GHz.

By using such a dielectric ceramic powder in the electronic part described above, and with addition of the dielectric ceramic powder to the organic insulating material in the aforementioned specified range, it is possible to increase the degree of higher dielectric constant and lower dielectric loss tangent.

The cured resin is obtained by curing reaction between the epoxy resin and the active ester compound in the presence of an additive, where the additive is at least one additive selected from the group consisting of curing accelerators, surface treatment agents, flame retardants and flexibilizers.

A curing accelerator will speed the curing reaction between the epoxy resin and active ester compound. Addition of a surface treatment agent can improve the wettability or interfacial adhesion of the dielectric ceramic powder in the cured resin. Addition of a flame retardant can improve the flame retardance, and addition of a flexibilizer can enhance the handling properties of the cured resin, while also ameliorating the fragility of the cured resin for better toughness.

The organic insulating material of the electronic part described above preferably further contains a polyarylate. This will increase the flexibility and pliability in the B stage state, thus resulting in satisfactory handling properties.

The polyarylate comprises a plurality of repeating units represented by -X-Y composed of structural unit X and structural unit Y (The plurality of each of the structural units X and structural units Y may be the same or different.), where the structural unit X is preferably a phthaloyl group, isophthaloyl group or terephthaloyl group represented by the following formula (2) (wherein the number of moles of terephthaloyl groups constitutes less than 40 mole percent of the total moles of the phthaloyl, isophthaloyl and terephthaloyl groups),

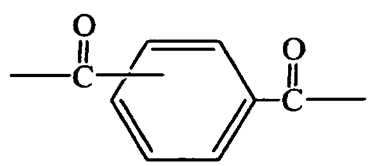

··· (2)

and the structural unit Y is preferably a divalent group represented by the following general formula (3).

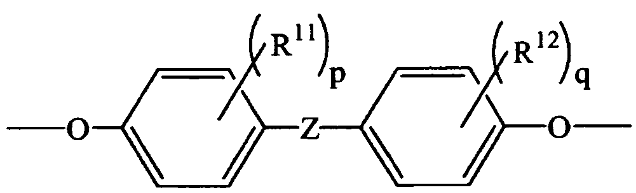

··· (3)

[wherein $R^{11}$ and $R^{12}$ each independently represent $C_{1-4}$ alkyl, alkoxy or a halogen, Z represents a single bond, ether bond, thioether bond, sulfone bond or carbonyl bond, and p and q each independently represent an integer of 0-4, with the proviso that when more than one $R^{11}$, $R^{12}$ and Z are present in the polyarylate, $R^{11}$, $R^{12}$ and Z may be the same or different.]

A polyarylate having the structure described above can impart toughness to the prepreg and improve the handling properties, as compared to polyarylates having structures other than the one described above.

Preferably, $R^{11}$ and $R^{12}$ in general formula (3) above are both methyl and Z is a single bond.

This will yield a prepreg with particularly high toughness and improved handling properties.

The composite dielectric layer preferably further comprises a magnetic powder dispersed in the organic insulating material.

Magnetic powder can impart a magnetic property to the composite dielectric layer, reduce the linear expansion coefficient and improve the material strength.

The composite dielectric layer preferably further comprises a cloth made of reinforcing fibers.

The cloth made of reinforcing fibers increases the flexural strength of the composite dielectric layer, and

therefore adequately prevents deformation or damage of the electronic part.

As a result of further avid research with the aim of achieving the objects stated above, the present inventors have discovered that the problems referred to above can be overcome by multilayer boards and electronic parts having a construction as described hereunder, and have succeeded in completing the present invention.

More specifically, the invention relates to multilayer boards and electronic parts constructed by laminating at least one resin-containing first dielectric layer, at least one resin-containing second dielectric layer and at least one conductor layer, wherein the dielectric loss tangent tanδ of the second dielectric layer is no greater than 0.01 and the critical flexure of the first dielectric layer is at least 1.3 times that of the second dielectric layer.

For such multilayer boards and electronic parts, the critical flexure of the first dielectric layer is at least 1.3 times that of the second dielectric layer, and the dielectric loss tangent tanδ of the second dielectric layer is no greater than 0.01. That is, multilayer boards and electronic parts according to the invention comprise a dielectric layer with excellent mechanical strength and a dielectric layer with excellent electrical properties. It is therefore possible to satisfactorily maintain electrical properties while adequately preventing damage of the multilayer boards or electronic parts, even when excessive loads are applied after completion of the products.

The second dielectric layer may further comprise a ceramic powder with a larger dielectric constant than the resin. This will allow the electrical properties to be satisfactorily maintained even when a resin with a low dielectric constant is used.

The aforementioned multilayer boards and electronic parts have two outermost layers, preferably with at least one of the two outermost layers being composed of the aforementioned first dielectric layer and at least one second dielectric layer being situated between the two outermost layers. This can adequately prevent damage of the multilayer boards or electronic parts, even when excessive loads are applied to the multilayer boards or electronic parts.

The peel strength of the first dielectric layer in such multilayer boards and electronic parts is preferably at least 1.5 times the peel strength of the second dielectric layer. This can satisfactorily maintain the electrical properties while even more adequately preventing damage of the multilayer boards or electronic parts, even when excessive loads are applied after completion of the products.

The invention also relates to multilayer boards and electronic parts constructed by laminating two resin-containing first dielectric layers, at least one resin-containing second dielectric layer situated between the two first dielectric layers, and at least one conductor layer, wherein at least one of the two first dielectric layers constitutes the outermost layer, the dielectric loss tangent tanδ of the second dielectric layers is no greater than 0.01 and the peel strengths of the first dielectric layers are at least 1.5 times the peel strengths of the second dielectric layers. For such multilayer boards and electronic parts, the peel strengths of the first dielectric layers are at least 1.5 times the peel strengths of the second dielectric layers and the dielectric loss tangents tanδ of the second dielectric layers are no greater than 0.01. That is, multilayer boards and electronic parts according to the invention comprise dielectric layers with excellent mechanical strength and dielectric layers with excellent electrical properties. It is therefore possible to satisfactorily maintain electrical properties while adequately preventing damage of the multilayer boards or electronic parts, even when excessive loads are applied after completion of the products.

The peel strengths of the first dielectric layers in such multilayer boards and electronic parts are preferably at least 8 N/cm. This will further increase the anchoring strength and peel strength of mounted passive elements and active elements, as well as the electrode strengths of the multilayer boards and electronic parts, as compared to when the peel strengths of the first dielectric layers are less than 8 N/cm.

The invention also relates to electronic parts which are provided with the aforementioned multilayer boards and electrical elements formed on the multilayer boards. In this case as well, since the multilayer boards comprise dielectric layers with excellent mechanical strength and dielectric layers with excellent electrical properties, it is possible to satisfactorily maintain electrical properties while adequately preventing damage of the multilayer boards or electronic parts, even when excessive loads are applied to the electronic parts after completion of the products.

For the multilayer boards and electronic parts of the invention, the critical flexure is the flexure required to break the first dielectric layers or second dielectric layers, or to create damage (cracking) in the first dielectric layers or second dielectric layers, wherein the flexing is accomplished by application of a load on the first dielectric layers or second dielectric layers cut to a flat rectangular shape having dimensions of 100 mm length, 75 mm width and 0.6 mm thickness, and laminated with a 12 μm thick Cu foil. The flexure referred to here is the flexure obtained by a three-point bending test (measurement based on the flexural strength test method according to JIS C6481). The peel strength is the peel strength as defined according to JIS C6481.

**Brief Description of the Drawings**

Fig. 1A is a cross-sectional view showing an embodiment of a resin composition of the invention.

Fig. 1B is a cross-sectional view showing a first embodiment of a sheet-like cured resin of the invention.

Fig. 1C is a cross-sectional view showing a first embodiment of a laminated body of the invention.

Fig. 1D is a cross-sectional view showing an embodiment of a prepreg of the invention.
Fig. 1E is a cross-sectional view showing a second embodiment of a sheet-like cured resin of the invention.
Fig. 1F is a cross-sectional view showing a second embodiment of a laminated body of the invention.
Fig. 1G is a perspective view showing an inductor as a first embodiment of an electronic part of the invention.
Fig. 2 is a cross-sectional view showing an inductor as a first embodiment of an electronic part of the invention.
Fig. 3 is a perspective view showing an inductor as a second embodiment of an electronic part of the invention.
Fig. 4 is a cross-sectional view showing an inductor as a second embodiment of an electronic part of the invention.
Fig. 5 is a perspective view showing an inductor as a third embodiment of an electronic part of the invention.
Fig. 6 is a cross-sectional view showing an inductor as a third embodiment of an electronic part of the invention.
Fig. 7 is a perspective view showing an inductor as a fourth embodiment of an electronic part of the invention.
Fig. 8 is a cross-sectional view showing an inductor as a fourth embodiment of an electronic part of the invention.
Fig. 9 is a perspective view showing an inductor as a fifth embodiment of an electronic part of the invention.
Fig. 10 is a pair of equivalent circuit diagrams for inductors as first and fifth embodiments of an electronic part of the invention.
Fig. 11 is a perspective view showing a capacitor as a sixth embodiment of an electronic part of the invention.
Fig. 12 is a cross-sectional view showing a capacitor as a sixth embodiment of an electronic part of the invention.
Fig. 13 is a perspective view showing a capacitor as a seventh embodiment of an electronic part of the invention.
Fig. 14 is a pair of equivalent circuit diagrams for a capacitor as a seventh embodiment of an electronic part of the invention.
Fig. 15 is a perspective view showing a balun transformer as an eighth embodiment of an electronic part of the invention.
Fig. 16 is a cross-sectional view showing a balun transformer as an eighth embodiment of an electronic part of the invention.
Fig. 17 is an exploded plan view showing the different component layers of a balun transformer as an eighth embodiment of an electronic part of the invention.
Fig. 18 is an equivalent circuit diagram of a balun transformer as an eighth embodiment of an electronic part of the invention.
Fig. 19 is a perspective view showing a laminated filter as a ninth embodiment of an electronic part of the invention.
Fig. 20 is an exploded perspective view showing a laminated filter as a ninth embodiment of an electronic part of the invention.
Fig. 21 is an equivalent circuit diagram of a laminated filter as a ninth embodiment of an electronic part of the invention.
Fig. 22 is a graph showing the transfer characteristics of a laminated filter as a ninth embodiment of an electronic part of the invention.
Fig. 23 is a perspective view showing a laminated filter as a tenth embodiment of an electronic part of the invention.
Fig. 24 is an exploded perspective view showing a laminated filter as a tenth embodiment of an electronic part of the invention.
Fig. 25 is an equivalent circuit diagram of a laminated filter as a tenth embodiment of an electronic part of the invention.
Fig. 26 is a graph showing the transfer characteristics of a laminated filter as a tenth embodiment of an electronic part of the invention.
Fig. 27 is a perspective view showing a block filter as an eleventh embodiment of an electronic part of the invention.
Fig. 28 is a front cross-sectional view showing a block filter as an eleventh embodiment of an electronic part of the invention.
Fig. 29 is a side cross-sectional view showing a block filter as an eleventh embodiment of an electronic part of the invention.
Fig. 30 is a flat cross-sectional view showing a block filter as an eleventh embodiment of an electronic part of the invention.
Fig. 31 is an equivalent circuit diagram of a block filter as an eleventh embodiment of an electronic part of the invention.
Fig. 32 is a simplified cross-sectional view showing a die for fabrication of a block filter as an eleventh embodiment of an electronic part of the invention.

Fig. 33 is a perspective view showing a coupler as a twelfth embodiment of an electronic part of the invention.

Fig. 34 is a cross-sectional view showing a coupler as a twelfth embodiment of an electronic part of the invention.

Fig. 35 is an exploded perspective view showing the different various component layers of a coupler as a twelfth embodiment of an electronic part of the invention.

Fig. 36 is an internal connection diagram of a coupler as a twelfth embodiment of an electronic part of the invention.

Fig. 37 is an equivalent circuit diagram of a coupler as a twelfth embodiment of an electronic part of the invention.

Fig. 38 is a perspective view showing an antenna as a thirteenth embodiment of an electronic part of the invention.

Fig. 39 is a set of diagrams of antenna as a thirteenth embodiment of an electronic part of the invention, wherein (a) is a plan view, (b) is a side cross-sectional view and (c) is a front cross-sectional view.

Fig. 40 is an exploded perspective view showing the different component layers of an antenna as a thirteenth embodiment of an electronic part of the invention.

Fig. 41 is a perspective view showing an antenna as a fourteenth embodiment of an electronic part of the invention.

Fig. 42 is an exploded perspective view showing an antenna as a fourteenth embodiment of an electronic part of the invention.

Fig. 43 is a perspective view showing a patch antenna as a fifteenth embodiment of an electronic part of the invention.

Fig. 44 is a cross-sectional view showing a patch antenna as a fifteenth embodiment of an electronic part of the invention.

Fig. 45 is a perspective view showing a patch antenna as a sixteenth embodiment of an electronic part of the invention.

Fig. 46 is a cross-sectional view showing a patch antenna as a sixteenth embodiment of an electronic part of the invention.

Fig. 47 is a perspective view showing a patch antenna as a seventeenth embodiment of an electronic part of the invention.

Fig. 48 is a cross-sectional view showing a patch antenna as a seventeenth embodiment of an electronic part of the invention.

Fig. 49 is a perspective view showing a patch antenna as an eighteenth embodiment of an electronic part of the invention.

Fig. 50 is a cross-sectional view showing a patch antenna as an eighteenth embodiment of an electronic part of the invention.

Fig. 51 is a perspective view showing a VCO as a nineteenth embodiment of an electronic part of the invention.

Fig. 52 is a cross-sectional view showing a VCO as a nineteenth embodiment of an electronic part of the invention.

Fig. 53 is an equivalent circuit diagram of a VCO as a nineteenth embodiment of an electronic part of the invention.

Fig. 54 is an exploded perspective view showing the different component layers of a power amplifier as a twentieth embodiment of an electronic part of the invention.

Fig. 55 is a cross-sectional view showing a power amplifier as a twentieth embodiment of an electronic part of the invention.

Fig. 56 is an equivalent circuit diagram of a power amplifier as a twentieth embodiment of an electronic part of the invention.

Fig. 57 is an exploded plan view showing the different component layers of a superposed module as a twenty-first embodiment of an electronic part of the invention.

Fig. 58 is a cross-sectional view showing a superposed module as a twenty-first embodiment of an electronic part of the invention.

Fig. 59 is an equivalent circuit diagram of a superposed module as a twenty-first embodiment of an electronic part of the invention.

Fig. 60 is a perspective view showing an RF module as a twenty-second embodiment of an electronic part of the invention.

Fig. 61 is a perspective view of the RF module of Fig. 60 with the outer casing member removed.

Fig. 62 is an exploded perspective view showing the different component layers of an RF module as a twenty-second embodiment of an electronic part of the invention.

Fig. 63 is a cross-sectional view showing an RF module as a twenty-second embodiment of an electronic part of the invention.

Fig. 64 is a perspective view showing a resonator as a twenty-third embodiment of an electronic part of the invention.

Fig. 65 is a cross-sectional view showing a resonator as a twenty-third embodiment of an electronic part of the invention.

Fig. 66 is a perspective view showing a resonator as a twenty-fourth embodiment of an electronic part of the invention.

Fig. 67 is a cross-sectional view showing a resonator as a twenty-fourth embodiment of an electronic part of the invention.

Fig. 68 is a perspective view showing a resonator as a twenty-fifth embodiment of an electronic part of the invention.

Fig. 69 is a perspective view showing a resonator as a twenty-sixth embodiment of an electronic part of the invention.

Fig. 70 is an equivalent circuit diagram for resonators as twenty-third to twenty-sixth embodiments of an electronic part of the invention.

Fig. 71 is a block diagram showing the high-frequency section of a portable data terminal as a twenty-seventh embodiment of an electronic part of the invention.

Fig. 72 is a flow chart for an example of forming a copper foil-clad board.

Fig. 73 is a process diagram for an example of forming a copper foil-clad board.

Fig. 74 is a flow chart for an example of forming a multilayer board.

Fig. 75 is a process diagram for an example of forming a multilayer board.

Fig. 76 is a partial cross-sectional view showing a twenty-eighth embodiment of an electronic part of the invention.

Fig. 77 is a perspective view showing a capacitor (condenser) as a twenty-ninth embodiment of an electronic part of the invention.

Fig. 78 is a partial cross-sectional view showing a capacitor (condenser) as a twenty-ninth embodiment of an electronic part of the invention.

Fig. 79 is a perspective view showing a inductor as a thirtieth embodiment of an electronic part of the invention.

Fig. 80 is a partial cross-sectional view showing a inductor as a thirtieth embodiment of an electronic part of the invention.

Fig. 81 is a graph showing the increase in dielectric constant with time for a cured resin composition heated at 125°C. Fig. 82 is a partial cross-sectional view showing the electronic part of Example 13.

## Best Modes for Carrying Out the Invention

Preferred embodiments of the resin composition, cured resin, sheet-like cured resin, laminated body, electronic parts and multilayer boards of the present invention will now be explained in detail.

First, the resin composition of the invention will be explained. Fig. 1A is a cross-sectional view showing an embodiment of a resin composition of the invention. As shown in Fig. 1A, the resin composition 18 comprises a curable mixture 19 and a dielectric ceramic powder distributed in the curable mixture 19.

The curable mixture 19 comprises an epoxy resin and an active ester compound obtained by reacting a phenolic hydroxyl group-containing compound and a compound with two or more groups which form ester bonds by reaction with the phenolic hydroxyl group.

The epoxy resin of the curable mixture 19 may be a compound having one or more epoxy groups, but from the standpoint of molecular weight and crosslinking degree, it is preferably a compound with two or more epoxy groups.

As epoxy resins there may be mentioned phenol-based glycidyl ether-type epoxy resins such as cresol-novolac-type epoxy resins, phenol-novolac-type epoxy resins, naphthol-modified novolac-type epoxy resins, bisphenol A-type epoxy resins, bisphenol F-type epoxy resins, biphenyl-type epoxy resins and triphenyl-type epoxy resins; alcohol-based glycidyl ether-type epoxy resins such as polypropyleneglycol glycidyl ether and hydrogenated bisphenol A-type epoxy resins; dicyclopentadiene skeleton-containing dicyclopentadiene-type epoxy resins; naphthalene skeleton-containing naphthalene-type epoxy resins; dihydroxybenzopyran-type epoxy resins; dihydroxydinaphthalene-type epoxy resins; glycidyl ester-type epoxy resins prepared from hexahydrophthalic anhydride or dimer acid starting materials; glycidylamine-based epoxy resins prepared from diaminophenylmethane or other polyamine starting materials; alicyclic epoxy resins; and brominated epoxy resins or mixtures thereof. These may be used alone or in combinations of two or more.

The active ester compound of the curable mixture 19 is a compound which yields a cured epoxy resin through the reaction scheme shown below, for example, and such a compound is obtained by reacting a compound with a

phenolic hydroxyl group and a compound with two or more groups which form ester bonds by reaction with the phenolic hydroxyl group. As groups which react with phenolic hydroxyl groups to form ester bonds there may be mentioned carboxyl groups and haloformyl (chloroformyl, etc.) groups. The compound represented by general formula (a) below is an epoxy resin, where $R^{10}$ represents a divalent organic group, and the compound represented by general formula (b) below is an active ester compound, where $R^1$ and $R^2$ are as defined above. The compound represented by general formula (c) below is the reaction product (cured product) resulting from reaction between both compounds.

The following reaction scheme represents a typical reaction wherein 1 mole of the compound represented by (b) is reacted with 2 moles of the compound represented by (a), and as shown by the chemical structure of (c), no hydroxyl group is produced in the epoxy group opened by the reaction. Thus, the epoxy groups of the epoxy resin and the ester bonds in the active ester compound contribute to the reaction in a ratio of 1:1.

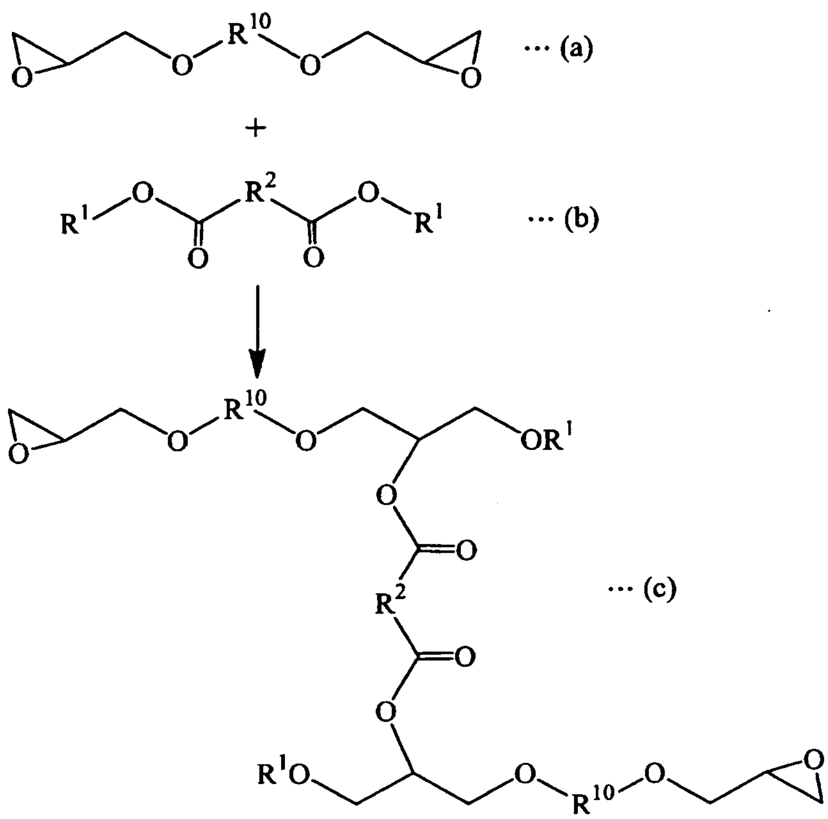

··· (a)

··· (b)

··· (c)

As active ester compounds in the curable mixture 19 there are preferred aromatic active ester compounds represented by general formula (1) above. $R^1$ in general formula (1) is most preferably one of the groups shown below. In these groups, A and B each independently represent a halogen or an alkyl group, $m_1$ represents an integer of 0-5, $m_2$ represents an integer of 0-4 and $m_3$ represents an integer of 0-3.

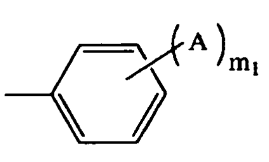

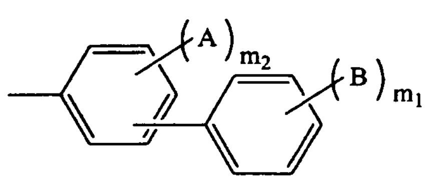

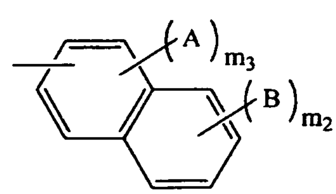

When k in general formula (1) is 2, $R^2$ is most preferably one of the following groups.

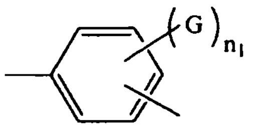
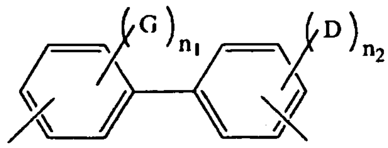
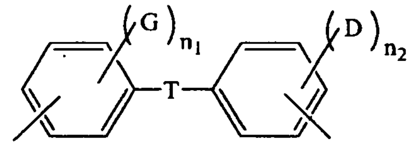

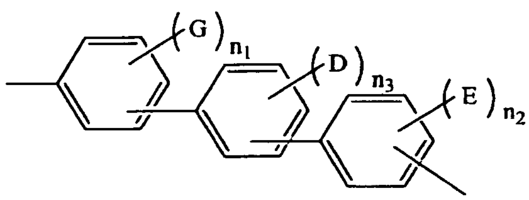
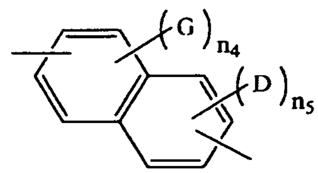
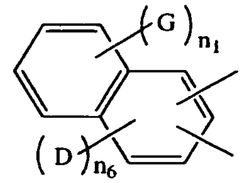

When k in general formula (1) is 3, $R^2$ is preferably the following group.

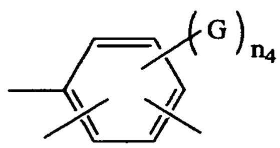

When k is 4, $R^2$ is preferably one of the following groups.

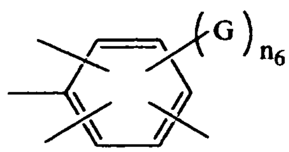
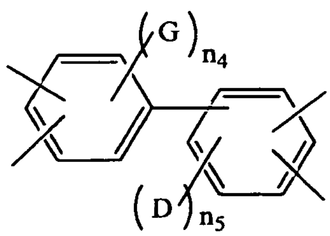

In these formulas, D, E and G each independently represent a halogen or an alkyl group, and T is an ether bond (-O-), thioether bond (-S-), sulfone bond ($-SO_2-$) or carbonyl bond (-CO-). Also, $n_1$, $n_2$ and $n_3$ each independently represent an integer of 0-4, $n_4$ and $n_5$ each independently represent an integer of 0-3, and $n_6$ represents an integer of 0-2.

The method employed to synthesize the active ester compound may be any publicly known synthesis method such as the acetic anhydride method, interfacial method, direct method, or the like.

In the acetic anhydride method, the compound with a phenolic hydroxyl group (hereinafter referred to as "phenol-based compound") is, for example, acetylated with an excess of acetic anhydride, and then subjected to deacetylation reaction with a compound having two or more carboxyl groups (hereinafter referred to as "polyvalent carboxylic acid"), to obtain an active ester compound. The acetic anhydride is preferably used in at least an equimolar amount with respect to the phenolic hydroxyl groups, in order to achieve adequate acetylation.

In the interfacial method, for example, an organic phase containing a polyvalent carboxylic acid chloride is contacted with an aqueous phase containing a phenol-based compound, to obtain an active ester compound. As solvents to be used for the organic phase there may be used non-aqueous solvents which dissolve polyvalent carboxylic acid chlorides, and for example, toluene, hexane and the like are preferred.

As polyvalent carboxylic acids to be used for synthesis of the active ester compound there may be mentioned aliphatic polyvalent carboxylic acids and aromatic polyvalent carboxylic acids. Using an aliphatic polyvalent carboxylic

acid as the polyvalent carboxylic acid can enhance the compatibility with the epoxy resin, while using an aromatic polyvalent carboxylic acid can improve the heat resistance of the cured resin composition 18 and thus of the composite dielectric layer used for an electronic part.

As aliphatic polyvalent carboxylic acids there may be mentioned saturated or unsaturated aliphatic polyvalent carboxylic acids, or their anhydrides or acid chlorides, such as malonic acid, succinic acid, glutaric acid, adipic acid, sebacic acid, fumaric acid, maleic acid, itaconic acid, aconitic acid, tricarbarylic acid, 1,2,3,4-butanetetracarboxylic acid, 4-methyl-4-cyclohexene-1,2-dicarboxylic acid, 1,2,3,4-cyclopentanetetracarboxylic acid and 5-(2,5-dioxotetrahydro-3-furanyl)-3-methyl-cyclohexene-1,2-dicarboxylic anhydride.

As aromatic polyvalent carboxylic acids there may be mentioned benzoic acids such as benzoic acid, methylbenzoic acid, dimethylbenzoic acid and trimethylbenzoic acid, naphthoic acids such as 1-naphthoic acid and 2-naphthoic acid, benzenedicarboxylic acids such as phthalic acid, isophthalic acid or terephthalic acid, or their anhydrides or acid chlorides, tricarboxylic acids such as trimellitic acid or trimesic acid, or their anhydrides or acid chlorides, tetracarboxylic acids such as pyromellitic acid or 3,3',4,4'-biphenylenetetracarboxylic, or their anhydrides, naphthalenedicarboxylic acids such as 1,4-naphthalenedicarboxylic acid, 2,6-naphthalenedicarboxylic acid or 2,3-naphthalenedicarboxylic acid, or their anhydrides, and 3,3',4,4'-benzophenonetetracarboxylic acid or its anhydride.

As phenol-based compounds to be used as starting materials for the active ester compound there are preferred phenol-based compounds having 1-3 aromatic rings, from the standpoint of heat resistance and curing reactivity of the cured resin composition 18 or prepreg 6 described hereunder.

As aromatic compounds having phenolic hydroxyl groups there may be mentioned phenols such as phenol, cresol and xylenol, benzenediols such as hydroquinone, resorcin, catechol and methylhydroquinone, benzenetriols such as phloroglucine, naphthols such as $\alpha$-naphthol and $\beta$-naphthol, naphthalenediols, o-phenylphenol, biphenols such as 2,2'-dihydroxybiphenyl or 2,2',4,4'-tetramethylbiphenol, 2,2',4,4'-tetrahydroxybenzophenone, and the like.

The dielectric ceramic powder 3 contained in the resin composition 18 will now be explained.

The dielectric ceramic powder 3 is preferably a dielectric ceramic powder exhibiting a dielectric constant and Q value (reciprocal of the dielectric loss tangent) in the high-frequency range (preferably the gigahertz band) of 100 MHz and higher which are greater than those of the reaction product between the epoxy resin and active ester, or of any optionally added polyarylate component, and one or more different types thereof may be used.

As such dielectric ceramic powders 3 there may be mentioned metal oxide powders comprising at least one metal selected from the group consisting of magnesium, silicon, aluminum, titanium, zinc, calcium, strontium, zirconium, barium, tin, neodymium, bismuth, lithium, samarium and tantalum. The dielectric ceramic powder 3 is preferably one of these metal oxide powders having a dielectric constant of 3.7-300 and a Q value of 500-100,000.

When the relative dielectric constant of the metal oxide powder is less than 3.7, the relative dielectric constant of the composite dielectric layer of the electronic part described hereunder cannot be increased, and it becomes difficult to reduce the size and weight of the electronic part. If the relative dielectric constant of the metal oxide powder is greater than 300 or the Q value is less than 500, the electronic part will generate excessive heat during use, tending to lower the transmission loss. The dielectric ceramic powder 3 will normally be composed of single crystals or polycrystals.

As preferred dielectric ceramic powders 3 there may be mentioned single crystals of sapphire or the like, and polycrystalline alumina powder. As preferred dielectric ceramic powders there may be mentioned those composed mainly of $Mg_2SiO_4$ [$\varepsilon$=7, Q=20000], $Al_2O_3$ [$\varepsilon$=9.8, Q=40000], $MgTiO_3$ [$\varepsilon$=17, Q=22000], $ZnTiO_3$ [$\varepsilon$=26, Q=800], $Zn_2TiO_4$ [$\varepsilon$=15, Q=700], $TiO_2$ [$\varepsilon$=104, Q=15000], $CaTiO_3$ [$\varepsilon$=170, Q=1800], $SrTiO_3$ [$\varepsilon$=255, Q=700], $SrZrO_3$ [$\varepsilon$=30, Q=1200], $BaTi_2O_5$ [$\varepsilon$=42, Q=5700], $BaTi_4O_9$ [$\varepsilon$=38, Q=9000], $Ba_2Ti_9O_{20}$ [$\varepsilon$=39, Q=9000], $Ba_2$ $(Ti,Sn)_9O_{20}$ [$\varepsilon$=37, Q=5000], $ZrTiO_4$ [$\varepsilon$=39, Q=7000], $(Zr,Sn)TiO_4$ [$\varepsilon$=38, Q=7000], $BaNd_2Ti_5O_{14}$ [$\varepsilon$=83, Q=2100], $BaNd_2Ti_4O_{12}$ [$\varepsilon$=92, Q=1700], $BaSm_2TiO_{14}$ [$\varepsilon$=74, Q=2400], $Bi_2O_3$-BaO-$Nd_2O_3$-$TiO_2$-based [$\varepsilon$=88, Q=2000], PbO-BaO-$Nd_2O_3$-$TiO_2$-based [$\varepsilon$=90, Q=5200], ($Bi_2O_3$, PbO)-BaO-$Nd_2O_3$-$TiO_2$-based [$\varepsilon$=105, Q=2500], $La_2Ti_2O_7$ [$\varepsilon$=44, Q=4000], $Nd_2Ti_2O_7$ [$\varepsilon$=37, Q=1100], (Li,Sm) $TiO_3$ [$\varepsilon$=81, Q=2050], $Ba(Mg_{1/3}Ta_{2/3})O_3$ [$\varepsilon$=25, Q=35000], $Ba(Zn_{1/3}Ta_{2/3})O3$ [$\varepsilon$=30, Q=14000], $Ba(Zn_{1/3}Nb_{2/3})O_3$ [$\varepsilon$=41, Q=9200], $Sr(Zn_{1/3}Nb_{2/3})O_3$ [$\varepsilon$=40, Q=4000], $Ba(Mg_{1/3}Nb_{2/3})O_3$ [$\varepsilon$=12, Q=24000], $Ba(Co_{1/3}Mg_{1/3}Nb_{1/3})O_3$ [$\varepsilon$=32, Q=11500], $Ba(Co_{1/3}Mg_{1/3}Ta_{1/3})O_3$ [$\varepsilon$=24, Q=38500], BaO-CaO-$Nd_2O_3$-$TiO_2$ [$\varepsilon$=90, Q=2200], BaO-SrO-$Nd_2O_3$-$TiO_2$ [$\varepsilon$=90, Q=1700], BaO-$Nd_2O_3$, MgO-$TiO_2$, MgO-$SiO_2$ [$\varepsilon$=6.1, Q=5000], ZnO-$TiO_2$ [$\varepsilon$=26, Q=840], $BaTiO_3$ ($\varepsilon$=1500, Q=100), $(Ba,Pb)TiO_3$ ($\varepsilon$=6000), $Ba(Ti,Zr)O_3$ ($\varepsilon$=9000) or $(Ba,Sr)TiO_3$ ($\varepsilon$=7000) compositions, although there is no limitation to these. The $\varepsilon$ values and Q values listed above as those measured in the gigahertz band using a dielectric resonator.

Particularly preferred as the dielectric ceramic powder 3 are dielectric ceramic powders composed mainly of $TiO_2$, $CaTiO_3$, $SrTiO_3$, BaO-$Nd_2O_3$-$TiO_2$-based BaO-CaO-$Nd_2O_3$-$TiO_2$-based BaO-SrO-$Nd_2O_3$-$TiO_2$-based, BaO-$Sm_2O_3$- $TiO_2$, $BaTi_4O_9$, $Ba_2Ti_9O_{20}$, $Ba_2(Ti,Sn)_9O_{20}$-based, MgO-$TiO_2$-based, ZnO-$TiO_2$-based MgO-$SiO_2$-based and $Al_2O_3$ compositions, because they have high Q values and larger $\varepsilon$ values than the cured product 2 described hereunder. Dielectric ceramic powders composed mainly of these components may be used alone, or two or more different ones may be used in combination.

The mean particle size of the dielectric ceramic powder 3 is preferably 0.01-100 $\mu$m, and more preferably

0.2-20 μm. A mean particle size of less than 0.01 μm may result in increased viscosity or reduced flow properties of the resin composition 18 or the prepreg 6 described hereunder, thus complicating its use as a sheet-like resin composition for adhesion. On the other hand, if the mean particle size exceeds 100 μm, problems such as precipitation of the dielectric ceramic powder 3 may occur during fabrication of the resin composition 18 or the prepreg 6 described hereunder.

The resin composition 18 preferably further contains a polyarylate. Stated differently, a polyarylate (aromatic polyester) is preferably added to the curable mixture 19 of the resin composition 18.

The polyarylate preferably comprises a repeating unit consisting of -X-Y-, as explained above, and most preferably it has a low dielectric constant and dielectric loss tangent. The polyarylate may be obtained by interfacial polymerization or solution polymerization, but interfacial polymerization is preferred in order to rapidly obtain a polyarylate with high purity and a low dielectric loss tangent.

In interfacial polymerization, preferably a halide of one or more dicarboxylic acids selected from the group consisting of phthalic acid, isophthalic acid and terephthalic acid is contacted with an organic solvent solution and the phenolate ion of a dihydric phenol compound represented by general formula (3a) below, producing interfacial polycondensation to obtain a polyarylate. In general formula (3a), $R^{11}$, $R^{12}$, Z, p and q are as defined above. In the reaction described above, the proportion of terephthalic acid halides must be no greater than 40 mole percent of the dicarboxylic acid halides.

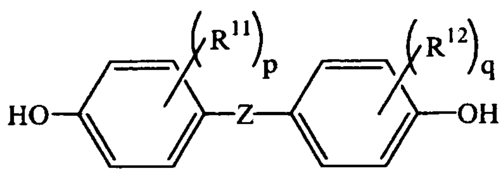

··· (3a)

The above-mentioned reaction is more preferably carried out by dissolving a dicarboxylic acid halide in an organic solvent such as toluene or methylene chloride and dissolving the aforementioned dihydric phenol in an alkali metal aqueous solution, in ranges of 0.1-2 mol/L each, and then contacting the two solutions for interfacial polymerization of the dicarboxylic acid halide and dihydric phenol.

In this case, addition of a phase transfer catalyst to the organic solvent is preferred to accelerate the reaction. As phase transfer catalysts there may be mentioned ammonium salts such as methyltrioctylammonium chloride and benzyltriethylammonium chloride, and phosphonium salts such as tetrabutylphosphonium bromide.

The oxygen in the water used for the interfacial polymerization is preferably removed beforehand. Removal of oxygen can suppress coloration of the obtained polyarylate. A surfactant may also be added to the reaction system. The polycondensation reaction system may be a batch system or continuous system, and the reaction temperature is preferably a temperature of between -5 and 100°C not exceeding the boiling point of the organic solvent, and most preferably 0-80°C.

The following explanation concerns the contents of the essential components, i.e. the epoxy resin, active ester compound and dielectric ceramic powder 3, and the polyarylate as an optional added component in the curable resin 19 contained in the resin composition 18.

The content of the active ester compound is preferably an amount for 0.3-4.0 ester equivalents (more preferably 0.8-3.0 ester equivalents) with respect to the epoxy equivalents of the epoxy resin. Curing of the epoxy resin will tend to be insufficient with less than 0.3 ester equivalents of the active ester compound, while with greater than 4.0 equivalents, the dielectric constant of the reaction product between the epoxy resin and the active ester compound will tend to be insufficiently reduced.

When a polyarylate is added, the content of the polyarylate is preferably 5-70 parts by weight with respect to 100 parts by weight as the total of the epoxy resin and the active ester compound. If the polyarylate content is less than 5 parts by weight, the viscosity of the resin composition 18 may be inadequately increased despite addition of the polyarylate, often resulting in coatability problems. If the polyarylate content exceeds 70 parts by weight, the flow property of the resin composition 18 may be excessively reduced, often resulting in inadequate adhesion, etc.

The content of the dielectric ceramic powder 3 is preferably 5-185 parts by volume and more preferably 10-150 parts by volume with respect to 100 parts by volume as the total of the epoxy resin and the active ester compound (or when a polyarylate is included, 100 parts by volume as the total of the epoxy resin, the active ester compound and the polyarylate).

One or more additives selected from the group consisting of coupling agents, curing accelerators, flame retardants, flexibilizers and organic solvents may also be added to the curable mixture 19 contained in the resin composition 18.

Addition of a coupling agent to the curable mixture 19 contained in the resin composition 18 can increase the cohesion between the dielectric ceramic powder 3 and the epoxy resin or active ester compound, or their reaction product, while also inhibiting moisture absorption.

As preferred coupling agents there may be mentioned chlorosilane-based, alkoxysilane-based, organic functional silane-based, silazane-based silane coupling agents, titanate-based coupling agents and aluminum-based coupling agents. The coupling agent used may be a single type or a combination of two different types, depending on the required properties. When the resin composition of the invention is to be applied for a printed board, electronic part, element or the like, heat resistance including reflow properties will be a requirement, and therefore an organic functional silane-based or alkoxysilane-based coupling agent is preferred.

At least a portion of the coupling agent is preferably bonded or adsorbed onto the surface of the dielectric ceramic powder 3. That is, the coupling agent is preferably present at the interface between the dielectric ceramic powder 3 and the epoxy resin or active ester compound or their reaction product (or the curable mixture 19 or its cured product). The presence of the coupling agent at the interface can improve the wettability or adhesion at the interface, while also enhancing the material strength of the cured resin composition 18 or prepreg 6 described hereunder and inhibiting moisture absorption and the like.

The amount of the coupling agent which is bonded or adsorbed onto the dielectric ceramic powder 3 may be appropriately determined based on the particle size and shape of the dielectric ceramic powder 3 used, the type of coupling agent added, etc., but it is preferably 0.1-5 parts by weight with respect to 100 parts by weight of the dielectric ceramic powder. As methods for bonding or adsorbing the coupling agent onto the dielectric ceramic powder 3 (surface treatment method) there may be mentioned dry methods, wet methods, spray methods and integral blend methods.

Addition of a curing accelerator to the curable mixture 19 contained in the resin composition 18 can accelerate the reaction between the epoxy resin and the active ester compound.

As curing accelerators there may be used common curing accelerators for epoxy resins, and specifically there may be mentioned imidazole compounds such as 2-methylimidazole, 2-ethyl-4-methylimidazole, 1-benzyl-2-methylimidazole, 2-heptadecylimidazole and 2-undecylimidazole; organic phosphine compounds such as triphenylphosphine and tributylphosphine; organic phosphite compounds such as trimethyl phosphite and triethyl phosphite; phosphonium salts such as ethyltriphenylphosphonium bromide and tetraphenylphosphonium tetraphenylborate; trialkylamines such as triethylamine and tributylamine; amines such as 1,8-diazacyclo(5.4.0)-undecene-7 (BDU); salts of BDU and terephthalic acid or 2,6-naphthalenecarboxylic acid; quaternary ammonium salts such as tetraethylammonium chloride, tetrapropylammonium chloride, tetrabutylammonium chloride, tetrabutylammonium bromide, tetrahexylammonium bromide and benzyltrimethylammonium chloride; urea compounds such as 3-phenyl-1,1-dimethylurea, 3-(4-methylphenyl)-1,1-dimethylurea, 3-(4-chlorophenyl)-1,1-dimethylurea and 3-(3,4-dichlorophenyl)-dimethylurea; bases such as sodium hydroxide and potassium hydroxide; and crown ether salts of potassium phenoxide, potassium acetate or the like. These may be used alone or in mixtures of two or more different types.

The curing accelerator is preferably added in an amount of 0.005-10.0 parts by weight with respect to the total of 100 parts by weight of the epoxy resin and active ester compound. A curing accelerator content of less than 0.005 part by weight may slow the curing reaction, while a content of greater than 10.0 parts by weight may lower the storage stability of the resin composition 18, tending to favor autopolymerization of the epoxy resin.

A flame retardant is preferably added to the curable mixture 19 when the resin composition 18 or the prepreg 6 described hereunder, or their cured product, is applied for purposes requiring flame retardance. Flame retardants are largely classified as reaction flame retardants and addition flame retardants. As reaction flame retardants there may be mentioned brominated bisphenol-type epoxy resins, brominated phenol resins and brominated phenol-novolac type epoxy resins, which are applied as base resins, or chlorendic anhydride and tetrabromophthalic anhydride, which are applied as curing agents. As addition flame retardants there may be mentioned halogen-based, phosphoric acid-based, nitrogen-based, metal salt-based, hydrated metal-based and inorganic-based flame retardants. These flame retardants may be used alone or in combinations of two or more different types.

The flame retardant content is preferably 5-50 parts by weight with respect to 100 parts by weight as the total of the epoxy resin and the active ester compound (or when a polyarylate is included, 100 parts by volume as the total of the epoxy resin, the active ester compound and the polyarylate). However, since the polyarylate or dielectric ceramic powder 3 exhibits a flame retardant effect, the appropriate content of the added flame retardant may be reduced in accordance with their amounts. The flame retardant content may be appropriately modified according to the UL94 requirements for flame retardance (for example, UL94 classes 5V, V-0, V-1, V-2 and HB, or the material thickness for achieving flame retardance certification).

Addition of a flexibilizer to the curable mixture 19 containing the resin composition 18 can increase the toughness of the hard and fragile cured resin composition 18.

As flexibilizers there may be mentioned dimer acid-modified alicyclic epoxy resins, epoxidated polybutadiene, polybutadiene, hydrogenated polybutadiene, rubber-modified epoxy resins, styrene-based thermoplastic elastomers,

and the like. The flexibilizer content is preferably 5-100 parts by weight with respect to 100 parts by weight as the total of the epoxy resin and the active ester compound

Addition of an organic solvent to the curable mixture 19 containing the resin composition 18 can adjust the viscosity and flow properties of the resin composition 18 or the prepreg 6 described hereunder. As solvents there may be mentioned tetrahydrofuran, toluene, xylene, methyl ethyl ketone, cyclohexanone, dimethylacetamide and dioxolane. The organic solvent content may be appropriately determined based on the required viscosity.

The cured resin, sheet-like cured resin and laminated body of the invention will now be explained.

Fig. 1B is a cross-sectional view showing a first embodiment of a sheet-like cured resin of the invention. The sheet-like cured resin 1 shown in Fig. 1B is provided with a cured product 2 obtained by curing the curable mixture 19 comprising the epoxy resin and active ester compound, and a dielectric ceramic powder 3, with the dielectric ceramic powder 3 dispersed in the cured product 2.

Fig. 1C is a cross-sectional view showing a first embodiment of a laminated body of the invention. The laminated body 5 shown in Fig. 1C comprises the aforementioned sheet-like cured resin 1 and a metal foil 4, with the metal foil 4 bonded to one side of the sheet-like cured resin 1. The metal foil 4 may be a metal foil made of copper, nickel, chromium, gold, silver, tin, nickel-chromium or the like, but copper foil is preferred from the standpoint of cost and availability. The thickness of the metal foil 4 is preferably 1-70 μm, and the method of fabricating the metal foil 4 may be appropriately selected from among electrolysis, calendering, sputtering and vapor deposition, depending on the required thickness and properties.

Resin compositions according to the invention are largely classified as either resin compositions obtained by partially completing the curing reaction between the epoxy resin and active ester compound, or resin compositions obtained by fully completing the curing reaction between the epoxy resin and active ester compound. Here, "fully completing the curing reaction" means achieving a state with a balance of heat of the reaction, as determined using a differential scanning calorimeter (DSC), and such a state may be achieved, for example, by thoroughly heating the resin composition at the curing temperature. On the other hand, "partially completing the curing reaction" means achieving a state wherein the curing reaction has partially proceeded but a balance of heat of the reaction is observed, as determined using a DSC, and such a state may be achieved, for example, by heating the resin composition for a short time at the curing temperature.

A resin composition obtained by partially completing the curing reaction between the epoxy resin and active ester compound may, for example, be molded into a sheet and used as a sheet-like cured resin (semi-cured adhesive sheet). It may also be used as a prepreg, in which case a molded article may be fabricated by curing a laminate of prepreg sheets under heated and pressurized conditions. The cured resin may also comprise a metal foil bonded to one or both sides of the sheet-like cured resin, as a laminated body. Such a laminated body may be heat cured by itself to form a single-layer board as a single-layer laminate for a printed wiring board, or a plurality of layers may be heat cured to form a multilayer board as a multilayer laminate for a printed wiring board.

On the other hand, a resin composition obtained by fully completing the curing reaction between the epoxy resin and active ester compound may be used, for example, as a sheet-like cured resin (cured sheet) with a high dielectric constant and low dielectric loss tangent, and it may also comprise a metal foil bonded to one or both sides of the sheet-like cured resin for use directly as a laminate for a printed wiring board.

The metal foil 4 may be applied in either of the aforementioned cases.

The sheet-like cured resin may be produced by kneading the resin composition 18 in an organic solvent (tetrahydrofuran, toluene, xylene, methyl ethyl ketone, cyclohexanone, dimethylacetamide, dioxolane or the like) for slurrying to obtain a paste, and then coating and drying it. Drying for a sufficient time at the curing temperature will yield the aforementioned cured sheet, while drying at low temperature or for a short time will yield an adhesive semi-cured sheet. The kneading may be carried out using a publicly known apparatus such as a ball mill or stirrer.

The method for coating the resin composition 18 in a paste-like state may be any publicly known method employing a doctor blade controlled system, spray system, curtain coating system, spin coating system, screen printing system or the like, which may be appropriately selected according to the required thickness, precision and form of the material (roll, sheet, etc.). The post-drying thickness of the resin composition 18 to be coated is preferably 5-200 μm, and it is preferably a thickness of at least twice the maximum particle size of the added dielectric ceramic powder 3.

If the thickness of the resin composition 18 is less than twice the maximum particle size of the dielectric ceramic powder 3 or the post-drying thickness is less than 5 μm, the coatability and smoothness during coating and the insulating property of the cured product may be less than satisfactory. On the other hand, if the post-drying thickness is greater than 200 μm, it will become difficult to remove the residual organic solvent. Consequently, a wet-on-wet thin coating method should be employed in cases where a sheet-like cured resin with a post-drying thickness exceeding 200 μm is obtained.

The drying conditions may be appropriately determined depending on the composition and thickness of the resin composition 18 and the type of organic solvent used, but the drying is preferably carried out at 50-150°C for 1-60 minutes. If necessary, step-drying may be conducted with different temperature stages. The coating may be accomplished on the aforementioned metal foil, or on a film made of PET, PI, PPS or LCP. The sheet-like cured resin is preferably obtained at high temperature in a vacuum, with suitable conditions being 150-250°C, 0.5-20 hr, 1.5-6.0 MPa pressure. If necessary, step curing or pressure reduction to below 30 torr may be also carried out.

Preferred embodiments of the prepreg, sheet-like cured resin and laminated body of the invention will now be explained. Identical or equivalent structural elements of these embodiments will be referred to using the same reference numerals, and will be explained only once.

Fig. 1D is a cross-sectional view showing an embodiment of a prepreg of the invention. The prepreg 6 shown in Fig. 1D is provided with a semi-cured product 7 obtained by semi-curing a curable mixture 19 comprising an epoxy resin and an active ester compound obtained by reaction between a compound with two or more carboxyl groups and a compound with a phenolic hydroxyl group (hereinafter referred to simply as "active ester compound"), as well as a dielectric ceramic powder 3 and reinforcing fibers 8, with the dielectric ceramic powder 3 dispersed in the semi-cured product 7 and the reinforcing fibers 8 distributed in the semi-cured product 7 in the form of a reinforcing fiber fabric. The curable mixture 19 is the same as that used in the resin composition 18.

Specifically, the prepreg 6 shown in Fig. 1D has a construction comprising a reinforcing fiber fabric and a resin layer composed of a semi-cured product 7 formed on both sides of the reinforcing fiber fabric. The thickness of the reinforcing fiber fabric is preferably 20-300 μm and more preferably 20-200 μm. A reinforcing fiber fabric thickness of less than 20 μm will tend to result in problems of inadequate strength, while a thickness of greater than 300 μm will tend to reduce the amount of resin adhesion and hinder the physical properties. The thickness of the resin layer composed of the semi-cured product 7 is preferably 5-100 μm and more preferably 5-50 μm. A resin layer thickness of less than 5 μm will reduce the resin proportion and will tend to hinder the physical properties, while a thickness of greater than 100 μm will tend to prevent uniform adhesion. The warp and weft yarn of the reinforcing fiber fabric in Fig. 1D is made of a reinforcing fiber bundle 9 consisting of a plurality of bundled reinforcing fibers 8, and they are woven in an alternating cross fashion. The semi-cured product 7 is also present between the reinforcing fibers 8 of the reinforcing fiber fabric.

The curable mixture comprising the epoxy resin and active ester compound in the prepreg of the invention is in a semi-cured state. Here, "semi-cured" means a state wherein the reaction between the epoxy resin and active ester compound has partially proceeded but a balance of heat of the reaction is observed, as determined using a differential scanning calorimeter (DSC), and such a state may be achieved, for example, by heating the prepreg for a short time at the curing temperature. The prepreg may also be cured to completion of the reaction, in which case a balance of heat of the reaction will not be observed with a DSC.

The reinforcing fibers 8 distributed in the prepreg 6 will now be described. The reinforcing fibers 8 are preferably at least one type of reinforcing fibers selected from the group consisting of E glass fibers, D glass fibers, NE glass fibers, H glass fibers, T glass fibers and aramid fibers, among which NE glass fibers are preferred for a low dielectric loss tangent, H glass fibers are preferred for a high dielectric constant, and E glass fibers are preferred for a satisfactory balance with cost. The reinforcing fibers 8 may be distributed in the prepreg either in the form of reinforcing fiber monofilaments or reinforcing fiber bundles, but they are preferably distributed in the prepreg 6 in the form of braided reinforcing fiber bundles (for example, a reinforcing fiber woven fabric or reinforcing fiber knitted fabric).

When a reinforcing fiber woven fabric (reinforcing fiber cloth) is used, the preferred thickness is as explained above. Particularly preferred thicknesses for reinforcing fiber woven fabrics are 20 μm, 30 μm, 50 μm, 100 μm and 200 μm. If necessary, a reinforcing fiber woven fabric may also be treated by fiber opening, closing or the like, and the surface may also be treated with a surface treatment agent such as a coupling agent in order to increase cohesion with the curable mixture.

The following explanation concerns the contents of the essential components, i.e. the epoxy resin, active ester compound and dielectric ceramic powder 3, and the polyarylate as an optional added component in the curable mixture 19 contained in the resin composition.

The content of the active ester compound is preferably an amount for 0.3-4.0 ester equivalents (more preferably 0.8-3.0 ester equivalents) with respect to the epoxy equivalents of the epoxy resin. Curing of the epoxy resin will tend to be insufficient with less than 0.3 ester equivalents of the active ester compound, while with greater than 4.0 equivalents, the dielectric constant of the reaction product between the epoxy resin and the active ester compound will tend to be insufficiently reduced.

When a polyarylate is added, the content of the polyarylate is preferably 5-70 parts by weight with respect to 100 parts by weight as the total of the epoxy resin and the active ester compound. If the polyarylate content is less than 5 parts by weight, the viscosity of the prepreg starting material (the paste described hereunder) may be inadequately increased despite addition of the polyarylate, often resulting in coatability problems. If the polyarylate content exceeds 70 parts by weight, the flow property of the prepreg starting material (the paste described hereunder) may be excessively reduced, often resulting in inadequate adhesion, etc.

The content of the dielectric ceramic powder 3 is preferably 5-100 parts by volume with respect to 100 parts by volume as the total of the epoxy resin and the active ester compound (or when a polyarylate is included, 100 parts

by volume as the total of the epoxy resin, the active ester compound and the polyarylate).

The sheet-like cured resin and laminated body of the invention will now be explained. Fig. 1E is a cross-sectional view showing a second embodiment of a sheet-like cured resin of the invention. The sheet-like cured resin 15 shown in Fig. 1E is provided with a cured product 2 obtained by curing the curable mixture 19 comprising the epoxy resin and active ester compound, as well as a dielectric ceramic powder 3 and reinforcing fibers 8, with the dielectric ceramic powder 3 dispersed in the cured product 2, and the reinforcing fibers 8 distributed in the cured product 16 in the form of a reinforcing fiber fabric. The warp and weft yarn of the reinforcing fiber fabric is made of a reinforcing fiber bundle 9 consisting of a plurality of bundled reinforcing fibers 8, and they are woven in an alternating cross fashion. The cured product 2 is also present between the reinforcing fibers 8 of the reinforcing fiber fabric.

Fig. 1F is a cross-sectional view showing a second embodiment of a laminated body of the invention. The laminated body 17 shown in Fig. 1F comprises the aforementioned sheet-like cured resin 15 and a metal foil 4, with the metal foil 4 bonded to one side of the sheet-like cured resin 15.

Preferred fabrication processes for the prepreg, sheet-like cured resin and laminated body of the invention will now be explained.

A paste prepared in the manner described below is preferably used to fabricate the prepreg 6, sheet-like cured resin 15 and laminated body 17. Specifically, a resin composition comprising the essential components, i.e. the epoxy resin, active ester compound and dielectric ceramic powder 3, and the additional components added as necessary, i.e. a polyarylate, coupling agent, curing accelerator, flame retardant and flexibilizer, is preferably kneaded in an organic solvent for slurrying to obtain a paste. Organic solvents to be used include volatile solvents such as tetrahydrofuran, toluene, xylene, methyl ethyl ketone, cyclohexanone, dimethylacetamide and dioxolane, and the amount thereof added may be varied to adjust the viscosity of the paste. The kneading may be carried out using a publicly known apparatus such as a ball mill or stirrer.

As typical processes for fabricating prepregs, sheet-like cured resins and laminated bodies according to the invention, there may be mentioned the following two processes.

Process 1: A prepreg 6 may be obtained by impregnating and coating the reinforcing fiber fabric with the slurrified paste and drying it. The coating thickness is preferably 5-50 μm on one side of the reinforcing fiber fabric. With a lower thickness it becomes difficult to guarantee the flow properties of the prepreg, while a higher thickness tends to result in sagging of the paste and increased variation in the thickness or adhesion weight. The drying conditions may be appropriately determined depending on the solvent used and the thickness of coating, and for example, the conditions may be 50-150°C for 1-60 minutes. If necessary, step-drying may be conducted with different temperature stages. The sheet-like cured resin 15 is preferably prepared by high temperature vacuum pressing of the obtained prepreg 6. High temperature vacuum pressing is preferably carried out at 150-250°C, 0.5-20 hr and 1.5-6.0 MPa pressure, under a vacuum degree of no greater than 30 torr. Step curing may be also carried out if necessary. The laminated body 17 may also have a metal foil 4 laminated on the front side and/or back side of the prepreg 6 with heating and pressurizing of the entire body, during the high temperature vacuum pressing to obtain the sheet-like cured resin 15.

Process 2: In process 2, the slurrified paste is coated onto the metal foil or on a film made of PET, PI, PPS, LCP or the like, by a publicly known coating method. As examples of coating methods there may be mentioned doctor blade controlled systems, spray systems, curtain coating systems, spin coating systems, screen printing systems and the like, which may be appropriately selected according to the required thickness, precision and form of the material (roll, sheet, etc.). The post-drying coated thickness is preferably 5-100 μm, and it is preferably a thickness of at least twice the maximum particle size of the added dielectric ceramic powder 3. If the thickness is less than 5 μm or less than twice the maximum particle size of the dielectric ceramic powder 3, the coatability and smoothness during coating and the insulating property of the cured product may be less than satisfactory, while if the thickness is greater than 100 μm, it will become difficult to remove the residual organic solvent. Consequently, a wet-on-wet thin coating method should be employed in cases where the coating thickness exceeds 100 μm.

The drying conditions may be appropriately determined depending on the thickness and on the type of organic solvent used, and for example, they may be 50-150°C for 1-60 minutes. If necessary, step-drying may be conducted with different temperature stages. By sandwiching the reinforcing fiber fabric with the coated article obtained in this manner and subjecting it to, for example, vacuum pressing, the organic solvent contained therein may be removed to obtain a prepreg. Also, after the coated article obtained in the manner described above has been completed and the reinforcing fiber fabric has been sandwiched with the obtained coated article, it may be subjected to high temperature vacuum pressing at 150-250°C, 0.5-20 hr, 1.5-6.0 MPa pressure, in a vacuum of no greater than 30 torr, to obtain a sheet-like cured resin 15. Coating of the paste onto a metal foil will yield a laminated body 17. When impregnation or filling into the reinforcing fiber fabric is a concern, the paste having a reduced solid concentration may be impregnated into the reinforcing fiber fabric beforehand prior to drying.

Electronic parts and multilayer boards according to the invention will now be explained.

An electronic part according to the invention is provided with at least one composite dielectric layer containing an organic insulating material and a dielectric ceramic powder having a larger dielectric constant than the organic

insulating material, and at least one conductive element section formed on the composite dielectric layer and constituting a capacitor element or inductor element, wherein the organic insulating material comprises a cured resin obtained by curing reaction between an epoxy resin and an active ester compound which is itself obtained by reaction between a compound having two or more carboxyl groups and a compound having a phenolic hydroxyl group.

Since the dielectric ceramic powder in such an electronic part has a larger relative dielectric constant than the organic insulating material containing the cured resin and the organic insulating material has a low dielectric loss tangent, the composite dielectric layer exhibits a high dielectric constant and low dielectric loss tangent in the high-frequency range of the gigahertz band. Consequently, the transmission loss in the electronic part is reduced, thereby allowing the electronic part to be smaller and more lightweight. In addition, it is possible to adequately minimize time-dependent changes in the relative dielectric constant in high-frequency range of 100 MHz and above even with prolonged use at high temperatures of 100°C and higher. Moreover, since the electronic part has increased flexural strength, the handling properties of the electronic part are improved and it becomes possible to satisfactorily prevent damage or deformation of the electronic part. An electronic part according to the invention also exhibits enhanced dielectric characteristics when used at high temperatures. In other words, the characteristics of electronic parts of the invention can be satisfactorily improved.

The aforementioned composite dielectric layer will be explained first. Identical or equivalent structural elements of these embodiments will be referred to using the same reference numerals, and will be explained only once.

The composite dielectric layer comprises an organic insulating material containing a cured resin, where the cured resin is obtained by curing reaction between an epoxy resin and an active ester compound. Stated differently, the composite dielectric layer is composed of, for example, the aforementioned sheet-like cured resin 1 or sheet-like cured resin 15. As explained above, the sheet-like cured resin 1 or sheet-like cured resin 15 is provided with a cured product 2 obtained by curing the curable mixture 19 comprising an epoxy resin and active ester compound, and a dielectric ceramic powder 3, with the dielectric ceramic powder 3 dispersed in the cured product 2. In other words, the cured resin contained in the organic insulating material is composed of the cured product 2.

The content of the active ester compound in the epoxy resin is preferably an amount for 0.3-4.0 ester equivalents and more preferably 0.8-3.0 ester equivalents with respect to the epoxy equivalents of the epoxy resin. Curing of the epoxy resin will tend to be insufficient with less than 0.3 ester equivalents of the active ester compound, while with greater than 4.0 equivalents, it tends to be difficult to obtain a cured resin with a sufficiently reduced dielectric constant.

The cured product 2 may be obtained by curing reaction between an epoxy resin and an active ester compound, in the presence of additives.

The additives may be one or more additives selected from the group consisting of curing accelerators, surface treatment agents, flame retardants and flexibilizers.

The curing accelerator is not particularly restricted so long as it can speed the curing reaction between the epoxy resin and active ester compound, and as such curing accelerators there may be used common curing accelerators used primarily for curing of epoxy resins.

As specific examples of curing accelerators there may be mentioned imidazole compounds such as 2-methylimidazole, 2-ethyl-4-methylimidazole, 1-benzyl-2-methylimidazole, 2-heptadecylimidazole and 2-undecylimidazole; organic phosphine compounds such as triphenylphosphine and tributylphosphine; organic phosphite compounds such as trimethyl phosphite and triethyl phosphite; phosphonium salts such as ethyltriphenylphosphonium bromide and tetraphenylphosphonium tetraphenylborate; trialkylamines such as triethylamine and tributylamine; amines such as 1,8-diazacyclo(5.4.0)-undecene-7 (BDU); salts of BDU and terephthalic acid or 2,6-naphthalenecarboxylic acid; quaternary ammonium salts such as tetraethylammonium chloride, tetrapropylammonium chloride, tetrabutylammonium chloride, tetrabutylammonium bromide, tetrahexylammonium bromide and benzyltrimethylammonium chloride; urea compounds such as 3-phenyl-1,1-dimethylurea, 3-(4-methylphenyl)-1,1-dimethylurea, 3-(4-chlorophenyl)-1,1-dimethylurea and 3-(3,4-dichlorophenyl)-dimethylurea; bases such as sodium hydroxide and potassium hydroxide; and crown ether salts of potassium phenoxide, potassium acetate or the like, which may be used alone or in mixtures of two or more different types.

The curing accelerator is preferably added in an amount of 0.005-10.0 parts by weight with respect to 100 parts by weight as the total of the epoxy resin and active ester compound. At less than 0.005 part by weight the curing reaction will tend to be slowed, while a content of greater than 10.0 parts by weight may lower the storage stability, tending to favor autopolymerization of the epoxy resin.

A flame retardant is added depending on the required flame retardance. Flame retardants are largely classified as reaction flame retardants and addition flame retardants. As reaction flame retardants there may be mentioned brominated bisphenol-type epoxy resins, brominated phenol resins and brominated phenol-novolac type epoxy resins, which are applied as base resins, or chlorendic anhydride and tetrabromophthalic anhydride, which are applied as curing agents. As addition flame retardants there may be mentioned halogen-based flame retardants such as halogenated phosphoric acid esters and brominated epoxy resins; phosphoric acid-based flame retardants such as phosphoric acid ester amides; nitrogen-based flame retardants; metal salt-based flame retardants; hydrated metal-based flame retardants; and inorganic-based flame retardants such as antimony trioxide and aluminum hydride. These flame retardants may be used alone or in combinations of two or more different types.

The flame retardant is preferably added in a content of 5-50 parts by weight with respect to 100 parts by weight of the resin composition. The polyarylate or dielectric ceramic powder itself also has a flame retardant property or is made of a material which exhibits a flame retardant effect, and therefore when the amount of the polyarylate and dielectric ceramic powder is high, the flame retardant may be added in a lower amount, or if the amount is low, it may be added in a greater amount. The amount of addition may be appropriately determined according to the required flame retardance (for example, UL94 classes 5V, V-0, V-1, V-2 and HB, or the target thickness).

The aforementioned flexibilizer can impart toughness to the composite dielectric layer, or when the composite dielectric layer is a prepreg containing reinforcing fibers, the handling properties are improved.

As examples of flexibilizers there may be mentioned dimer acid-modified alicyclic epoxy resins, epoxidated polybutadiene, polybutadiene, hydrogenated polybutadiene, rubber-modified epoxy resins, styrene-based thermoplastic elastomers, and the like, but there is no limitation to these.

Surface treatment agents increase the cohesion between the dielectric ceramic powder and organic insulating material, and reduce moisture absorption.

As such surface treatment agents there may be mentioned chlorosilane-based coupling agents, alkoxysilane-based coupling agents, organic functional silane-based coupling agents, silazane-based silane coupling agents, titanate-based coupling agents and aluminum-based coupling agents. The surface treatment agent used may be a single type or a combination of two different types, depending on the required properties.

Since electronic parts require heat resistance including reflow properties, the surface treatment agent is preferably an organic functional silane-based or alkoxysilane-based coupling agent.

The amount of surface treatment agent added may be appropriately determined in a range of 0.1-5 parts by weight with respect to 100 parts by weight of the dielectric ceramic powder. The amount of addition is determined based on the particle size and shape of the dielectric ceramic powder used and on the type of surface treatment agent added. As examples of methods for surface treatment there may be mentioned dry methods, wet methods, spray methods and integral blend methods, which may be selected depending on the need.

The organic insulating material preferably further contains a polyarylate in addition to the cured product 2. This will increase the flexibility and pliability in the B stage state, thus resulting in satisfactory handling properties.

The polyarylate comprises a plurality of repeating units represented by -X-Y composed of structural unit X and structural unit Y (The plurality of each of the structural units X and structural units Y may be the same or different.), where the structural unit X is preferably a phthaloyl group, isophthaloyl group or terephthaloyl group represented by the following formula (2) (wherein the number of moles of terephthaloyl groups constitutes less than 40 mole percent of the total moles of the phthaloyl, isophthaloyl and terephthaloyl groups),

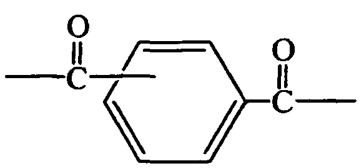

··· (2)

and the structural unit Y is preferably a divalent group represented by the following general formula (3).

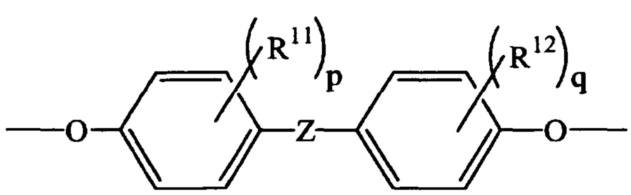

··· (3)

[wherein $R^{11}$ and $R^{12}$ each independently represent C1-4 alkyl, alkoxy or a halogen, Z represents a single bond, ether bond, thioether bond, sulfone bond or carbonyl bond, and p and q each independently represent an integer of 0-4, with the proviso that when more than one $R^{11}$, $R^{12}$ and Z are present in the polyarylate, $R^{11}$, $R^{12}$ and Z may be the same or different.]

A polyarylate having the structure described above can impart toughness to the prepreg and improve the handling properties, as compared to polyarylates having structures other than the one described above.

Preferably, $R^{11}$ and $R^{12}$ in general formula (3) above are both methyl and Z is a single bond.

This will yield a prepreg with particularly high toughness and improved handling properties.

The synthesis method for the aforementioned polyarylate may be interfacial polymerization or solution polymerization, but interfacial polymerization is preferred in order to rapidly obtain a polyarylate with high purity and a low dielectric loss tangent.

In interfacial polymerization, preferably a halide of one or more dicarboxylic acids selected from the group consisting of phthalic acid, isophthalic acid and terephthalic acid is contacted with an organic solvent solution and the phenolate ion of a dihydric phenol compound represented by general formula (3a) below, producing interfacial polycondensation to obtain a polyarylate. In general formula (3a), $R^{11}$, $R^{12}$, Z, p and q are as defined above. In the reaction described above, the proportion of terephthalic acid halides must be no greater than 40 mole percent of the dicarboxylic acid halides.

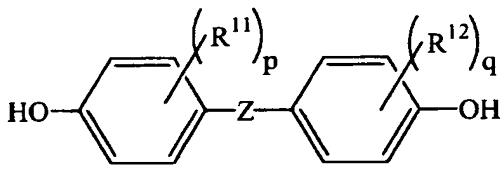

··· (3a)

The above-mentioned reaction is more preferably carried out by dissolving a dicarboxylic acid halide in an organic solvent such as toluene or methylene chloride and dissolving the aforementioned dihydric phenol in an alkali metal aqueous solution, in ranges of 0.1-2 mol/L each, and then contacting the two solutions for interfacial polymerization of the dicarboxylic acid halide and dihydric phenol.

In this case, addition of a phase transfer catalyst to the organic solvent is preferred to accelerate the reaction. As phase transfer catalysts there may be mentioned ammonium salts such as methyltrioctylammonium chloride and benzyltriethylammonium chloride, and phosphonium salts such as tetrabutylphosphonium bromide.

The oxygen in the water used for the interfacial polymerization is preferably removed beforehand. Removal of oxygen can suppress coloration of the obtained polyarylate.

A surfactant may also be added to the reaction system. The polycondensation reaction system may be a batch system or continuous system, and the reaction temperature is preferably a temperature of between -5 and 100°C not exceeding the boiling point of the organic solvent, and most preferably 0-80°C.

When the organic insulating material contains the aforementioned polyarylate, the amount of polyarylate added may be 5-70 parts by weight with respect to 100 parts by weight as the total of the epoxy resin and the active ester compound. If the amount of polyarylate added is less than 5 parts by weight the production efficiency of the electronic part will tend to be lower, and if it is greater than 70 parts by weight, the cohesion of the composite dielectric layer with conductive metals may be reduced, often leading to peeling of the conductive metals from the composite dielectric layer with prolonged use, and fluctuation in the performance of the electronic part.

The composite dielectric layer used for the invention comprises dielectric ceramic powder dispersed in the organic insulating material described above. The dielectric ceramic powder used is one having a larger relative dielectric constant and Q value than the organic insulating material in the high-frequency band of 100 MHz and higher, such as the dielectric ceramic powder 3, for example.

The amount of the dielectric ceramic powder added is preferably in the range of 5-185 parts by volume with respect to 100 parts by volume of the organic insulating material, and the amount may be appropriately selected within this range depending on the required dielectric constant and dielectric loss tangent. With addition of the dielectric ceramic powder at less than 5 parts by volume it tends to be difficult to achieve a larger dielectric constant than the dielectric ceramic powder, while at greater than 185 parts by volume, the cohesion of the composite dielectric layer with conductive metals may be reduced, often leading to peeling of the conductive metals from the composite dielectric layer with prolonged use and fluctuation in the performance of the electronic part.

The composite dielectric layer preferably further comprises a magnetic powder dispersed in the organic insulating material, in addition to the aforementioned dielectric ceramic powder. Magnetic powder can impart a magnetic property to the composite dielectric layer, reduce the linear expansion coefficient and improve the material strength.

As magnetic powders there may be mentioned Mn-MgZn, Ni-Zn, Mn-Mg and plana ferrites, or carbonyl iron, iron-silicon based alloys, iron-aluminum-silicon based alloys, iron-nickel based alloys and amorphous ferromagnetic metals. They may be used alone or in combinations of two or more.

The mean particle size of the magnetic powder is preferably 0.01-100 μm, and more preferably 0.2-20 μm. If

the mean particle size of the magnetic powder is less than 0.01 μm, kneading with the resin will tend to be difficult, whereas if it is greater than 100 μm, it may not be possible to achieve uniform dispersion.

The amount of magnetic powder added is preferably in the range of 5-185 parts by volume with respect to 100 parts by volume of the organic insulating material, and the amount may be appropriately selected within this range. At less than 5 parts by volume the effect of powder addition tends to be less notably exhibited, while at greater than 185 parts by volume the flow property is impaired.

The composite dielectric layer preferably further comprises a cloth made of reinforcing fibers. A cloth made of reinforcing fibers increases the mechanical strength of the composite dielectric layer, and therefore adequately prevents damage or deformation of the electronic part.

The material of the reinforcing fibers is preferably at least one selected from the group consisting of E glass fibers, D glass fibers, NE glass fibers, H glass fibers, T glass fibers and aramid fibers. Among these, NE glass fibers have a low dielectric loss tangent, H glass fibers have a high dielectric constant, and E glass fibers yield a satisfactory balance with cost. They may therefore be appropriately used depending on the required properties.

The thickness of the cloth is preferably 20-300 μm, and it may be appropriately selected depending on the required thickness and properties.

As specific examples of cloth types there may be mentioned 101 (20 μm thickness), 106 (30 μm thickness), 1080 (50 μm thickness), 2116 (100 μm thickness) and 7628 (200 μm thickness).

The surface of the cloth may be treated by fiber opening, closing or the like as necessary, and the cloth surface may also be treated with a surface treatment agent such as a coupling agent in order to increase cohesion with the resin.

An electronic part according to the invention has at least one conductive element section formed on the composite dielectric layer. The conductive element section constitutes a capacitor element or inductor element, but the composite dielectric layer is not limited to having a single conductive element section and may have more than one. By providing a plurality or a plurality of types of conductive element sections on the composite dielectric layer, it is possible to impart various different functions to the electronic part. Specifically, such conductive element sections will consist of metal foils 4 or the like formed on the surface of composite conductor layers.

According to the invention, the prepreg serving as the base for an electronic part may be obtained by kneading a resin composition comprising an epoxy resin, active ester compound, polyarylate, dielectric ceramic powder and magnetic powder in prescribed amounts in a solvent to obtained a slurrified paste, which is then coated and dried to a semi-cured state. As solvents to be used there may be mentioned volatile solvents such as tetrahydrofuran, toluene, xylene, methyl ethyl ketone, cyclohexanone, dimethylacetamide and dioxolane. Such solvents liquefy the epoxy resin, active ester compound and polyarylate while adjusting the viscosity of the paste. The kneading may be carried out using a publicly known apparatus such as a ball mill or stirrer.

As processes for fabricating the aforementioned prepreg and sheet-like cured product (board) prepared by complete curing of the prepreg, there may be mentioned the two processes mentioned above, i.e. Processes 1 and 2.

A laminated body according to the invention may be a double-sided patterning board, multilayer board or the like, which may be fabricated in the manner described below.

Fig. 72 is a manufacturing flow chart for a double-sided patterning board, and Fig. 73 is a process diagram for an example of forming a double-sided patterning board. As shown in Figs. 72 and 73, a prepreg (without copper foil) 1 of a prescribed thickness and copper (Cu) foils 2 of prescribed thickness are stacked and pressed under heating and molded (Step A). Next, a through-hole is formed by drilling (Step B). The formed through-hole is plated with copper (Cu) to form plating films 23 (Step C). The copper foils 2 on both sides are patterned to form a conductive pattern 211 (Step D). This is followed by plating for connection with external terminals, as indicated in Fig. 72 (Step E). This plating is accomplished by a method of Ni plating followed by Pd plating, a method of Ni plating followed by Au plating (either electrolytic or electroless plating) or a method using a solder leveler.

Fig. 74 is a manufacturing flow chart for a multilayer board and Fig. 75 is a manufacturing process diagram for a multilayer board, both for an example of a triple laminated dielectric layer. As shown in Figs. 74 and 75, a prepreg 1 of a prescribed thickness and copper (Cu) foils of prescribed thickness are stacked and pressed under heating and molded (Step a). The copper foils 2 on both sides are patterned to form a conductive pattern 21 (Step b). Both sides of the double-sided patterning board obtained in this manner are further laminated with a prepreg 1 and copper foil 2 of prescribed thicknesses, and simultaneously pressed under heating and molded (Step c). Next, a through-hole is formed by drilling (Step d). The formed through-hole is plated with copper (Cu) to form plating films 4 (Step e). The copper foils 2 on both sides are then patterned to form a conductive pattern 21 (Step f). This is followed by plating for connection with external terminals, as indicated in Fig. 74 (Step g). This plating is accomplished by a method of Ni plating followed by Pd plating, a method of Ni plating followed by Au plating (either electrolytic or electroless plating) or a method using a solder leveler.

The molding conditions for the heated pressing are preferably a pressure of $9.8 \times 10^5$ to $7.84 \times 10^6$ Pa (10-80 $kgf/cm^2$) at 100-200°C for 0.5-20 hours.

Electronic parts according to the invention are not limited to the examples described above and may be fabricated using various different types of boards. For example, a multilayer board may be obtained using a board or copper foil-clad board (laminated body) as the molding material, for formation of a multilayer structure using a prepreg as the adhesive layer.

For embodiments wherein a copper foil is bonded with a prepreg or a board used as a molding material, a paste may first be prepared comprising the composite dielectric material obtained by kneading the aforementioned dielectric ceramic powder, magnetic powder, flame retardant as necessary, epoxy resin, active ester compound and a high boiling point solvent such as butyl carbitol acetate, and the paste may be formed onto a patterned board by screen printing or the like, in order to achieve enhanced characteristics.

An electronic part according to the invention may be obtained by combining the aforedescribed prepreg, copper foil-clad board, laminated board, etc. with an element configuration pattern.

Electronic parts according to the invention may be condensers (capacitors), coils (inductors), filters or the like as described above, as well as superposed modules used in antennas, high-frequency electronic circuits such as RF modules (RF stage gains), VCOs (voltage controlled oscillators) or power amplifiers (power stage gains), and optical pickup amplifiers, which comprise combinations of the parts described above with other types of wiring patterns, amplifier elements and functional elements.

Embodiments of electronic parts of the invention will now be explained in greater detail.

(First embodiment)

Fig. 1G is a perspective view showing an inductor as a first embodiment of an electronic part of the invention, and Fig. 2 is a cross-sectional view showing an inductor as a first embodiment of an electronic part of the invention.

In Fig. 1G and Fig. 2, the inductor 10 is provided with a laminated body obtained by laminating component layers 10a-10e, internal conductors 13a-13d formed on the component layers 10b-10e, and via holes 14 for electrical connection of the internal conductors 13a-13d. A coil pattern (conductive element section) is formed by the internal conductors 13 and via holes 14.

Each of the component layers 10a-10e is composed of a composite dielectric layer as described above. The via holes 14 may be formed by drilling, laser processing, etching or the like.

Terminal electrodes 12 are formed on each of the opposite sides of the laminated body, and both ends of the coil pattern are connected to respective terminal electrodes 12. Both ends of the terminal electrodes 12 are provided with land patterns 11.

The terminal electrodes 12 each have a half-split through-via cylinder structure. The terminal electrodes 12 have such a structure because multiple elements are formed on a laminated board assembly, and when each element is cut at the final stage it is cut at the centers of the through-via holes by dicing, V cutting or the like.

When the inductor 10 is to be used as a high-frequency chip inductor, the distributed capacitance must be reduced to a minimum, and therefore the relative dielectric constants of each of the component layers 10a-10e are preferably between 2.6 and 3.5. When the inductor 10 is the inductor of a resonance circuit, the distributed capacitance is sometimes actively utilized, and for such purposes the relative dielectric constants of each of the component layers 10a-10e are preferably between 5 and 40.

With this type of inductor 10, the changes in the relative dielectric constant with time are adequately minimized even with use at high temperatures. The reliability of the inductor 10 in high temperature environments is therefore increased. Moreover, since the inductor 10 employs composite dielectric layers with high flexural strength as the component layers 10a-10e, it is possible to satisfactorily prevent damage or deformation during handling of the inductor 10. The electronic part can also be downsized, and mounting of capacitative elements onto circuits can be omitted. Material loss must also be kept to a minimum in such inductors, and therefore the dielectric loss tangent (tanδ) of each of the component layers 10a-10e may be limited to 0.0025-0.0075 in order to obtain inductors with very low material loss and high Q values. The component layers 10a-10e may be either identical or different, with selection of the optimum combination.

Fig. 10(a) shows an equivalent circuit for the electronic part of Fig. 1G. As shown in Fig. 10(a), the inductor 10 of the equivalent circuit is represented as an electronic part (inductor) having a coil 31.

(Second embodiment)

Fig. 3 is a perspective view showing an inductor as a second embodiment of an electronic part of the invention, and Fig. 4 is a cross-sectional view showing an inductor as a second embodiment of an electronic part of the invention.

The electronic part according to this embodiment differs from the electronic part according to the first embodiment in that the coil pattern winds in the lateral direction, i.e. in the direction which connects the terminal electrodes 12 on opposite ends.

The other constituent features are identical to the first embodiment, and these identical constituent features

are indicated by the same reference numerals in Figs. 3 and 4 and will not be explained.

(Third embodiment)

Fig. 5 is a perspective view showing an inductor as a third embodiment of an electronic part of the invention, and Fig. 6 is a cross-sectional view showing an inductor as a second embodiment of an electronic part of the invention.

The electronic part according to this embodiment differs from the electronic part according to the first embodiment in that internal conductors 13 each formed in a spiral fashion on upper and lower planes are connected by a via hole 14.

The other constituent features are identical to the first embodiment, and these identical constituent features are indicated by the same reference numerals in Figs. 5 and 6 and will not be explained.

(Fourth embodiment)

Fig. 7 is a perspective view showing an inductor as a fourth embodiment of an electronic part of the invention, and Fig. 8 is a cross-sectional view showing an inductor as a fourth embodiment of an electronic part of the invention.

The electronic part according to this embodiment differs from the electronic part according to the first embodiment in that the pattern shape of the internal conductor 13 connecting the terminal electrodes 12 provided on both sides of the laminated body is a meander shape.

The other constituent features are identical to the first embodiment, and these identical constituent features are indicated by the same reference numerals in Figs. 7 and 8 and will not be explained.

(Fifth embodiment)

Fig. 9 is a perspective view showing an inductor as a fifth embodiment of an electronic part of the invention.

The electronic part according to this embodiment differs from the electronic part according to the first embodiment in that four coil patterns are provided in series in the laminated body, and in that only one type of coil pattern is used in the laminated body. This construction allows space reduction when the electronic part is situated on a circuit board or the like, as compared to using four electronic parts each with one coil pattern.

Fig. 10(b) is an equivalent circuit diagram for the inductor of this embodiment. As shown in Fig. 10(b), the inductor of this embodiment is represented as four connected coils 31a-31d in the equivalent circuit.

(Sixth embodiment)

Fig. 11 is a perspective view showing a capacitor (condenser) as a sixth embodiment of an electronic part of the invention, and Fig. 12 is a cross-sectional view showing a capacitor (condenser) as a sixth embodiment of an electronic part of the invention.

In Figs. 11 and 12, the capacitor 20 is provided with a laminated body obtained by laminating component layers 20a-20g and internal conductors 23 formed on the component layers 20a-20g, with terminal electrodes 22 provided on either side of the laminated body. The adjacent internal conductors 23 are respectively connected to different terminal electrodes 22. A land pattern 21 is provided on either end of both terminal electrodes 22. The internal conductors 23 provided in the laminated body form a conductive element section. Each of the component layers 20a-20g is composed of the aforementioned composite dielectric layer.

Each of the component layers 20a-20g preferably has a relative dielectric constant of 2.6-40 and a dielectric loss tangent of 0.0025-0.0075 from the standpoint of variety and precision of the resulting capacity. In this capacitor 20, the relative dielectric constant is also increased in the high-frequency range, and therefore the area of the internal conductor 23 can be reduced and the capacitor 20 can therefore be downsized. In addition, the change in the relative dielectric constant with time is also adequately minimized even with use of the capacitor 20 at high temperatures. The reliability of the capacitor 20 in high temperature environments is therefore increased. Moreover, since the capacitor 20 employs composite dielectric layers with high flexural strength as the component layers 20a-20g, it is possible to satisfactorily prevent damage or deformation during handling of the capacitor 20. The dielectric loss tangent (tanδ) may be limited to 0.0075-0.025 in order to obtain a capacitor with very low material loss. The component layers 20a-20g may be either identical or different, with selection of the optimum combination.

Fig. 14(a) shows an equivalent circuit diagram for the capacitor 20. Fig. 14(a) shows the electronic part (condenser) as having a capacitor 32 in the equivalent circuit.

(Seventh embodiment)

Fig. 13 is a perspective view showing a capacitor as a seventh embodiment of an electronic part of the invention.

The electronic part according to this embodiment differs from the capacitor according to the sixth embodiment which has a single conductive element section of the capacitor element formed in the laminated body, in that the four conductive element sections of the capacitor element are formed in an array fashion in the laminated body. Also, terminal electrodes 12 and land patterns 11 are provided to match the number of capacitor elements. By forming the capacitor in an array fashion, various capacities can be created to precision. The aforementioned ranges for the dielectric constant and dielectric loss tangent are therefore preferred.

The other constituent features are identical to the sixth embodiment, and these identical constituent features are indicated by the same reference numerals in Fig. 13 and will not be explained.

Fig. 14(b) is an equivalent circuit diagram for the capacitor of this embodiment. Fig. 14(b) shows the electronic part (condenser) of this embodiment as four connected capacitors 32a-32d in the equivalent circuit.

(Eighth embodiment)

Figs. 15 to 18 show a balun transformer as an eighth embodiment of an electronic part of the invention. Fig. 15 is a perspective view, Fig. 16 is a cross-sectional view, Fig. 17 is an exploded plan view showing each of the component layers, and Fig. 18 is an equivalent circuit diagram.

In Figs. 15 to 17, the balun transformer 40 comprises a laminated body obtained by laminating component layers 40a-40o, internal GND conductors 45 situated above, below and within the laminated body, and internal conductors 43 formed between the internal GND conductors 45. The internal conductors 43 are spiral conductors 43 with $\lambda g/4$ lengths, and they are connected by via holes 44 or the like to form the coupling lines 53a-53d shown in the equivalent circuit of Fig. 18.

The component layers 40a-40o of this balun transformer preferably have relative dielectric constants of 2.6-40 and dielectric loss tangents (tanδ) of 0.0075-0.025, with the aforementioned composite dielectric layer being used for each of the component layers 40a-40o. The component layers may be either identical or different, with selection of the optimum combination.

With this type of balun transformer 40, the changes in the relative dielectric constant with time are adequately minimized even with use at high temperatures. The reliability of the balun transformer 40 in high temperature environments is therefore increased. Moreover, since the balun transformer 40 employs composite dielectric layers with high flexural strength as the component layers 40a-40o, it is possible to satisfactorily prevent damage or deformation during handling of the balun transformer 40.

(Ninth embodiment)

Figs. 19 to 22 show a laminated filter as a ninth embodiment of an electronic part of the invention. Fig. 19 is a perspective view, Fig. 20 is an exploded perspective view, Fig. 21 is an equivalent circuit diagram and Fig. 22 is a transfer characteristic graph.

The laminated filter of this embodiment is constructed to have a two-pole type transfer characteristic. As shown in Figs. 19 to 21, the laminated filter 60 is provided with a laminated body comprising laminated component layers 60a-60e. The component layer 60b is a group of upper component layers, and the component layer 60d is a group of lower component layers. A pair of strip lines 68 are formed on the component layer 60c at roughly the center of the laminated body, while a pair of condenser conductors 67 are formed on the adjacent lower component layer group 60d. Respective GND conductors 65 are formed on the surfaces of the component layers 60b,60e, with the GND conductors 65 sandwiching the strip lines 68 and condenser conductors 67. The strip lines 68, condenser conductors 67 and GND conductors 65 are each connected to respective end electrodes (external terminals) 62 formed on the edges of the laminated body. GND patterns 66 are formed on either side of the end electrodes 62, and the GND patterns 66 are connected to the GND conductors 65.

The strip lines 68 are the strip lines 74a,74b having lengths of $\lambda g/4$ or less as shown in the equivalent circuit diagram of Fig. 21, and the condenser conductors 67 form I/O coupling capacitance Ci. The strip lines 74a,74b are linked by a coupling capacitance Cm and coupling coefficient M. Because the laminated filter 60 is constructed in such a manner as to form this type of equivalent circuit, it exhibits the two-pole transfer characteristic shown in Fig. 22.

The component layers 60a-60e of the laminated filter 60 have relative dielectric constants of 2.6-40 in order to achieve the desired transfer characteristics in the frequency band from a few 100 MHz to a few GHz. Since it is preferred to minimize material loss for a strip line resonator, the dielectric loss tangent (tanδ) is preferably 0.0025-0.0075. The composite dielectric layer described above may be used for the component layers 60a-60e. Each

of the component layers may be either identical or different, with selection of the optimum combination.

With this type of laminated filter 60, the changes in the relative dielectric constant with time are adequately minimized even with use at high temperatures. The reliability of the laminated filter 60 in high temperature environments is therefore increased. Moreover, since the laminated filter 60 employs composite dielectric layers with high flexural strength as the component layers 60a-60e, it is possible to satisfactorily prevent damage or deformation during handling of the laminated filter 60.

(Tenth embodiment)

Figs. 23 to 26 show a laminated filter as a tenth embodiment of an electronic part of the invention. Fig. 23 is a perspective view, Fig. 24 is an exploded perspective view, Fig. 25 is an equivalent circuit diagram and Fig. 26 is a transfer characteristic graph.

The laminated filter of this embodiment is constructed to have a four-pole type transfer characteristic. As shown in Figs. 23 to 25, this laminated filter 60 differs from the laminated filter of the ninth embodiment which has two strip lines 68 formed on the component layer 60c, in that four strip lines 68 are formed on the component layer 60c.

In the laminated filter of this embodiment, the strip lines 68 are the strip lines 74c,74d,74e,74f having lengths of λg/4 or less as shown in the equivalent circuit diagram of Fig. 25, and the strip lines 74c,74d, the strip lines 74d,74e and the strip lines 74e,74f are each linked by a coupling capacitance Cm and coupling coefficient M. Because the laminated filter 60 is constructed in such a manner as to form this type of equivalent circuit, it exhibits the four-pole transfer characteristic shown in Fig. 26.

The other constituent features are identical to the ninth embodiment, and these identical constituent features are indicated by the same reference numerals in Figs. 23 and 24 and will not be explained.

(Eleventh embodiment)

Figs. 27 to 32 show a block filter as an eleventh embodiment of an electronic part of the invention. Fig. 27 is a perspective view, Fig. 28 is front cross-section view, Fig. 29 is a side cross-sectional view, Fig. 30 is a flat cross-sectional view, Fig. 31 is an equivalent circuit diagram and Fig. 32 is a side view showing the structure of the molding die.

The block filter of this embodiment is constructed to have a two-pole type transfer characteristic. As shown in Figs. 27 to 32, the block filter 80 comprises a configuration block 80a, a pair of coaxial conductors 81 formed in the configuration block 80a and condenser coaxial conductors 82 connected to the coaxial conductors 81. The coaxial conductors 81 and condenser coaxial conductors 82 consist of conductors formed in a hollow fashion through the configuration block 80a. A surface GND conductor 87 is formed around the configuration block 80a so as to cover it. Condenser conductors 83 are formed at positions opposite the condenser coaxial conductors 82 of the configuration block 80a. The condenser conductors 83 and surface GND conductor 87 are used, respectively, as an I/O terminal and part-anchoring terminal. The conductive material is attached to the inner surfaces of the coaxial conductors 81 and condenser coaxial conductors 82 by electroless plating, vapor deposition or the like, thereby forming transmission channels.

The coaxial conductors 81 are the coaxial lines 94a,94b having lengths of λg/4 or less as shown in the equivalent circuit diagram of Fig. 31, and the GND conductors 87 are formed surrounding them. Also, the condenser coaxial conductors 82 and condenser conductors 83 produce I/O coupling capacitance Ci. The coaxial conductors 81 are linked by a coupling capacitance Cm and coupling coefficient M. Because the block filter 80 is constructed in such a manner as to form the equivalent circuit shown in Fig. 31, it exhibits a two-pole transfer characteristic.

Fig. 32 is a simplified cross-sectional view showing an example of a die for formation of the configuration block 80a of the block filter 80. In Fig. 32, the die comprises a metal base 103 made of iron or the like with a resin injection port 104 and injection hole 106 formed therein, and part-forming sections 105a, 105b formed in communication therewith. A composite resin material used to form the configuration block 80a is injected in a liquid state from the resin injection port 104, through the injection hole 106 and into the part-forming sections 105a, 105b. The composite resin filled inside the die is cooled or heated for solidification of the composite resin and then removed from the die, after which the unwanted portions which have hardened in the injection port 104, etc. are cut off. This procedure forms a configuration block 80a as shown in Fig. 27 to 30.

The configuration block 80a formed in this manner is then subjected to treatment such as plating, etching, printing, sputtering, vapor deposition or the like to form the surface GND conductors 87, coaxial conductors 81 and condenser coaxial conductors 82 of copper, gold, palladium, platinum, aluminum or the like.

The configuration block 80a of the block filter 80 has a relative dielectric constant of 2.6-40 in order to achieve the desired transfer characteristic in the frequency band from a few 100 MHz to a few GHz. Since it is preferred to minimize material loss for a coaxial resonator, the dielectric loss tangent (tanδ) is preferably 0.0025-0.0075. The aforementioned composite dielectric layer may be used as the configuration block 80a described above.

With this type of block filter 80, the changes in the relative dielectric constant with time are adequately minimized even with use at high temperatures. The reliability of the block filter 80 in high temperature environments is therefore increased. Moreover, since the block filter 80 employs a composite dielectric layer with high flexural strength as the configuration block 80a, it is possible to satisfactorily prevent damage or deformation during handling of the block filter 80.

(Twelfth embodiment)

Figs. 33 to 37 show a coupler as a twelfth embodiment of an electronic part of the invention. Fig. 33 is a perspective view, Fig. 34 is a cross-sectional view, Fig. 35 is an exploded perspective view showing each of the component layers, Fig. 36 is an internal connection diagram, and Fig. 37 is an equivalent circuit diagram.

In Figs. 33 to 37, the coupler 110 comprises a laminated body obtained by laminating component layers 110a-110c, internal GND conductors 115 formed on the upper and lower surfaces of component layer 110b of the laminated body, and two coil patterns formed between the internal GND conductors 115, constituting a transformer. Each of the coil patterns is composed of a plurality of internal conductors 113 and a via hole 114 connecting the internal conductors 113, and each is in a spiral configuration. The ends of the formed coil patterns and the internal GND conductors 115 are connected to terminal electrodes 112 formed on the sides of the laminated body, as shown in Fig. 36. Also, land patterns 111 are formed at both edges of the terminal electrodes 112.

Thus, this coupler 110 comprises two linked coils 125a,125b, as shown in the equivalent circuit diagram of Fig. 37.

When the goal is a wide band application, the component layers 110a-110c of the coupler 110 preferably have relative dielectric constants that are as small as possible. From the standpoint of downsizing, on the other hand, the relative dielectric constant should be as large as possible. The material used to form the component layers 110a-110c may therefore be a material having a relative dielectric constant suited for the purpose and for the required performance, specifications, etc. The relative dielectric constants of the component layers 110a-110c will usually be 2.6-40 in order to achieve the desired transfer characteristics in the frequency band from a few 100 MHz to a few GHz. In order to increase the Q value of the internal inductor, the dielectric loss tangent (tanδ) is preferably 0.0025-0.0075. This will allow notable reduction in material loss in order to form an inductor with a high Q value and obtain a high-performance coupler. The composite dielectric layer described above may be used for the component layers 110a-110c. Each of the component layers may be either identical or different, with selection of the optimum combination.

With this type of coupler 110, the changes in the relative dielectric constant with time are adequately minimized even with use at high temperatures. The reliability of the coupler 110 in high temperature environments is therefore increased. Moreover, since the coupler 110 employs composite dielectric layers with high flexural strength as the component layers 110a-110c, it is possible to satisfactorily prevent damage or deformation during handling of the coupler 110.

(Thirteenth embodiment)

Figs. 38 to 40 show an antenna as a thirteenth embodiment of an electronic part of the invention, wherein Fig. 38 is a perspective view, Fig. 39(a) is a plan view, Fig. 39(b) is a side cross-sectional view, Fig. 39(c) is a front cross-sectional view, and Fig. 40 is an exploded perspective view showing the different component layers.

As shown in Figs. 38 to 40, the antenna 130 comprises a long laminated body obtained by laminating component layers 130a-130c, internal conductors 133 respectively formed on the component layer 130b and the component layer 130c, and terminal electrodes 132 provided on both ends of the long laminated body.

The internal conductors 133 form an antenna pattern. According to this embodiment, the internal conductors 133 are constructed as reactance elements having approximately λg/4 lengths corresponding to the frequency used, and the antenna pattern is formed in a meander fashion.

Each of the ends of the internal conductors 133 is connected to a respective terminal electrode 132. When the goal is a wide band application, the component layers 130a-130c of the antenna 130 preferably have relative dielectric constants that are as small as possible. From the standpoint of downsizing, on the other hand, the relative dielectric constant should be as large as possible. The material used to form the component layers 130a-130c may therefore be a material having a relative dielectric constant suited for the purpose and for the required performance, specifications, etc. In most cases, the component layers 130a-130c preferably have relative dielectric constants of 2.6-40 and dielectric loss tangents of 0.0075-0.025, and the aforementioned composite dielectric layer is preferably used for each of the component layers 130a-130c, in order to widen the frequency range and allow formation to high precision. Material loss must also be kept to a minimum. The dielectric loss tangent (tanδ) is therefore preferably 0.0025-0.0075 to obtain an antenna with very low material loss. Each of the component layers may be either identical or different, with selection of the optimum combination.

With this type of antenna 130, the changes in the relative dielectric constant with time are adequately minimized even with use at high temperatures. The reliability of the antenna 130 in high temperature environments is therefore increased. Moreover, since the antenna 130 employs composite dielectric layers with high flexural strength as the component layers 130a-130c, it is possible to satisfactorily prevent damage or deformation during handling of the antenna 130.

(Fourteenth embodiment)

Fig. 41 is a perspective view of an antenna as a fourteenth embodiment of an electronic part of the invention, and Fig. 42 is an exploded perspective view of an antenna as a fourteenth embodiment of an electronic part of the invention.

In Figs. 41 and 42, the antenna 140 comprises a laminated body obtained by laminating component layers 140a-140c, and internal conductors 143a formed on the component layers 140b and component layers 140c, respectively. The upper and lower internal conductors 143a are connected to a via hole 144, and form a helical antenna pattern (inductance element). Terminal electrodes are provided on each end of the laminated body similar to the thirteenth embodiment, and both edges of the antenna pattern are connected to respective terminal electrodes.

(Fifteenth embodiment)

Fig. 43 is a perspective view showing a patch antenna as a fifteenth embodiment of an electronic part of the invention, and Fig. 44 is a cross-sectional view showing a patch antenna as a fifteenth embodiment of an electronic part of the invention.

As shown in Figs. 43 and 44, the patch antenna 150 of this embodiment comprises a component layer 150a, a flat patch conductor 159 formed on the surface of the component layer 150a, and a GND conductor 155 formed on the bottom face of the component layer 150a opposite the patch conductor 159. The patch conductor 159 forms an antenna pattern. Also, a power supply through conductor 154 is connected to the patch conductor 159 at a power supply point 153, and the through conductor 154 has a gap 156 with the GND conductor 155 to avoid connection with the GND conductor 155. Power is thus supplied through the through conductor 154 from below the GND conductor 155.

When the goal is a wide band application, the component layer 150a of the patch antenna 150 preferably has a relative dielectric constant which is as small as possible. From the standpoint of downsizing, on the other hand, the relative dielectric constant should be as large as possible. The material used for the component layer 150a may therefore be one having a relative dielectric constant suited for the purpose and for the required performance, specifications, etc. In most cases, the component layer 150a preferably has a relative dielectric constant of 2.6-40 and a dielectric loss tangent of 0.0075-0.025, and the aforementioned composite dielectric layer is preferably used as the component layer 150a. This will widen the frequency range and allow formation to high precision. The dielectric loss tangent (tanδ) may be in the range of 0.0025-0.0075 to obtain an antenna with very low material loss and high radiation efficiency.

A magnetic body produces a wavelength-shortening effect similar to a dielectric body in the frequency band of no greater than a few 100 MHz, which also allowing the inductance value of the radiation element to be increased. By matching the Q frequency peak, it is possible to obtain a high Q value even at relatively low frequencies. Consequently, when using the patch antenna 150 for wireless devices at a few tens to a few 100 MHz, the magnetic permeability is preferably 3-20, and a composite magnetic layer containing magnetic powder is preferably used as the composite layer 150a. This will make it possible to realize higher characteristics and downsizing for the frequency band of no greater than a few 100 MHz. Each of the component layers may be either identical or different, with selection of the optimum combination.

With this type of patch antenna 150, the changes in the relative dielectric constant with time are adequately minimized even with use at high temperatures. The reliability of the patch antenna 150 in high temperature environments is therefore increased. Moreover, since the patch antenna 150 employs a composite dielectric layer with high flexural strength as the component layer 150a, it is possible to satisfactorily prevent damage or deformation during handling of the patch antenna 150.

(Sixteenth embodiment)

Fig. 45 is a perspective view showing a patch antenna as a sixteenth embodiment of an electronic part of the invention, and Fig. 46 is a cross-sectional view showing a patch antenna as a sixteenth embodiment of an electronic part of the invention.

As shown in Figs. 45 and 46, the patch antenna 160 of this embodiment comprises a component layer 160a, a patch conductor (antenna pattern) 169 formed on the surface of the component layer 160a, and a GND conductor 165 formed on the bottom face of the component layer 160a opposite the patch conductor 169. Also, a power supply

conductor 161 is situated on the side of the component layer 160a, near the patch conductor 169 and out of contact therewith, with power being supplied from a power supply terminal 162 to the power supply conductor 161. The power supply terminal 162 is composed of copper, gold, palladium, platinum, aluminum or the like and may be formed by treatment such as plating, terminating, printing, sputtering, vapor deposition or the like. The other constituent features are identical to the fifteenth embodiment, and these identical constituent features are indicated by the same reference numerals and will not be explained.

(Seventeenth embodiment)

Fig. 47 is a perspective view showing a multilayer patch antenna as a seventeenth embodiment of an electronic part of the invention, and Fig. 48 is a cross-sectional view showing a patch antenna as a seventeenth embodiment of an electronic part of the invention.

As shown in Fig. 47, the patch antenna 170 of this embodiment comprises a laminated body obtained by laminating a component layer 150a and a component layer 150b, patch conductors 159a,159e formed respectively on the component layers 150a, 150b, and a GND conductor 155 formed on the bottom face of the component layer 150b opposite the patch conductors 159a,159e. A power supply through the conductor 154 is connected to the patch conductor 159a at a power supply point 153a, and the through conductor 154 has a gap 156 with the GND conductor 155 and patch conductor 159e to avoid connection with the GND conductor 155 and patch conductor 159e. Power is thus supplied to the patch conductor 159a through the through conductor 154 from below the GND conductor 155. Power is supplied to the patch conductor 159e by capacitive coupling with the patch conductor 159a and capacitance formed by the gap with the through conductor 154. The other constituent features are identical to the fifteenth embodiment, and these identical constituent features are indicated by the same reference numerals and will not be explained.

(Eighteenth embodiment)

Fig. 49 is a perspective view showing a multiple patch antenna as an eighteenth embodiment of an electronic part of the invention, and Fig. 50 is a cross-sectional view showing a multiple patch antenna as an eighteenth embodiment of an electronic part of the invention.

The patch antenna 180 of this embodiment differs from the patch antenna of the seventeenth embodiment having only a single conductive element section provided on the laminated body, in that four conductive element sections forming the antenna are provided in a lattice fashion in the laminated body. Specifically, as shown in Figs. 49 and 50, the patch antenna 180 comprises a laminated body obtained by laminating component layers 150a,150b, patch conductors 159a,159b,159c,159d formed on the component layer 150a, patch conductors 159e,159f,159g,159h which are formed on the component layer 150b, and a GND conductor 155 formed on the bottom face of the component layer 150b opposite the patch conductors 159a,159e. The other constituent features are identical to the seventeenth embodiment, and these identical constituent features are indicated by the same reference numerals and will not be explained.

By thus mounting a plurality of conductive element sections in a lattice fashion on a single laminated body, it is possible to downsize the patch antenna and reduce the number of parts.

(Nineteenth embodiment)

Figs. 51 to 53 show a VCO (voltage controlled oscillator) as a nineteenth embodiment of an electronic part of the invention. Fig. 51 is a perspective view, Fig. 52 is a cross-sectional view and Fig. 53 is an equivalent circuit diagram.

In Figs. 51 to 53, the VCO 210 comprises a laminated body obtained by laminating component layers 210a-210g, an electrical element 261 such as a condenser, inductor, semiconductor element, resistor or the like formed and mounted on the laminated body, and conductor patterns 262,263,264 formed on the component layers 210a-210d and on the component layers 210e-210g, respectively. The VCO 210 is constructed to form an equivalent circuit as shown in Fig. 53, and the conductor pattern 263 forms a strip line. The VCO 210 may also have a condenser, signal wire, semiconductor element, power line or the like in addition to the strip line. It is therefore effective to form the component layers of materials which are suited for their respective functions.

More specifically, the strip line 263 is formed as an internal conductor on the surface of the component layer 210g, while the GND conductor 262 and terminal conductor 266 are formed on the back side. Also, a condenser conductor 264 is formed on the surface of the component layer 210e and a wiring inductor conductor 265 is formed on the surface of the component layer 210b. The internal conductors formed on each of the component layers are connected by via holes 214, and electronic parts 261 are mounted on the surface to form a VCO having the equivalent circuit shown in Fig. 53.

In the VCO 210 of this embodiment, for example, composite dielectric layers with dielectric loss tangents of 0.0025-0.0075 are preferably used for the composite layers 210f,210g forming the resonator, while composite dielectric layers with dielectric loss tangents of 0.0075-0.025 and relative dielectric constants of 5-40 are preferably used for the composite layers 210c-210e forming the condenser. Composite dielectric layers with dielectric loss tangents of 0.0025-0.0075 and relative dielectric constants of 2.6-3.5 are preferably used for the composite layers 210a,210b forming the wiring and inductor.

This manner of construction can achieve relative dielectric constants, Q values and dielectric loss tangents suited for different functions, thereby permitting higher performance, downsizing and smaller thickness. With this type of VCO 210, the changes in the relative dielectric constant with time are adequately minimized even with use at high temperatures. The reliability of the VCO 210 in high temperature environments is therefore increased. Moreover, since the VCO 210 employs composite dielectric layers with high flexural strength as the component layers 210a-210g, it is possible to satisfactorily prevent damage or deformation during handling of the VCO 210.

(Twentieth embodiment)

Figs. 54 to 56 show a power amplifier as a twentieth embodiment of an electronic part of the invention. Fig. 54 is an exploded plan view of each component layer, Fig. 55 is a cross-sectional view and Fig. 56 is an equivalent circuit diagram.

As shown in Figs. 54 to 56, the power amplifier 300 comprises a laminated body obtained by laminating component layers 300a-300e, an electrical element 361 such as a condenser, inductor, semiconductor element, resistor or the like formed and mounted on the laminated body, and conductor patterns 313,315 formed in the component layers 300a-300e and on their top and bottom faces. The power amplifier is constructed with the equivalent circuit as shown in Fig. 56, and therefore comprises strip lines L11-L17, condensers C11-C20, signal wires, a power line to the semiconductor, etc. It is therefore effective to form the component layers of materials which are suited for their respective functions.

More specifically, internal conductors 313, GND conductors 315, etc. are formed on the surfaces of these component layers 300a-300e. Each of the internal conductors is connected by a via hole 314, and electronic parts 361 are mounted on the surface of the laminated body to form a power amplifier having the equivalent circuit shown in Fig. 56.

In the power amplifier 300 of this embodiment, composite dielectric layers with dielectric loss tangents of 0.0075-0.025 and relative dielectric constants of 2.6-40 are preferably used for the composite layers 300d,300e forming the strip lines. Composite dielectric layers with dielectric loss tangents of 0.0075-0.025 and relative dielectric constants of 5-40 are preferably used for the composite layers 300a-300c forming the condenser.

This manner of construction can achieve dielectric constants, Q values and dielectric loss tangents suited for different functions, thereby permitting higher performance, downsizing and smaller thickness. With this type of power amplifier 300, the changes in the relative dielectric constant with time are adequately minimized even with use at high temperatures. The reliability of the power amplifier 300 in high temperature environments is therefore increased. Moreover, since the power amplifier 300 employs composite dielectric layers with high flexural strength as the component layers 300a-300e, it is possible to satisfactorily prevent damage or deformation during handling of the power amplifier 300.

(Twenty-first embodiment)

Figs. 57 to 59 show a superposed module used for an optical pickup or the like as a twenty-first embodiment of an electronic part of the invention. Fig. 57 is an exploded plan view showing the different component layers, Fig. 58 is a cross-sectional view, and Fig. 59 is an equivalent circuit diagram.

In Figs. 57 to 59, the superposed module 400 comprises a laminated body obtained by laminating component layers 400a-400k, an electrical element 461 such as a condenser, inductor, semiconductor element, resistor or the like formed and mounted on the laminated body, and conductor patterns 413,415 formed in the component layers 400a-400k and on their top and bottom faces. The superposed module 400 is constructed with the equivalent circuit as shown in Fig. 59, and therefore comprises inductors L21,L23, condensers C21-C27, signal wires, a power line to the semiconductor, etc. It is therefore effective to form the component layers of materials which are suited for their respective functions.

More specifically, internal conductors 413, GND conductors 415, etc. are formed on the surfaces of these component layers 400a-400k. Each of the internal conductors is connected above and below by a via hole 414, and electronic parts 461 are mounted on the surface to form a superposed module having the equivalent circuit shown in Fig. 59.

In the superposed module 400 of this embodiment, composite dielectric layers with dielectric loss tangents

of 0.0075-0.025 and relative dielectric constants of 10-40 are preferably used for the composite layers 400d-400h forming the condenser. Composite dielectric layers with dielectric loss tangents of 0.0025-0.0075 and relative dielectric constants of 2.6-3.5 are preferably used for the composite layers 400a-400c and 400j-400k forming the inductor.

This manner of construction can achieve dielectric constants, Q values and dielectric loss tangents suited for different functions, thereby permitting higher performance, downsizing and smaller thickness. With this type of superposed module 400, the changes in the relative dielectric constant with time are adequately minimized even with use at high temperatures. The reliability of the superposed module 400 in high temperature environments is therefore increased. Moreover, since the superposed module 400 employs composite dielectric layers with high flexural strength as the component layers 400a-400k, it is possible to satisfactorily prevent damage or deformation during handling of the superposed module 400.

(Twenty-second embodiment)

Figs. 60 to 63 show an RF module as a twenty-second embodiment of an electronic part of the invention. Fig. 60 is a perspective view, Fig. 61 is a perspective view with the outer casing member removed, Fig. 62 is an exploded perspective view showing the different component layers, and Fig. 63 is a cross-sectional view.

In Figs. 60 to 63, the RF module 500 comprises a laminated body obtained by laminating component layers 500a-500i, an electrical element 561 such as a condenser, inductor, semiconductor element, resistor or the like mounted on the laminated body, and conductor patterns 513,515,572 and an antenna pattern 573 formed in the component layers 500a-500i and on their top and bottom faces. The RF module 500 comprises inductors, condensers, signal wires, a power line to the semiconductor, etc. as described above. It is therefore effective to form the component layers of materials which are suited for their respective functions.

In the RF module 500 of this embodiment, composite dielectric layers with dielectric loss tangents of 0.0025-0.0075 and relative dielectric constants of 2.6-3.5 are preferably used for the antenna construction, strip line construction and wiring layers 500a-500d,500g forming the inductor. Composite dielectric layers with dielectric loss tangents of 0.0075-0.025 and relative dielectric constants of 10-40 are preferably used for the component layers 500e-500f of the condenser. Composite magnetic layers comprising magnetic powder and having magnetic permeabilities of 3-20 are preferably used for the power line layers 500h-500i.

Internal conductors 513, GND conductors 515, antenna conductors 573, etc. are formed on the surfaces of the component layers 500a-500i. Also, each of the internal conductors are connected above and below by via holes 514, and electronic elements 561 are mounted on the surface of the laminated body to form an RF module.

This manner of construction can achieve dielectric constants, Q values and dielectric loss tangents suited for different functions, thereby permitting higher performance, downsizing and smaller thickness. With this type of RF module 500, the changes in the relative dielectric constant with time are adequately minimized even when the RF module is used at high temperatures. The reliability of the RF module 500 in high temperature environments is therefore increased. Moreover, since the RF module 500 employs composite dielectric layers with high flexural strength as the component layers 500a-500i, it is possible to satisfactorily prevent damage or deformation during handling of the RF module 500.

(Twenty-third embodiment)

Figs. 64 and 65 show a resonator as a twenty-third embodiment of an electronic part of the invention. Fig. 64 is a perspective view, and Fig. 65 is a cross-sectional view.

In Figs. 64 and 65, the resonator 600 is provided with a base material 610 and a cylindrical coaxial conductor 641 running through the base material 610.

The process for fabrication of the resonator 600 is the same as for the block filter of the eleventh embodiment. That is, a surface GND conductor 647 and end conductor 682 are first formed on the surface of the base material 610 with a cylindrical through-hole formed therein by die molding, by treatment such as plating, etching, printing, sputtering, vapor deposition or the like, and then the coaxial conductor 641 is formed on the inner surface of the base material 610 in connection with the surface GND conductor 647 and end conductor 682, and resonator HOT terminal 681 or the like is formed in connection with the coaxial conductor 641. The surface GND conductor 647, end conductor 682, coaxial conductor 641 and resonator HOT terminal 681 are formed of copper, gold, palladium, platinum, aluminum or the like. The coaxial conductor 641 is a coaxial-type line having a specific characteristic impedance, and the surface GND conductor 647 is formed on the base material 610 in a manner surrounding the coaxial conductor 641.

The base material 610 of the resonator has a relative dielectric constant of 2.6-40 in order to achieve the desired resonance characteristic in the frequency band from a few 100 MHz to a few GHz. It is preferred to minimize material loss for the resonator, and the dielectric loss tangent (tanδ) is preferably 0.0025-0.0075. The composite dielectric layer described above is used for the base material 610. According to this type of resonator 600, the changes

in the relative dielectric constant with time are adequately minimized even when the resonator 600 is used at high temperatures. The reliability of the resonator 600 in high temperature environments is therefore increased. Moreover, since the resonator 600 employs a composite dielectric layer with high flexural strength as the base material 610, it is possible to satisfactorily prevent damage or deformation during handling of the resonator 600.

(Twenty-fourth embodiment)

Figs. 66 and 67 show a strip resonator as a twenty-fourth embodiment of an electronic part of the invention. Fig. 66 is a perspective view, and Fig. 67 is a cross-sectional view.

As shown in Figs. 66 and 67, the strip resonator 700 comprises a laminated body obtained by laminating component layers 710a-710d, a rectangular strip conductor 784 formed on the component layer 710c, and rectangular GND conductors 783 formed on the component layer 710b and component layer 710d, sandwiching the strip conductor 784. Also, a resonator HOT terminal 781 and GND terminal 782 are formed on either side of the laminated body, and both ends of the strip conductor 784 are connected to the resonator HOT terminal 781 and GND terminal 782, respectively. The strip resonator 700 may be fabricated in the same manner as the inductor of the first embodiment.

The component layers 710a-710d of the resonator have relative dielectric constants of 2.6-40 in order to achieve the desired resonance characteristic in the frequency band from a few 100 MHz to a few GHz. It is preferred to minimize material loss for the resonator, and the dielectric loss tangent (tanδ) is preferably 0.0025-0.0075. The composite dielectric layer described above is used for the composite layers 710a-710d.

(Twenty-fifth embodiment)

Fig. 68 is a perspective view showing a resonator as a twenty-fifth embodiment of an electronic part of the invention.

As shown in Fig. 68, the resonator 800 comprises a base material 810, a cylindrical coaxial conductor 841 running through the base material 810, and a cylindrical coaxial conductor 842 running through the base material 810 in parallel with the cylindrical coaxial conductor 841. In the base material 810, an end electrode 882 is formed at one end of the coaxial conductor 842, and a connecting electrode 885 is formed at the other end. One end of the coaxial conductor 841 is connected to the coaxial conductor 841 via the connecting electrode 885, while a resonator HOT terminal 881 is formed at the other end. The end electrode 882 and resonator HOT terminal 881 are electrically insulated. Also, a surface GND conductor 847 is formed surrounding the base material 810. The surface GND conductor 847, though connected to the end electrode 882, is electrically insulated from the resonator HOT terminal 881. Thus, the coaxial conductors 841,842 function as coaxial-type lines with specific characteristic impedance.

This type of resonator base material 810 has a relative dielectric constant of 2.6-40 in order to achieve the desired resonance characteristic in the frequency band from a few 100 MHz to a few GHz. It is preferred to minimize material loss for the resonator, and the dielectric loss tangent (tanδ) is preferably 0.0025-0.0075. The composite dielectric layer described above is used for the base material 810.

(Twenty-sixth embodiment)

Fig. 69 is a perspective view showing a strip resonator as a twenty-sixth embodiment of an electronic part of the invention.

In Fig. 69, the strip resonator 850 comprises a laminated body obtained by laminating a plurality of component layers 810, a U-shaped strip conductor 884 formed on the component layers 810, and a rectangular GND conductor 883 sandwiched between upper and lower component layers 810. Resonator HOT terminals 881 and GND terminals 882 are aligned on both sides of the laminated body, and both ends of the strip conductor 884 are connected to the resonator HOT terminals 881 and GND terminals 882, respectively. The strip resonator 850 may be fabricated in the same manner as the inductor of the first embodiment.

The material of the component layers 810 of the resonator 850 has a relative dielectric constant of 2.6-40 in order to achieve the desired resonance characteristic in the frequency band from a few 100 MHz to a few GHz. It is preferred to minimize material loss for the resonator, and the dielectric loss tangent (tanδ) is preferably 0.0025-0.0075. The composite dielectric layer described above is used for the composite layers 810.

Fig. 70 is an equivalent circuit diagram for the resonators of the twenty-third to twenty-sixth embodiments. In Fig. 70, the resonator HOT terminal 981 is connected to one end of a resonator 984,941 composed of coaxial lines or strip lines, while a GND terminal 982 is connected to the other end.

(Twenty-seventh embodiment)

Fig. 71 is a block diagram showing a twenty-seventh embodiment of an electronic part of the invention, as an example of using an electronic part of the invention as a portable data terminal.

In the portable data terminal 1000 shown in Fig. 71, an outgoing signal transmitted from a base band unit 1010 is mixed with an RF signal from a hybrid circuit 1021 by a mixer 1001. A voltage controlled oscillator circuit (VCO) 1020 is connected to the hybrid circuit 1021 and forms a synthesizer circuit together with a phase lock loop circuit 1019, whereby an RF signal of the desired frequency is supplied.

The outgoing signal which has been RF-modulated by the mixer 1001 is amplified by a power amplifier 1003 through a band pass filter (BPF) 1002. A portion of the output from the power amplifier 1003 is retrieved from a coupler 1004, and after being modulated to the desired level by an attenuator 1005, it is re-inputted to the power amplifier 1003 and adjusted so that the power amplifier gain is constant. The outgoing signal transmitted from the coupler 1004 is inputted to a duplexer 1008 through a back flow-preventing isolator 1006 and a low pass filter 1007, and transmitted from a connected antenna 1009.

On the other hand, the incoming signal inputted to the antenna 1009 is inputted from the duplexer 1008 to an amplifier 1011 and amplified to the desired level. The incoming signal outputted from the amplifier 1011 is inputted to a mixer 1013 through a band pass filter 1012. At the mixer 1013, the RF signal is inputted from the hybrid circuit 1021 through a band pass filter (BPF) 1022 and the RF signal component is eliminated and demodulated. The incoming signal outputted from the mixer 1013 is amplified by an amplifier 1015 through a SAW filter 1014, and then inputted to a mixer 1016. A local outgoing signal of the desired frequency is inputted to the mixer 1016 from a local oscillator circuit 1018, and the aforementioned incoming signal is converted to the desired frequency, amplified to the desired level by an amplifier 1017, and then transmitted to a base band unit.

The aforementioned antenna or power amplifier may be used as an antenna front end module 1200 including an antenna 1009, duplexer 1008 and low pass filter 1007 (see broken line in Fig. 71) or as an isolator power amplifier module 1100 including an isolator 1006, coupler 1004, attenuator 1005 and power amplifier 1003 (see broken line in Fig. 71) in the portable data terminal 1000 described above, thereby allowing construction of a hybrid module. The twenty-second embodiment previously illustrated that a part comprising other constituent members may be constructed as an RF unit, and the BPF, VCO, etc. of Fig. 71 may also employ the VCO, etc. of the ninth to twelfth embodiments and the nineteenth embodiment.

When an electronic part according to this embodiment is mounted in a portable data terminal such as described above, the reduced size of the electronic part allows downsizing of the portable data terminal 1000. In addition, since an electronic part according to this embodiment has excellent flexural strength, it is possible to satisfactorily prevent damage or deformation of the electronic part during its handling. Moreover, changes in the dielectric properties of an electronic part according to this embodiment are adequately minimized even with use at high temperatures, and therefore the performance of the portable data terminal 1000 can be maintained for prolonged periods even if it is used in high temperature environments.

(Twenty-eighth embodiment)

A twenty-eighth embodiment of the invention will now be explained in detail.

Fig. 76 is a partial cross-sectional view showing a twenty-eighth embodiment of an electronic part of the invention.

Fig. 76 shows an electronic part which is a power amplifier 1100 provided with a multilayer board 1110 and electrical elements 1120a,1120b formed on the multilayer board 1110.

The multilayer board 1110 has two component layers as outermost layers (first dielectric layers) 1110a,1100g, with a plurality (three in this embodiment) of resin-containing component layers (second dielectric layers) 1110b-1110f being situated between the two outermost layers 1110a,1110g. The multilayer board 1110 comprises conductor layers 1130a-1130h on the surface of a component layer 1110a, between the component layer 1110a and component layer 1110b, between the component layer 1110b and component layer 1110c, between the component layer 1110c and component layer 1110d, between the component layer 1110d and component layer 1110e, between the component layer 1110e and component layer 1110f, between the component layer 1110f and component layer 1110g, and on the surface of the component layer 1110g. The component layers 1110a-1110g and conductor layers 1130a-1130h are constructed in a laminated fashion.

The critical flexures of the component layers 1100a, 1100g in this multilayer board 1110 are at least 1.3 times those of the component layers 1110b-1110f, and the dielectric loss tangents tanδ of the component layers 1110b-1110f are no greater than 0.01.

In other words, the multilayer board 1110 comprises component layers 1110a, 1110g with excellent mechanical strength and component layers 1110b-1110f with excellent electrical properties. It is therefore possible to satisfactorily

maintain electrical properties while adequately preventing damage of the multilayer board 1110 in the power amplifier 1100 even when excessive load is applied to the power amplifier 1100 after its manufacture. That is, the characteristics of this power amplifier 1100 can be sufficiently enhanced.

Since breakage of a bent or flexed multilayer board usually occurs from its surface sections, the dominant part of the strength of the multilayer board depends on the strength of the outermost layers. In this multilayer board 1110, however, the outermost layers of the multilayer board 1110 are component layers 1110a,1110g made of materials with high mechanical strength, and therefore breakage of the multilayer board 1110 is more satisfactorily prevented.

If the critical flexures of the component layers 1100a,1100g are less than 1.3 times those of the component layers 1110b-1110f it becomes difficult to increase the strength of the multilayer board 1110, and damage to the multilayer board 1110 under excessive load cannot be adequately prevented. Also, if the dielectric loss tangents tanδ of the component layers 1110b-1110f are greater than 0.01, the Q value of the power amplifier 1100 is vastly reduced compared to when tanδ is 0.01 or lower, and the electrical properties cannot be satisfactorily maintained.

From the standpoint of increasing the mechanical strength of the power amplifier 1100, the critical flexures of the component layers 1110a,1110b are preferably at least 1.5 times, but preferably not greater than 20 times, those of the component layers 1110b-1110f. If the critical flexures are more than 20 times greater, process handling becomes more difficult. Also, the dielectric loss tangents tanδ of the component layers 1110b-1110f are preferably no greater than 0.005. This will result in more satisfactory electrical properties compared to when tanδ is greater than 0.005.

There are no particular restrictions on the resin contained in the component layers 1110b-1110f. As examples of such resins there may be mentioned tetrafluoroethylene, aromatic liquid crystal polyesters, polyphenylene sulfide, polyvinylbenzyl ether compounds, divinylbenzene, fumarates, polyphenylene oxide (ethers), cyanate esters, bismaleimidetriazine, polyether ether ketone, polyimides, and the like. Such resins may also be mixtures of epoxy resins and cured active ester resins with high Q values.

However, the component layers 1110b-1110f may also comprise, in addition to the aforementioned resin, a ceramic powder with a larger dielectric constant than the resin. This will permit the dielectric loss tangents tanδ of the component layers 1110b-1110f to be reduced to no greater than 0.01 even when using a resin with a low dielectric constant.

Ceramic powders for such use are classified as either dielectric ceramic powders or magnetic powders.

A dielectric ceramic powder is a metal oxide powder comprising at least one metal selected from the group consisting of magnesium, silicon, aluminum, titanium, zinc, calcium, strontium, zirconium, barium, tin, neodymium, bismuth, lithium, samarium and tantalum, and it is preferably a metal oxide powder having a relative dielectric constant of 3.7-300 and a Q value of 500-100,000.

When the relative dielectric constant of the metal oxide powder is less than 3.7, the relative dielectric constant of the composite dielectric layer cannot be increased, and it becomes difficult to reduce the size and weight of the electronic part. If the relative dielectric constant of the metal oxide powder is greater than 300 or the Q value is less than 500, the electronic part 1100 will generate excessive heat during use, and the transmission loss will also tend to be reduced. The dielectric ceramic powder will normally be composed of single crystals or polycrystals.

As specific examples of dielectric ceramic powders there may be mentioned the specific dielectric ceramic powders mentioned above for inclusion in the composite dielectric layer, as well as insulating powders such as silica, glass, hydroxides (aluminum hydroxide, magnesium hydroxide, etc.) and the like. The form of the dielectric ceramic powder may be spherical, granular, scaly or needle-like.

Preferred dielectric ceramic powders are those composed mainly of $TiO_2$, $CaTiO_3$, $SrTiO_3$, $BaO-Nd_2O_3-TiO_2$, $BaO-CaO-Nd_2O_3-TiO_2$, $BaO-SrO-Nd_2O_3-TiO_2$, $BaO-Sm_2O_3-TiO_2$, $BaTi_4O_9$, $Ba_2Ti_9O_{20}$, $Ba_2(Ti,Sn)_9O_{20}$, $MgO-TiO_2$, $ZnO-TiO_2$, $MgO-SiO_2$ and $Al_2O_3$ components, similar to the dielectric ceramic powder included in the aforementioned composite dielectric layer. Dielectric ceramic powders composed mainly of these components may be used alone or in combinations of two or more.

The mean particle size of the dielectric ceramic powder is preferably in the range of 0.01-100 μm and more preferably in the range of 0.2-20 μm, for the same reasons explained above for the dielectric ceramic powder included in the aforementioned composite dielectric layer.

The amount of dielectric ceramic powder added is preferably in the range of 5-185 parts by volume with respect to 100 parts by volume of the organic insulating material, for the same reasons explained above for the dielectric ceramic powder included in the aforementioned composite dielectric layer, and the amount may be appropriately selected within this range depending on the required dielectric constant and dielectric loss tangent.

On the other hand, a magnetic powder can impart magnetic properties to the component layers 1110b-1110f, reduce the linear expansion coefficient and enhance the material strength.

Specific examples of magnetic powders include the magnetic powders mentioned for inclusion in the composite dielectric layer described above. These may be used alone or in combinations of two or more.

The mean particle size of the magnetic powder is preferably in the range of 0.01-100 μm and more preferably in the range of 0.2-20 μm, for the same reasons explained above for the magnetic powder included in the aforementioned composite dielectric layer.

The amount of magnetic powder added is preferably in the range of 5-185 parts by volume with respect to 100 parts by volume of the organic insulating material, for the same reasons explained above for the magnetic powder included in the aforementioned composite dielectric layer, and the amount may be appropriately selected within this range.

As resins to be included in the component layers 1110a,1110g there may be mentioned the resins mentioned for inclusion in the component layers 1110b-1110f, as well as epoxy resins, phenol resins and the like. The component layers 1110a,1110g may also comprise, in addition to the aforementioned resin, a ceramic powder with a larger dielectric constant than the resin. However, if the component layers 1110a,1110g contain a large amount of ceramic powder, it will be difficult for the critical flexures of the component layers 1110a,1110g to be at least 1.3 times those of the component layers 1110b-1110f. On the other hand, a large amount of ceramic powder in the component layers 1110a,1110g will further enhance the electrical properties. Thus, the ceramic powder is preferably added in an appropriate amount, and specifically, the ceramic powder is preferably added at 10-200 parts by volume with respect to 100 parts by volume of the resin.

When a benzyl ether compound is used as the resin in the component layers 1110b-1110f, it is preferred to use an epoxy resin as the resin in the component layers 1110a,1110g, as a thermosetting resin having higher flexural strength and a lower elastic modulus than benzyl ether compounds, and having a relatively low curing temperature compared to other resins.

The peel strengths of the component layers 1110a,1110g in the multilayer board 1110 are preferably at least 1.5 times the peel strengths of the component layers 1110b-1110f. This will allow satisfactorily maintenance of the electrical properties while adequately preventing damage of the multilayer board 1110, even when excessive load is applied to the power amplifier 1100 after its manufacture. This will also increase the anchoring strength and peel strength of the mounted passive/active elements (electrical elements 1120a,1120b) and improve the strengths of both the multilayer board 1110 and of the conductor layers 1130h serving as the electrodes of the power amplifier 1100 functioning as the electronic part, as compared to when the peel strengths are less than 1.5 times greater.

The peel strengths of the component layers 1110a,1110g are more preferably at least 2 times the peel strengths of the component layers 1110b-1110f. However, the peel strengths of the component layers 1110a, 1110g are preferably no greater than 20 times the peel strengths of the component layers 1110b-110f. If the peel strengths of the component layers 1110a, 1110g are greater than 20 times the peel strengths of the component layers 1110b-1110f, the conductor layer (copper foil, for example) must be considerably roughened, and this will adversely affect the high-frequency characteristics of the power amplifier 1100.

More specifically, the peel strengths of the component layers 1110a,1110g are preferably at least 8 N/cm and more preferably at least 10 N/cm. This is advantageous because it inhibits stress-induced damage of the mounted electrical elements 1120a,1120b and peeling of the conductor layers 1130h serving as the terminals, as compared to when the peel strengths of the component layers 1110a,1110g are less than 8 N/cm.

The peel strengths of the component layers 1110a,1110g are preferably no greater than 100 N/cm. If the peel strengths of the component layers 1110a,1110g are greater than 100 N/cm, the conductor layer (copper foil, for example) must be considerably roughened, and this will adversely affect the high-frequency characteristics of the power amplifier 1100.

In Fig. 76, the component layer 1110d has a cloth 1131 made of reinforcing fiber, and it forms a core substrate. The material and thickness of the cloth 1131 are as explained above.

The material forming the aforementioned conductor layers 1130a-1130h is not particularly restricted so long as it is a conductive material, and as such conductive materials there may be mentioned Cu, Ni, Al, Au, Ag and the like, with Cu being preferred among these. Cu reduces the internal resistance and inhibits migration. Condensers, inductors, semiconductors, resistors or the like may be used as the electrical elements 1120a,1120b.

The multilayer board 1110 may be manufactured by a common printed board process such as a build-up process, batch laminating process or the like.

(Twenty-ninth embodiment)

Fig. 77 is a perspective view showing a capacitor (condenser) as a twenty-ninth embodiment of an electronic part of the invention, and Fig. 78 is a partial cross-sectional view showing a capacitor (condenser) as a twenty-ninth embodiment of an electronic part of the invention.

In Figs. 77 and 78, the capacitor 1200 comprises a laminated body obtained by laminating component layers 1200a-1200g, conductor layers 23 formed on the component layers 1200b-1200g, and terminal electrodes 22 provided on either side of the laminated body. The adjacent internal conductors 23 are also connected to different terminal electrodes 22. Land patterns 21 are provided on both ends of the terminal electrodes 22. The component layers 1200a, 1200g are composed of the materials similar to the component layers 1110a,1110b of the twenty-seventh embodiment,

and the component layers 1200b-1200f are composed of the materials similar to the component layers 1110b-1110f of the twenty-seventh embodiment. That is, the critical flexures of the component layers 1200a,1200g are at least 1.3 times those of the component layers 1200b-1200f, and the dielectric loss tangents tanδ of the component layers 1200b-1200f are no greater than 0.01. With this type of capacitor 1200, it is possible to satisfactorily maintain the electrical properties while adequately preventing damage of the capacitor 1200, even when excessive load is applied to the capacitor 1200 after its manufacture.

In order to obtain a high capacitance capacitor 1200, the materials composing the component layers 1200b-1200f among the component layers 1200a-1200g must have dielectric constants which are as high as possible, and it is therefore preferred for the resin contained in the component layers 1200b-1200f to be composited with ceramic powder having a higher dielectric constant than the resin. When the capacitor 1200 is to be used for purposes involving application of a high-frequency electromagnetic field, often the Q value of the capacitor 1200 will also affect the electrical properties, and in such cases tanδ is preferably minimized; consequently, the resin composing the component layers 1200b-1200f may be selected so that tanδ of the resin itself is small, or it may be composited with a ceramic powder having a smaller tanδ than the resin. The resins and ceramic powders mentioned for the twenty-seventh embodiment may be used for the resin or ceramic powder of this embodiment as well. The component layers 1200a,1200g may be the same or different, with selection of the optimum combination. The component layers 1200b-1200f may also be the same or different, with selection of the optimum combination. Constituent features of this embodiment which are identical or equivalent to those of embodiments described above are indicated by the same reference numerals, and will not be explained.

(Thirtieth embodiment)

Fig. 79 is a perspective view showing a inductor as a thirtieth embodiment of an electronic part of the invention, and Fig. 80 is a partial cross-sectional view showing a inductor as a thirtieth embodiment of an electronic part of the invention.

In Figs. 79 and 80, the inductor 1300 comprises a laminated body obtained by laminating component layers 1300a-1300e, internal conductors 13a-13 (conductor layer)d formed on the component layers 1300b-1300e, and via holes 14 for electrical connection of the internal conductors 13a-13d. The internal conductors 13 and via holes 14 form a coil pattern (conductive element section).

The component layers 1300a,1300e are composed of the same materials as the component layers 1110a, 1110g of the twenty-eighth embodiment, and the component layers 1300b-1300d are composed of the same materials as the component layers 1110b-1110f of the twenty-eighth embodiment. That is, the critical flexures of the component layers 1300a,1300g are at least 1.3 times those of the component layers 1300b-1300d, and the dielectric loss tangents tanδ of the component layers 1300b-1300d are no greater than 0.01. With this type of inductor 1300, it is possible to satisfactorily maintain the electrical properties while adequately preventing damage of the inductor 1300, even when excessive load is applied to the inductor 1300 after its manufacture.

In addition, terminal electrodes 12 are provided on opposite sides of the laminated body, and both ends of the coil pattern are respectively connected to the terminal electrodes 12. Land patterns 11 are also formed on both ends of the terminal electrodes 12.

The component layers 1300a,1300e may be the same or different, with selection of the optimum combination. The component layers 1300b-1300d may also be the same or different, with selection of the optimum combination. Constituent features of this embodiment which are identical or equivalent to those of embodiments described above are indicated by the same reference numerals, and will not be explained.

The internal conductors 13a-13d are formed in a helical fashion together with the via holes 14, but the via holes 14 may be omitted so that the internal conductors 13a-13d collectively form a meander shape. This construction can also function as an inductor.

The present invention is not limited to the embodiments described above. For example, an electronic part of the invention may be any of the electronic parts according to the first to twenty-seventh embodiments, or it may be a coil core, toroidal core, disc capacitor, feedthrough capacitor, clamp filter, common mode filter, EMC filter, power filter, pulse transformer, deflection coil, choke coil, DC-DC converter, delay line, wave absorber sheet, thin wave absorber, electromagnetic shield, diplexer, duplexer, antenna switch module, antenna front end module, isolator-power amplifier module, PLL module, front end module, tuner unit, directional coupler, double balanced mixer (DBM), power synthesizer, power distributor, toner sensor, current sensor, actuator, sounder (piezoelectric tone generator), microphone, receiver, buzzer, PTC thermistor, temperature fuse, ferrite magnet, or the like.

A power amplifier 1100, capacitor 1200 and inductor 1300 are used as the electronic parts in the twenty-eighth to thirtieth embodiments, but as alternatives to power amplifiers, capacitors and inductors, applications of electronic parts of the invention may also include VCOs, antenna switch modules, front end modules, PLL modules, RF tuner modules, RF units, superposed modules, TXCOs, or the like.

Also, the critical flexures of the outermost layers in the twenty-eighth to thirtieth embodiments are at least 1.3 times those of the component layers situated between them, but so long as the peel strengths of the outermost layers are at least 1.5 times those of the component layers situated between them, the critical flexures of the outermost layers do not necessarily have to be 1.3 times those of the component layers situated between them. In such cases as well, it is possible to satisfactorily maintain electrical properties while adequately preventing damage of the electronic parts, even when excessive loads are applied to the electronic parts after completion of the products. The peel strengths of the outermost layers are preferably no greater than 20 times those of the component layers situated between them. If the peel strengths of the outermost layers exceed 20 times those of the component layers situated between them, the conductor layer (copper foil, for example) must be considerably roughened, and this will adversely affect the high-frequency characteristics of the electronic parts.

Moreover, although both of the critical flexures of both outermost layers of the twenty-eighth to thirtieth embodiments are at least 1.3 times those of the component layers situated between them, it is sufficient for the critical flexure of at least one of the two outermost layers to be at least 1.3 times those of the aforementioned component layers. In such cases as well, it is possible to satisfactorily maintain electrical properties while adequately preventing damage of the electronic parts, even when excessive loads are applied to the electronic parts after completion of the products.

Preferred examples of the present invention will now be described in detail, with the understanding that the invention is in no way limited thereto.

(Production Example A: Synthesis of active ester compound)

After placing 900 mL of distilled water and 0.5833 mole (23.33 g) of sodium hydroxide in a 2 L separable flask equipped with a nitrogen inlet tube, nitrogen was sufficiently bubbled through the nitrogen inlet tube to remove the oxygen in the distilled water and in the reaction system. Next, 0.54 mole (77.85 g) of α-naphthol was dissolved therein over a period of one hour to obtain an α-naphthol solution. Separately, 600 mL of toluene was added to a different flask which had been raised to a temperature of 60°C, and 0.27 mole (54.82 g) of isophthalic acid chloride (product of Tokyo Kasei Kogyo Co., Ltd.) was dissolved therein.

The isophthalic acid chloride solution was raised to 60°C and then added dropwise to the aforementioned α-naphthol solution over a period of 15 seconds while stirring with a paddle blade at 300 rpm, and reaction was conducted while maintaining the stirring rate for 4 hours. After completion of the reaction, the mixture was separated by standing and the aqueous phase was removed. The toluene phase was subjected three times to a procedure of washing with 0.5% sodium carbonate water for 30 minutes followed by standing for separation, and then three times to a procedure of washing with deionized water for 30 minutes followed by standing for separation. Next, the temperature was raised to remove approximately 400 mL of toluene for concentration, and then 600 mL of heptane was added dropwise over a period of 15 seconds to precipitate di(α-naphthyl) isophthalate. This was filtered and washed with 300 mL of methanol for 30 minutes at room temperature, filtered, and then dried to obtain 106 g of di(α-naphthyl) isophthalate as an active ester compound. The esterification rate was 99.8%. The obtained di(α-naphthyl) isophthalate will hereunder be referred to as "IAAN".

(Production Example B: Synthesis of polyarylate)

A solution comprising 1.031 kg of isoterephthaloyl chloride, 0.258 kg of terephthaloyl chloride, 0.057 kg of methyltrioctylammonium chloride and 27.3 kg of toluene was mixed and stirred with a solution comprising 1.540 kg of 3,3'-5,5'-tetramethylbiphenol, 0.648 kg of sodium hydroxide and 19.2 kg of deoxygenated water in a 100 L kiln at 11°C for contact for a period of 30 minutes.

The resulting solution was separated by standing, the aqueous phase was removed, and the toluene phase was then washed with water three times. Next, methanol was supplied as a weak solvent to the obtained toluene phase at rates of 10 L/min and 100 L/min, respectively, and the mixture was continuously passed through a continuous shearing machine (FM-25 Fine Flow Mill by Pacific Machinery & Engineering Co., Ltd.; blade circumferential speed: 15 m/sec) for precipitation (polyarylate precipitation). The obtained polyarylate was then collected on a filter medium and subjected three times to a procedure of washing with hot water at 80°C for 30 minutes in a kiln followed by filtering, and then dried to obtain the polyarylate. The inherent viscosity of the polyarylate was 1.5 dL/g as determined in chloroform (0.1 g/dL) at 30°C using an Ubbelohde viscometer. The obtained polyarylate will hereunder be referred to as "polyarylate 1".

(Example A1)

After placing 177 parts by weight of a $BaNd_2TiO_4$-based dielectric ceramic powder (mean particle size: 1.6

μm, dielectric property in gigahertz band: ε90/Q1700, product of TDK), 620 parts by weight of tetrahydrofuran as an organic solvent and 0.9 part by weight of KBM573 (product of Shin-Etsu Chemical Co., Ltd.) as a coupling agent in a 5 liter beaker, a stirrer was used for stirring for 4 hours. This was followed by addition of 174 parts by weight of EPICLON HP7200H (product of Dainippon Ink and Chemicals, Inc.) as an epoxy resin, 158 parts by weight of IAAN as an active ester compound, 48 parts by weight of EPICLON152 (product of Dainippon Ink and Chemicals, Inc.) as a flame retardant and 1.1 parts by weight of CUREZOL 2E4MZ (product of Shikoku Corp.) as a curing accelerator, and then stirring to complete dissolution and dispersion to obtain a paste (paste A).

Separately, 67 parts by weight of polyarylate 1 and 840 parts by weight of tetrahydrofuran as an organic solvent were placed in a 2 liter beaker and stirred to complete dissolution and dispersion of the polyarylate to obtain a paste (paste B).

Next, paste B was placed in a beaker containing paste A and stirred to complete dispersion to obtain a paste (paste C).

This paste C was coated onto an 18 μm electrolytic copper foil (CF-T9, product of Fukuda Metal Foil Powder Co., Ltd.) or a 50 μm PET film using a doctor blade, and dried at 50°C/10 min + 120°C/10 min. The thickness of the obtained resin composition was 50 μm. Twelve layers were stacked and pressed with a high-temperature vacuum press (Model KVHC by Kitagawa Seiki Co., Ltd.) under the following conditions: [Temperature profile: temperature increase from 30°C to 150°C at 2°C/min and holding at that temperature for 60 minutes, followed by temperature increase to 190°C at 3°C/min and holding at that temperature for 60 minutes; Pressure: 3 MPa; Vacuum degree: ≤30 torr]. The thickness of the obtained cured resin composition after pressing was 500 μm.

(Examples A2-A11)

Cured products containing $BaNd_2TiO_4$-based dielectric ceramic powder were obtained in the same manner as Example A1, except that the materials listed in Table 1 were used in the weights listed in the same table.

(Examples B1-B8)

Cured products containing $Ba_2Ti_9O_{20}$-based dielectric ceramic powder (mean particle size: 1.7 μm; dielectric property in gigahertz band: ε39/Q9000, product of TDK) were obtained in the same manner as Example A1, except that the materials listed in Table 2 were used in the weights listed in the same table.

(Examples C1-C8)

Cured products containing $Al_2O_3$-based dielectric ceramic powder (mean particle size: 2.2 μm; dielectric property in gigahertz band: ε9.8/Q40000, product of TDK) were obtained in the same manner as Example A1, except that the materials listed in Table 3 were used in the weights listed in the same table.

(Comparative Example 1)

A cured product containing 332 g of polyvinyl benzyl ether instead of an epoxy resin and active ester compound was obtained in the same manner as Example B5, except that the materials listed in Table 2 were used in the weights listed in the same table.

The dielectric constants, dielectric loss tangents, glass transition temperatures and moisture absorptions of the cured products obtained in Examples A1-A11, B1-B8 and C1-C8 were measured by the following methods.

(Dielectric constant and dielectric loss tangent)

The cured product was cut into a rod-shaped sample with a 100 mm length, 1.5 mm width and 0.5 mm thickness, and the dielectric constant and dielectric loss tangent were measured at a frequency of 2 GHz by the cavity resonator perturbation method (using a high-frequency dielectric property tester developed by TDK and an 83620A and 8757D by Hewlett-Packard).

(Glass transition temperature)

A DSC-50 (Shimazu Corp.) was used for measurement according to the method of JIS C6481 in a temperature range from 30°C to 200°C at a temperature elevating rate of 10°C/min, and the glass transition temperature was determined by calculating the midpoint between the onset and endset of the endothermic curve.

(Moisture absorption)

The cured product was cut into a flat sample with a 50 mm length, 50 m width and 0.5 mm thickness, dried under reduced pressure at 120°C/hr (at a reduced pressure of no greater than 5 torr) and allowed to stand for 1 hour in a constant-temperature, constant-humidity tank kept at 25°C/60% RH, and then the initial weight was measured with a precision balance (ER-182A, product of Kensei Kogyo Co., Ltd.). After subsequently standing for 24 hours in a high-temperature, high-humidity tank kept at 85°C/85% RH, being removed from the tank and then standing for 1 hour in a constant-temperature, constant-humidity tank kept at 25°C/60% RH, the post-testing weight was measured with the precision balance. The moisture absorption was calculated by the following formula.

Moisture absorption (%) = (Post-testing weight - initial weight)/initial weight x 100

Paste C (or the substance equivalent to paste C) obtained in each of Examples A1-A11, B1-B8 and C1-C8 was used for a flow property test by the following method.

(Flow property)

Paste C (or the substance equivalent to paste C) was coated onto an 18 μm electrolytic copper foil to a 100 mm length, 100 mm width and 0.05 mm thickness, and dried at 50°C/10 min + 120°C/10 min to prepare a resin-coated copper foil. A release film, jig template (thickness: 2 mm) and cushion material were laminated in that order on the front and back sides of the resin-coated copper foil, and the laminate was pressed with a high-temperature vacuum press (Model KVHC by Kitagawa Seiki Co., Ltd.) under the following conditions: [Temperature profile: temperature increase from 30°C to 150°C at 2°C/min and holding at that temperature for 60 minutes; Pressure: 3 MPa; Vacuum degree: ≤30 torr], after which the dimensional change after pressing was measured and the flow property was calculated by the following formula.

Flow property (%) = (Area after pressing - area before pressing)/area before pressing x 100

The results of the test are shown in Tables 1 to 3, together with the resin compositions used. Dielectric constants of 3.0 or greater as measured under the conditions described above may be considered high dielectric constants, while dielectric loss tangents of 0.0045 or lower may be considered low dielectric loss tangents. Glass transition temperatures of 130°C or higher may be considered high, while moisture absorption values of 0.20% or below may be considered low moisture absorption values. The symbols "○" and "Δ" in the flow property rows of Tables 1 to 3 represent, respectively, a flow property of 101% or greater (○) and a flow property of 100.1 % and less than 101% (Δ).

Table 1

| | | Example A1 | Example A2 | Example A3 | Example A4 | Example A5 | Example A6 | Example A7 | Example A8 | Example A9 | Example A10 | Example A11 |
|---|---|---|---|---|---|---|---|---|---|---|---|---|
| Epoxy resin | EPICLON-HP7200H | 174 | 174 | 174 | 174 | 174 | 174 | 174 | 174 | 174 | 177 | 174 |
| | YX-4000 | - | - | - | - | - | - | - | - | - | 75 | - |
| Active ester compound | IAAN | 158 | 158 | 158 | 158 | 158 | 158 | 158 | 158 | 158 | 240 | 158 |
| Polyarylate | Polyarylate 1 | 67 | 67 | 67 | 67 | 67 | 67 | 67 | 67 | 67 | 93 | 67 |
| Flame retardant | EPICLON152 | 48 | 48 | 48 | 48 | 48 | 48 | 48 | 48 | 48 | 36 | 48 |
| Curing accelerator | CUREZOL 2E4MZ | 1.1 | 1.1 | 1.1 | 1.1 | 1.1 | 1.1 | 1.1 | 1.1 | - | - | 1.1 |
| | DMAP | - | - | - | - | - | - | - | - | 1.1 | 1.1 | - |
| Organic solvent | THF | 1460 | 1460 | 1460 | 1460 | 1460 | 1460 | 1460 | 1460 | 1460 | 1460 | 1460 |
| Dielectric ceramic powder | $BaNd_2Ti_4O_{12}$ | 177 | 354 | 708 | 1062 | 1415 | 1769 | 2123 | 2300 | 1415 | 1971 | - |
| | $Ba_2Ti_9O_{20}$ | - | - | - | - | - | - | - | - | - | - | - |
| | $Al_2O_3$ | - | - | - | - | - | - | - | - | - | - | - |
| Surface treatment agent | KBM573 | 0.9 | 1.8 | 3.5 | 5.3 | 7.1 | 8.9 | 10.6 | 11.5 | 7.1 | 9.9 | - |
| Dielectric ceramic powder content (pts/vol) | | 5 | 10 | 20 | 30 | 40 | 50 | 60 | 65 | 40 | 40 | 0 |
| Dielectric constant (2 GHz) | Perturbation (cavity resonator) | 3.2 | 3.8 | 5.5 | 7.9 | 11.3 | 15.9 | 22.0 | 24.0 | 11.2 | 11.2 | 2.8 |
| Dielectric loss tangent (2 GHz) | Perturbation (cavity resonator) | 0.0043 | 0.0042 | 0.0038 | 0.0036 | 0.0033 | 0.0031 | 0.0029 | 0.0027 | 0.0034 | 0.0030 | 0.0048 |
| Flow property | | o | o | o | o | o | o | o | Δ | o | o | o |
| Glass transition temperature | DSC method (°C) | 132 | 133 | 133 | 133 | 133 | 134 | 134 | 133 | 136 | 134 | 132 |
| Moisture absorption | 85°C/85% RH x 24 hours (%) | 0.19 | 0.16 | 0.13 | 0.09 | 0.07 | 0.05 | 0.04 | 0.04 | 0.07 | 0.07 | 0.21 |

EPICLON-HP7200H (Dicyclopentadiene-type epoxy resin, epoxy equivalents: 280, Dainippon Ink and Chemicals, Inc.), YX-4000 (Biphenol-type epoxy resin, epoxy equivalents: 186, Yuka Shell Epoxy Co., Ltd.), EPICLON152 (Brominated bisphenol A-type epoxy resin, epoxy equivalents: 360, bromine content: 45%, Dainippon Ink and Chemicals, Inc.), CUREZOL 2E4MZ (2-Ethyl-4-methylimidazole, Shikoku Corp.), DMAP (Dimethylaminopyridine, Tokyo Kasei Kogyo Co., Ltd.), KBM573 (N-Phenyl-γ-aminopropyltriethoxysilane, Shin-Etsu Chemical Co., Ltd.)

Table 2

| | | Example B1 | Example B2 | Example B3 | Example B4 | Example B5 | Example B6 | Example B7 | Example B8 | Comp. Ex. 1 |
|---|---|---|---|---|---|---|---|---|---|---|
| Epoxy resin | EPICLON-HP7200H | 174 | 174 | 174 | 174 | 174 | 174 | 174 | 174 | - |
| | YX-4000 | - | - | - | - | - | - | - | - | - |
| Active ester compound | IAAN | 158 | 158 | 158 | 158 | 158 | 158 | 158 | 158 | - |
| Polyvinylbenzyl ether | | - | - | - | - | - | - | - | - | 332 |
| Polyarylate | Polyarylate 1 | 67 | 67 | 67 | 67 | 67 | 67 | 67 | 67 | 67 |
| Flame retardant | EPICLON152 | 48 | 48 | 48 | 48 | 48 | 48 | 48 | 48 | 48 |
| Curing accelerator | CUREZOL 2E4MZ | 1.1 | 1.1 | 1.1 | 1.1 | 1.1 | 1.1 | 1.1 | 1.1 | 1.1 |
| | DMAP | - | - | - | - | - | - | - | - | - |
| Organic solvent | THF | 1460 | 1460 | 1460 | 1460 | 1460 | 1460 | 1460 | 1460 | 1460 |
| Dielectric ceramic powder | $BaNd_2Ti_4O_{12}$ | - | - | - | - | - | - | - | - | - |
| | $Ba_2Ti_9O_{20}$ | 177 | 354 | 708 | 1062 | 1415 | 1769 | 2123 | 2300 | 1415 |
| | $Al_2O_3$ | - | - | - | - | - | - | - | - | - |
| Surface treatment agent | KBM573 | 0.9 | 1.8 | 3.5 | 5.3 | 7.1 | 8.9 | 10.6 | 11.5 | 7.1 |
| Dielectric ceramic powder content (pts/vol) | | 5 | 10 | 20 | 30 | 40 | 50 | 60 | 65 | 40 |
| Dielectric constant (2 GHz) | Perturbation (cavity resonator) | 3.1 | 3.6 | 5.0 | 6.9 | 9.2 | 12.1 | 15.7 | 17.2 | - |
| Dielectric loss tangent (2 GHz) | Perturbation (cavity resonator) | 0.0042 | 0.0041 | 0.0036 | 0.0035 | 0.0034 | 0.0030 | 0.0028 | 0.0027 | - |
| Flow property | | ○ | ○ | ○ | ○ | ○ | ○ | ○ | Δ | - |
| Glass transition temperature | DSC method (°C) | 131 | 133 | 133 | 134 | 134 | 133 | 135 | 134 | - |
| Moisture absorption | 85°C/85% RH x 24 hours (%) | 0.2 | 0.17 | 0.14 | 0.1 | 0.08 | 0.06 | 0.05 | 0.04 | - |

EPICLON-HP7200H (Dicyclopentadiene-type epoxy resin, epoxy equivalents: 280, Dainippon Ink and Chemicals, Inc.), YX-4000 (Biphenol-type epoxy resin, epoxy equivalents: 186, Yuka Shell Epoxy Co., Ltd.), EPICLON152 (Brominated bisphenol A-type epoxy resin, epoxy equivalents: 360, bromine content: 45%, Dainippon Ink and Chemicals, Inc.), CUREZOL 2E4MZ (2-Ethyl-4-methylimidazole, Shikoku Corp.), DMAP (Dimethylaminopyridine, Tokyo Kasei Kogyo Co., Ltd.), KBM573 (N-Phenyl-γ-aminopropyltriethoxysilane, Shin-Etsu Chemical Co., Ltd.)

Table 3

| | | Example C1 | Example C2 | Example C3 | Example C4 | Example C5 | Example C6 | Example C7 | Example C8 |
|---|---|---|---|---|---|---|---|---|---|
| Epoxy resin | EPICLON-HP7200H | 174 | 174 | 174 | 174 | 174 | 174 | 174 | 174 |
| | YX-4000 | - | - | - | - | - | - | - | - |
| Active ester compound | IAAN | 158 | 158 | 158 | 158 | 158 | 158 | 158 | 158 |
| Polyarylate | Polyarylate 1 | 67 | 67 | 67 | 67 | 67 | 67 | 67 | 67 |
| Flame retardant | EPICLON152 | 48 | 48 | 48 | 48 | 48 | 48 | 48 | 48 |
| Curing accelerator | CUREZOL 2E4MZ | 1.1 | 1.1 | 1.1 | 1.1 | 1.1 | 1.1 | 1.1 | 1.1 |
| | DMAP | - | - | - | - | - | - | - | - |
| Organic solvent | THF | 1460 | 1460 | 1460 | 1460 | 1460 | 1460 | 1460 | 1460 |
| Dielectric ceramic powder | $BaNd_2Ti_4O_{12}$ | - | - | - | - | - | - | - | - |
| | $Ba_2Ti_9O_{20}$ | - | - | - | - | - | - | - | - |
| | $Al_2O_3$ | 177 | 354 | 708 | 1062 | 1415 | 1769 | 2123 | 2300 |
| Surface treatment agent | KBM573 | 0.9 | 1.8 | 3.5 | 5.3 | 7.1 | 8.9 | 10.6 | 11.5 |
| Dielectric ceramic powder content (pts/vol) | | 5 | 10 | 20 | 30 | 40 | 50 | 60 | 65 |
| Dielectric constant (2 GHz) | Perturbation (cavity resonator) | 3.0 | 3.2 | 3.8 | 4.4 | 5.1 | 5.8 | 6.5 | 7.0 |
| Dielectric loss tangent (2 GHz) | Perturbation (cavity resonator) | 0.004 | 0.004 | 0.004 | 0.003 | 0.003 | 0.003 | 0.003 | 0.003 |
| Flow property | | ○ | ○ | ○ | ○ | ○ | ○ | ○ | Δ |
| Glass transition temperature | DSC method (°C) | 131 | 132 | 132 | 133 | 132 | 133 | 133 | 134 |
| Moisture absorption | 85°C/85% RH x 24 hours (%) | 0.2 | 0.17 | 0.13 | 0.1 | 0.07 | 0.06 | 0.05 | 0.04 |

EPICLON-HP7200H (Dicyclopentadiene-type epoxy resin, epoxy equivalents: 280, Dainippon Ink and Chemicals, Inc.), YX-4000 (Biphenol-type epoxy resin, epoxy equivalents: 186, Yuka Shell Epoxy Co., Ltd.), EPICLON152 (Brominated bisphenol A-type epoxy resin, epoxy equivalents: 360, bromine content: 45%, Dainippon Ink and Chemicals, Inc.), CUREZOL 2E4MZ (2-Ethyl-4-methylimidazole, Shikoku Corp.), DMAP (Dimethylaminopyridine, Tokyo Kasei Kogyo Co., Ltd.), KBM573 (N-Phenyl-γ-aminopropyltriethoxysilane, Shin-Etsu Chemical Co., Ltd.)

In Example B5 and Comparative Example 1, the flexural strength (JIS C6481), elastic modulus (JIS C6481) and copper foil peel strength (JIS C6481) were measured. The results are shown in Table 4. For Example B5, the dielectric constant was determined by heating a rod-shaped sample of measured size at 125°C for 1000 hours, measuring the dielectric constant under the conditions specified above at 240 hours, 500 hours and 1000 hours after the start of heating. The difference between these and the dielectric constant measured without heating was then determined. The results are shown in Fig. 81. As seen in Fig. 81, the cured product of Example B5 exhibited only a small increase in dielectric constant when held for a prolonged period at high temperature.

Table 4

| | Example B5 | Comp. Ex 1 |
|---|---|---|
| Flexural strength (MPa) | 125 | 85 |
| Elastic modulus (GPa) | 9.0 | 11.0 |
| Copper foil peel strength (N/cm) | 10.0 | 6.0 |

(Example 1)

After placing 177 parts by weight of a $BaNd_2TiO_4$-based dielectric ceramic powder (mean particle size: 1.6 μm, dielectric property in gigahertz band: ε90/Q1700, product of TDK), 620 parts by weight of tetrahydrofuran as an organic solvent and 0.9 part by weight of KBM573 (product of Shin-Etsu Chemical Co., Ltd.) as a coupling agent in a 5 liter beaker, a stirrer was used for stirring for 4 hours. This was followed by addition of 174 parts by weight of EPICLON HP7200H (product of Dainippon Ink and Chemicals, Inc.) as an epoxy resin, 158 parts by weight of IAAN as an active ester compound, 48 parts by weight of EPICLON152 (product of Dainippon Ink and Chemicals, Inc.) as a flame retardant and 1.1 parts by weight of CUREZOL 2E4MZ (product of Shikoku Corp.) as a curing accelerator, and stirring to complete dissolution and dispersion to obtain a paste (paste D).

Separately, 67 parts by weight of polyarylate 1 and 840 parts by weight of tetrahydrofuran as an organic solvent were placed in a 2 liter beaker and stirred to complete dissolution and dispersion of the polyarylate to obtain a paste (paste E).

Next, paste E was placed in a beaker containing paste D and stirred to complete dispersion to obtain a paste (paste F).

This paste F was coated onto a 2116 type glass cloth (NEA2116, thickness: 100 μm, product of Nitto Boseki Co., Ltd.), and dried at 50°C/10 min + 120°C/10 min to obtain a prepreg. The thickness of the obtained prepreg was 170 μm. Three layers were stacked and pressed with a high-temperature vacuum press (Model KVHC by Kitagawa Seiki Co., Ltd.) under the following conditions: [Temperature profile: temperature increase from 30°C to 150°C at 2°C/min and holding at that temperature for 60 minutes, followed by temperature increase to 190°C at 3°C/min and holding at that temperature for 60 minutes; Pressure: 3 MPa; Vacuum degree: ≤30 torr], to obtain a cured resin sheet. The thickness of the obtained cured resin sheet was 500 μm.

(Examples 2-9)

Prepregs and cured resin sheets containing $BaNd_2TiO_4$-based dielectric ceramic powder were obtained in the same manner as Example 1, except that the materials listed in Table 5 were used in the weights listed in the same table.

(Example 10)

A prepreg and cured resin sheet containing $Ba_2Ti_9O_{20}$-based dielectric ceramic powder (mean particle size: 1.7 μm; dielectric property in gigahertz band: ε39/Q9000, product of TDK) was obtained in the same manner as Example 1, except that the materials listed in Table 5 were used in the weights listed in the same table.

(Example 11)

A prepreg and cured resin sheet containing $Al_2O_3$-based dielectric ceramic powder (mean particle size: 2.2 μm; dielectric property in gigahertz band: ε9.8/Q40000, product of TDK) was obtained in the same manner as Example 1, except that the materials listed in Table 5 were used in the weights listed in the same table.

The dielectric constants, dielectric loss tangents, glass transition temperatures and moisture absorptions of the cured resin sheets obtained in Examples 1-11 were measured by the same methods as in Example A1.

Also, paste F (or a substance equivalent to paste F) obtained in each of Examples 1-9 was used for a filling/adhesion property test by the following method.

(Filling/adhesion property)

Paste F (or a substance equivalent to paste F) was coated onto a 2116 type glass cloth (NEA2116, thickness: 100 μm, product of Nitto Boseki Co., Ltd.) to a thickness of 0.17 mm, and dried at 50°C/10 min + 120°C/10 min to obtain a prepreg. An 18 μm thick electrolytic copper foil (CF-T9, product of Fukuda Metal Foil Powder Co., Ltd.), jig template (thickness: 2 mm) and cushion material were laminated in that order on the front and back sides of the prepreg, and the laminate was pressed with a high-temperature vacuum press (Model KVHC by Kitagawa Seiki Co., Ltd.) under the following conditions: [Temperature profile: temperature increase from 30°C to 150°C at 2°C/min and holding at that temperature for 60 minutes; Pressure: 3 MPa; Vacuum degree: ≤30 torr]. The laminated board fabricated in this manner (a board coated with metal foil on both sides) was observed by SEM to examine the internal filling property, while adhesion to the metal foil was evaluated by peeling the metal foil in a 100 mm x 100 mm area.

The results of this test are shown in Table 5 together with the compositions. Dielectric constants of 3.6 or greater as measured under the conditions described above may be considered high dielectric constants, while dielectric loss tangents of 0.05 or lower may be considered low dielectric loss tangents. Glass transition temperatures of 120°C or higher may be considered high, while moisture absorption values of 0.1 % or below may be considered low moisture absorption values. The symbols "○" and "Δ" in the filling/adhesion property row of Table 5 represent, respectively, filling with no gaps and satisfactory adhesion with the prepreg (○), and partial gaps and incomplete adhesion with the prepreg (Δ).

Table 5

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| Epoxy resin | EPICLON-HP7200H | 174 | 174 | 174 | 174 | 174 | 174 | 174 | 174 | 177 | 174 | 174 |
| | YX-4000 | - | - | - | - | - | - | - | - | 75 | - | - |
| Active ester compound | IAAN | 158 | 158 | 158 | 158 | 158 | 158 | 158 | 158 | 240 | 158 | 158 |
| Polyarylate | Polyarylate 1 | 67 | 67 | 67 | 67 | 67 | 67 | 67 | 67 | 93 | 67 | 67 |
| Flame retardant | EPICLON152 | 48 | 48 | 48 | 48 | 48 | 48 | 48 | 48 | 36 | 48 | 48 |
| Curing accelerator | CUREZOL 2E4MZ | 1.1 | 1.1 | 1.1 | 1.1 | 1.1 | 1.1 | 1.1 | - | - | 1.1 | 1.1 |
| | DMAP | - | - | - | - | - | - | - | 1.1 | 1.1 | - | - |
| Organic solvent | THF | 1460 | 1460 | 1460 | 1460 | 1460 | 1460 | 1460 | 1460 | 1460 | 1460 | 1460 |
| Dielectric ceramic powder | $BaNd_2Ti_4O_{12}$ | 177 | 354 | 708 | 1062 | 1415 | 1769 | 1730 | 1415 | 1971 | - | - |
| | $Ba_2Ti_9O_{20}$ | - | - | - | - | - | - | - | - | - | 1415 | - |
| | $Al_2O_3$ | - | - | - | - | - | - | - | - | - | - | 1415 |
| Surface treatment agent | KBM573 | 0.9 | 1.8 | 3.5 | 5.3 | 7.1 | 8.9 | 8.7 | 7.1 | 9.9 | 7.1 | 7.1 |
| Dielectric ceramic powder content (pts/vol) | | 5 | 10 | 20 | 30 | 40 | 50 | 55 | 40 | 40 | 40 | 40 |
| Dielectric constant (2 GHz) | Perturbation (cavity resonator) | 3.6 | 4 | 4.8 | 6.8 | 9.7 | 12.3 | 13.1 | 10.2 | 10.1 | 8.1 | 4.7 |
| Dielectric loss tangent (2 GHz) | Perturbation (cavity resonator) | 0.0031 | 0.0033 | 0.0036 | 0.0038 | 0.0038 | 0.0040 | 0.0042 | 0.0038 | 0.0030 | 0.0033 | 0.003 |
| Filling/adhesion property | | o | o | o | o | o | o | Δ | o | o | - | - |
| Glass transition temperature | DSC method (°C) | 133 | 134 | 133 | 133 | 134 | 133 | 132 | 133 | 135 | 134 | 132 |
| Moisture absorption | 85°C/85% RH x 24 hours (%) | 0.08 | 0.07 | 0.06 | 0.05 | 0.04 | 0.04 | 0.04 | 0.04 | 0.04 | 0.05 | 0.04 |

EPICLON-HP7200H (Dicyclopentadiene-type epoxy resin, epoxy equivalents: 280, Dainippon Ink and Chemicals, Inc.), YX-4000 (Biphenol-type epoxy resin, epoxy equivalents: 186, Yuka Shell Epoxy Co., Ltd.), EPICLON152 (Brominated bisphenol A-type epoxy resin, epoxy equivalents: 360, bromine content: 45%, Dainippon Ink and Chemicals, Inc.), CUREZOL 2E4MZ (2-Ethyl-4-methylimidazole, Shikoku Corp.), DMAP (Dimethylaminopyridine, Tokyo Kasei Kogyo Co., Ltd.), KBM573 (N-Phenyl-γ-aminopropyltriethoxysilane, Shin-Etsu Chemical Co., Ltd.

(Example 12)

After placing 1415 parts by weight of a $Ba_2Ti_9O_{20}$-based dielectric ceramic powder (mean particle size: 1.7 μm; dielectric property in gigahertz frequency band: ε39/Q9000, product of TDK), 620 parts by weight of tetrahydrofuran as an organic solvent and 7.1 parts by weight of KBM573 (product of Shin-Etsu Chemical Co., Ltd.) as a coupling agent in a 5 liter beaker, a stirrer was used for stirring for 4 hours. This was followed by addition of 174 parts by weight of EPICLON HP7200H (product of Dainippon Ink and Chemicals, Inc.) as an epoxy resin, 158 parts by weight of IAAN as an active ester compound, 48 parts by weight of EPICLON152 (product of Dainippon Ink and Chemicals, Inc.) as a flame retardant and 1.1 parts by weight of CUREZOL 2E4MZ (product of Shikoku Corp.) as a curing accelerator, and stirring to complete dissolution and dispersion to obtain a paste (paste G).

Separately, 67 parts by weight of polyarylate 1 and 840 parts by weight of tetrahydrofuran as an organic solvent were placed in a 2 liter beaker and stirred to complete dissolution and dispersion of the polyarylate to obtain a paste (paste H).

Next, paste H was placed in a beaker containing paste G and stirred to complete dispersion to obtain a paste (paste I).

This paste I was coated onto an 18 μm electrolytic copper foil (CF-T9, product of Fukuda Metal Foil Powder Co., Ltd.) or a 50 μm PET film using a doctor blade, and dried at 50°C/10 min + 120°C/10 min. The thickness of the obtained sheet was 50 μm. Twelve layers were stacked and pressed with a high-temperature vacuum press (Model KVHC by Kitagawa Seiki Co., Ltd.) under the following conditions: [Temperature profile: temperature increase from 30°C to 150°C at 2°C/min and holding at that temperature for 60 minutes, followed by temperature increase to 190°C at 3°C/min and holding at that temperature for 60 minutes; Pressure: 3 MPa; Vacuum degree: ≤30 torr]. The thickness of the obtained cured sheet after pressing was 500 μm. (Comparative Example 2)

A cured product containing 332 g of polyvinylbenzyl ether instead of an epoxy resin and active ester compound was obtained in the same manner as Example 12, except that the materials listed in Table 6 were used in the weights listed in the same table. Of the flexibilizer materials shown in Table 6, TOUGHTEC H1043 is a hydrogenated styrene-butadiene-styrene triblock copolymer (Asahi Kasei Corp.) and SAYTEX BT93 is ethylene bistetrabromophthalimide (Albemarle Co., Ltd.).

The dielectric constants, dielectric loss tangents, glass transition temperatures and moisture absorptions of the cured sheets obtained in Example 12 were determined in the same manner as Example A1 above.

The flexural strength (MPa) of the cured sheet was measured according to JIS C6481.

The results of these tests are shown below in Table 6, together with the resin compositions used. Relative dielectric constants of 3.6 or greater as measured under the conditions described above may be considered high dielectric constants, while dielectric loss tangents of 0.05 or lower may be considered low dielectric loss tangents. Glass transition temperatures of 120°C or higher may be considered high, while moisture absorption values of 0.1 or below may be considered low moisture absorption values.

Table 6

| | | Example 12 | Comp. Ex. 2 |
|---|---|---|---|
| Epoxy resin | - | 174 | - |
| Active ester compound | - | 158 | - |
| Polyvinylbenzyl ether | - | - | 344 |
| Flexibilizer | Polyarylate | 67 | - |
| | TOUGHTEC H1043 | - | 86 |
| Flame retardant | EPICLON 152 | 48 | - |
| | SAYTEX BT93 | - | 122 |
| Curing accelerator | CUREZOL 2E4MZ | 1.1 | - |
| | Dicumyl peroxide | - | 5.2 |
| Organic solvent | THF | 1390 | - |
| | Toluene | - | 1967 |
| Dielectric ceramic powder | $Ba_2Ti_9O_{20}$-based | 1415 | 1415 |
| Surface treatment agent | KBM573 | 7.1 | 7.1 |

Table 6 (continued)

| | | Example 12 | Comp. Ex. 2 |
|---|---|---|---|
| Dielectric ceramic powder content | Vol% | 40 | 40 |
| Dielectric constant (2 GHz) | Perturbation (cavity resonator) | 9.2 | 8.8 |
| Dielectric loss tangent (2GHz) | Perturbation (cavity resonator) | 0.0034 | 0.0029 |
| Glass transition temperature (°C) | DSC method | 134 | 192 |
| Moisture absorption (%) | 85°C/85% RH 24 hours | 0.08 | 0.05 |
| Flexural strength (MPa) | - | 125 | 98 |

As shown in Table 6, the cured sheet of Example 12 exhibited high flexural strength while the cured sheet of Comparative Example 2 exhibited low flexural strength. This indicates that electronic parts comprising a cured sheet according to Example 12 will be resistant to deformation and damage during their handling.

(Example 13)

A power amplifier module was fabricated as the electronic part shown in Fig. 82, in the manner described below. In Fig. 82, structural elements identical or equivalent to those of Fig. 76 will be referred to using the same reference numerals.

First, a vinylbenzyl resin (polyvinylbenzyl ether compound (VB)) with a molecular weight of approximately 6000 represented by the following structural formula (I):

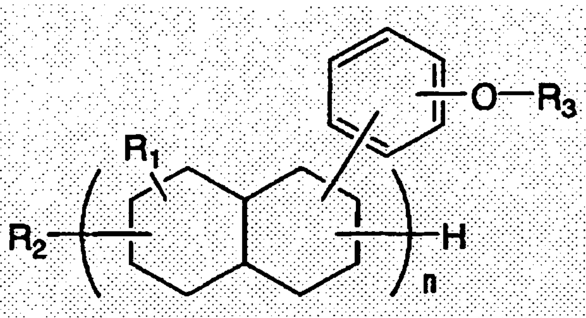

(I)

(wherein $R_1$ is methyl, $R_2$ is benzyl, $R_3$ is vinylbenzyl, and n is 3), and TOUGHTEC H1043 were placed in toluene and stirred to complete dissolution. Next, SAYTEXBT93, dicumyl peroxide, $BaNd_2Ti_4O_{12}$ (mean particle size: 0.2 μm, relative dielectric constant: 93), KBM573 and 200 g of 20 mmφ zirconia balls were added and mixed therewith for 4 hours with a ball mill.

This produced a paste (hereinafter referred to as "paste J"). The ceramic powder content of paste J was adjusted to approximately 40 vol%. Paste J was coated onto a 12 μm electrolytic copper foil (JTM, product of Nikko Materials Co., Ltd.) using a doctor blade, and dried at 120°C for 5 minutes to obtain a 50 μm-thick sheet (hereinafter referred to as sheet A). Four identical sheets A were prepared in the same manner. The dielectric constant of paste J was approximately 10, and the tanδ was approximately 0.0025. Upon measuring the flexural strength, elastic modulus and peel strength of sheet A, the flexural strength was 80 MPa, the elastic modulus was 8 GPa, and the peel strength was 4.2 N/cm with a 12 μm copper foil. The critical flexure of sheet A was also measured and found to be 3.6 mm. The flexural strength was measured by the same method described above, and the elastic modulus was measured according to JIS K6911.

Separately, a ceramic powder made of molten silica (FB-3SX by Denki Kagaku Kogyo Co., Ltd.) was composited with an epoxy resin to obtain a paste (hereinafter referred to as "paste K"). The ceramic powder content of paste K was adjusted to approximately 15 vol%. Paste K was coated onto a 12 μm electrolytic copper foil (JTM, product of Nikko Materials Co., Ltd.) using a doctor blade, and dried at 110°C for 5 minutes to obtain a 50 μm-thick sheet (hereinafter referred to as sheet B). Two identical sheets B were prepared in the same manner. The dielectric constant of paste K was approximately 3.2, and tanδ was approximately 0.011. Upon measuring the flexural strength, elastic modulus and peel strength of sheet B, the flexural strength was 140 MPa, the elastic modulus was 5 GPa, and the peel strength was 11 N/cm with a 12 μm copper foil, which was 2.2 times the peel strength of sheet A. The critical flexure of sheet B was also measured and found to be 5.7 mm, which was 2.3 times that of sheet A. The flexural strength, elastic modulus and peel strength were measured by the same methods described above.

Next, a 150 µm-thick core substrate composed of paste D and an approximately 95 µm-thick glass cloth 1131 was situated between two sheets B, and then two sheets A were situated between each of the two sheets B and the core substrate. The sheets A, the core substrate and the sheets B were stacked and pressed with a high-temperature vacuum press (Model KVHC by Kitagawa Seiki Co., Ltd.), with conditions of temperature increase at 3°C/min followed by holding at 150°C for 40 minutes, temperature increase at 4°C/min and holding at 200°C for 180 minutes, while maintaining a pressure of 4 MPa. As a result there was obtained a multilayer board 1110 comprising component layers 1110a-1110g and conductor layers 1130a-1130h.

Next, a semiconductor bare chip 1120a having a built-in amplifier circuit was mounted as an electrical element on the multilayer board 1110 by wire bonding, and then the bare chip 1120a was molded with a resin composition 1140 comprising an epoxy resin and silica. A chip capacitor 1120b was also mounted as an electrical element on the multilayer board. As a result there was obtained a power amplifier module 1100 such as shown in Fig. 82.

(Comparative Example 3)

A power amplifier module was obtained in the same manner as Example 13 except that the sheets B were replaced with the sheets A. In this power amplifier module, therefore, the critical flexures of the outermost layers were equal to those of the inner layers, and the peel strengths of the outermost layers were also equal to those of the inner layers.

(Electrical property and mechanical property tests)

The power amplifier modules of Example 13 and Comparative Example 3 obtained above were subjected to the following electrical property and mechanical property tests.

Specifically, the electrical property tests were conducted by measurement of the output level, efficiency, distortion, etc. using measuring devices such as a signal generator, power meter, spectrum analyzer and the like. The mechanical property tests were conducted by subjecting the chip capacitor 1120b as the mounted part to a lateral pressing strength test, flexure test, bonding strength test and peeling test, all according to JIS C7210.

As a result, the power amplifier modules of both Example 13 and Comparative Example 3 were found to maintain satisfactory electrical properties. However, it was found that the power amplifier module of Example 13 was more satisfactorily resistant to damage than the power amplifier module of Comparative Example 3.

Industrial Applicability

As mentioned above, according to the resin composition, a cured resin, a sheet-like cured resin, a laminated body, a prepreg, electronic parts and multilayer boards of the present invention, properties of the electronic parts can be improved adequately.

## Claims

1. A resin composition comprising a curable mixture containing an epoxy resin and an active ester compound obtained by reaction between a compound with a phenolic hydroxyl group and a compound with two or more groups which form ester bonds by reaction with said phenolic hydroxyl group,
   with a dielectric ceramic powder distributed in said curable mixture.

2. A resin composition according to claim 1, wherein said active ester compound is an aromatic active ester compound represented by the following general formula (1).

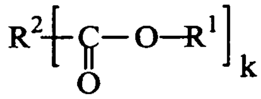

··· (1)

[wherein k represents an integer of 2-4,

$R^1$ represents naphthyl optionally having at least one substituent selected from the group consisting of halogen atoms and alkyl groups, or

phenyl optionally having at least one substituent selected from the group consisting of halogen atoms, alkyl groups

and phenyl groups (where the phenyl groups may be optionally substituted with halogen atoms and/or alkyl groups), and

$R^2$ represents a divalent to tetravalent group containing 1 to 3 aromatic rings (where the aromatic rings may be optionally substituted with halogen atoms and/or alkyl groups),

with the proviso that when $R^2$ contains more than one aromatic ring, the aromatic rings either form fused rings or are bonded by at least one bond selected from the group consisting of ether bonds, thioether bonds, sulfone bonds, carbonyl bonds and single bonds.]

**3.** A resin composition according to claim 1 or 2, wherein said dielectric ceramic powder is a metal oxide powder comprising at least one metal selected from the group consisting of magnesium, silicon, aluminum, titanium, zinc, calcium, strontium, zirconium, barium, tin, neodymium, bismuth, lithium, samarium and tantalum, and it is metal oxide powder having a dielectric constant of 3.7-300 and a Q value of 500-100,000.

**4.** A resin composition according to one of claims 1 to 3, wherein the content of said dielectric ceramic powder is 5-185 parts by volume with respect to 100 parts by volume as the total of said epoxy resin and said active ester compound.

**5.** A resin composition according to one of claims 1 to 4, which further comprises a polyarylate.

**6.** A resin composition according to claim 5, wherein said polyarylate comprises a plurality of repeating units represented by -X-Y composed of structural unit X and structural unit Y (The plurality of each of the structural units X and structural units Y may be the same or different.),

wherein said structural unit X is a phthaloyl group, isophthaloyl group or terephthaloyl group represented by the following formula (2) (wherein the number of moles of terephthaloyl groups constitutes less than 40 mole percent of the total moles of the phthaloyl, isophthaloyl and terephthaloyl groups),

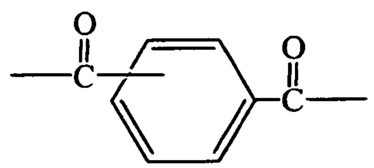

··· (2)

and said structural unit Y is a divalent group represented by the following general formula (3).

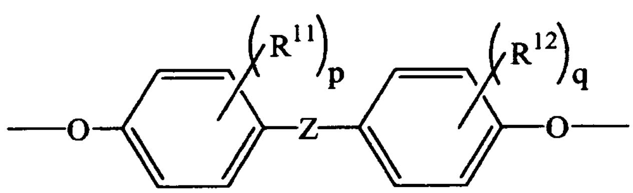

··· (3)

[wherein $R^{11}$ and $R^{12}$ each independently represent C1-4 alkyl, alkoxy or a halogen, Z represents a single bond, ether bond, thioether bond, sulfone bond or carbonyl bond, and p and q each independently represent an integer of 0-4, with the proviso that when more than one $R^{11}$, $R^{12}$ and Z are present in the polyarylate, $R^{11}$, $R^{12}$ and Z may be the same or different.]

**7.** A resin composition according to claim 6, wherein $R^{11}$ and $R^{12}$ are both methyl and Z is a single bond.

**8.** A resin composition according to one of claims 5 to 7, wherein the content of said dielectric ceramic powder is 5-185 parts by volume with respect to 100 parts by volume as the total of said epoxy resin, said active ester compound and said polyarylate.

**9.** A resin composition according to one of claims 1 to 8, which further comprises one or more additives selected

from the group consisting of coupling agents, curing accelerators, flame retardants, flexibilizers and organic solvents.

**10.** A resin composition according to claim 9, wherein at least a portion of the coupling agent is bonded or adsorbed onto the surface of the dielectric ceramic powder.

**11.** A cured resin obtained by partially completing the curing reaction between said epoxy resin and said active ester compound in a resin composition according to one of claims 1 to 10.

**12.** A cured resin obtained by fully completing the curing reaction between said epoxy resin and said active ester compound in a resin composition according to one of claims 1 to 10.

**13.** A sheet-like cured resin comprising a cured resin according to claim 11 shaped into the form of a sheet.

**14.** A sheet-like cured resin according to claim 13, which has a thickness of 5-200 μm.

**15.** A sheet-like cured resin comprising a cured resin according to claim 12 shaped into the form of a sheet.

**16.** A sheet-like cured resin according to claim 15, which has a thickness of 5-1000 μm.

**17.** A laminated body comprising a sheet-like cured resin according to claim 13 or 14 and a metal foil bonded on one or both sides of said sheet-like cured resin.

**18.** A laminated body comprising a sheet-like cured resin according to claim 15 or 16 and a metal foil bonded on one or both sides of said sheet-like cured resin.

**19.** A prepreg obtained by semi-curing of a resin composition comprising a curable mixture containing an epoxy resin and an active ester compound obtained by reaction between a compound with a phenolic hydroxyl group and a compound with two or more groups which form ester bonds by reaction with said phenolic hydroxyl group,

with a dielectric ceramic powder and reinforcing fibers distributed in said curable mixture.

**20.** A prepreg comprising a reinforcing fiber fabric consisting of woven reinforcing fibers, and a resin layer formed on both sides of said reinforcing fiber fabric,

wherein said resin layer is a resin layer obtained by semi-curing of a resin composition comprising a curable mixture containing an epoxy resin and an active ester compound obtained by reaction between a compound with a phenolic hydroxyl group and a compound with two or more groups which form ester bonds by reaction with said phenolic hydroxyl group,

with a dielectric ceramic powder distributed in said curable mixture.

**21.** A prepreg according to claim 20, wherein said resin layer has a thickness of 5-100 μm.

**22.** A prepreg according to claim 20 or 21, wherein said reinforcing fiber fabric has a thickness of 20-300 μm.

**23.** A prepreg according to one of claims 19 to 22, wherein said active ester compound is an aromatic active ester compound represented by the following general formula (1).

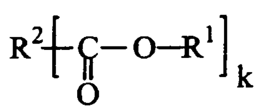 ··· (1)

[wherein k represents an integer of 2-4,

$R^1$ represents naphthyl optionally having at least one substituent selected from the group consisting of halogen atoms and alkyl groups, or
phenyl optionally having at least one substituent selected from the group consisting of halogen atoms, alkyl groups and phenyl groups (where the phenyl groups may be optionally substituted with halogen atoms and/or alkyl groups),

and

$R^2$ represents a divalent to tetravalent group containing 1 to 3 aromatic rings (where the aromatic rings may be optionally substituted with halogen atoms and/or alkyl groups),

with the proviso that when $R^2$ contains more than one aromatic ring, the aromatic rings either form fused rings or are bonded by at least one bond selected from the group consisting of ether bonds, thioether bonds, sulfone bonds, carbonyl bonds and single bonds.]

**24.** A prepreg according to one of claims 19 to 23, wherein said dielectric ceramic powder is a metal oxide powder comprising at least one metal selected from the group consisting of magnesium, silicon, aluminum, titanium, zinc, calcium, strontium, zirconium, barium, tin, neodymium, bismuth, lithium, samarium and tantalum, and it is metal oxide powder having a dielectric constant of 3.7-300 and a Q value of 500-100,000.

**25.** A prepreg according to one of claims 19 to 24, wherein the content of said dielectric ceramic powder is 5-100 parts by volume with respect to 100 parts by volume as the total of said epoxy resin and said active ester compound.

**26.** A prepreg according to one of claims 19 to 25, wherein said resin composition further comprises a polyarylate.

**27.** A prepreg according to claim 26, wherein said polyarylate comprises a plurality of repeating units represented by -X-Y composed of structural unit X and structural unit Y (The plurality of each of the structural units X and structural units Y may be the same or different.),

wherein said structural unit X is a phthaloyl group, isophthaloyl group or terephthaloyl group represented by the following formula (2) (wherein the number of moles of terephthaloyl groups constitutes less than 40 mole percent of the total moles of the phthaloyl, isophthaloyl and terephthaloyl groups),

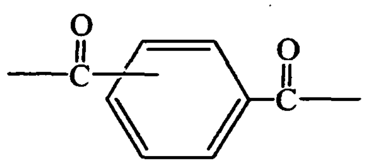

··· (2)

and said structural unit Y is a divalent group represented by the following general formula (3).

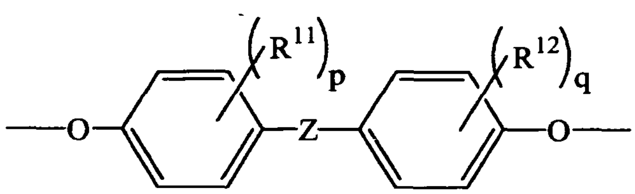

··· (3)

[wherein $R^{11}$ and $R^{12}$ each independently represent C1-4 alkyl, alkoxy or a halogen, Z represents a single bond, ether bond, thioether bond, sulfone bond or carbonyl bond, and p and q each independently represent an integer of 0-4, with the proviso that when more than one $R^{11}$, $R^{12}$ and Z are present in the polyarylate, $R^{11}$, $R^{12}$ and Z may be the same or different.]

**28.** A prepreg according to claim 27, wherein $R^{11}$ and $R^{12}$ are both methyl and Z is a single bond.

**29.** A prepreg according to one of claims 26 to 28, wherein the content of said dielectric ceramic powder is 5-100 parts by volume with respect to 100 parts by volume as the total of said epoxy resin, said active ester compound and said polyarylate.

**30.** A prepreg according to one of claims 19 to 29, wherein said resin composition further comprises one or more additives selected from the group consisting of coupling agents, curing accelerators, flame retardants and flexibilizers.

**31.** A prepreg according to claim 30, wherein at least a portion of said coupling agent is bonded or adsorbed onto the

surface of said dielectric ceramic powder.

**32.** A prepreg according to one of claims 19 to 31, wherein said reinforcing fibers are at least one type of reinforcing fibers selected from the group consisting of E glass fibers, D glass fibers, NE glass fibers, H glass fibers, T glass fibers and aramid fibers.

**33.** A sheet-like cured resin comprising a cured prepreg according to one of claims 19 to 32 shaped into the form of a sheet.

**34.** A sheet-like cured resin according to claim 33, which has a thickness of 30-10,000 μm.

**35.** A laminated body comprising a sheet-like cured resin according to claim 33 or 34 and a metal foil bonded on one or both sides of said sheet-like cured resin.

**36.** An electronic part provided with at least one composite dielectric layer containing an organic insulating material and a dielectric ceramic powder having a larger relative dielectric constant than said organic insulating material,

and at least one conductive element section formed on said composite dielectric layer and constituting a capacitor element or inductor element,

wherein said organic insulating material comprises a cured resin obtained by curing reaction between an epoxy resin and an active ester compound which is itself obtained by reaction between a compound having two or more carboxyl groups and a compound having a phenolic hydroxyl group.

**37.** An electronic part according to claim 36, wherein said active ester compound is an aromatic active ester compound represented by the following general formula (1).

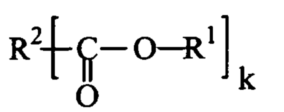

··· (1)

[wherein k represents an integer of 2-4,

$R^1$ represents naphthyl optionally having at least one substituent selected from the group consisting of halogen atoms and alkyl groups, or

phenyl optionally having at least one substituent selected from the group consisting of halogen atoms, alkyl groups and phenyl groups (where the phenyl groups may be optionally substituted with halogen atoms and/or alkyl groups), and

$R^2$ represents a divalent to tetravalent group containing 1 to 3 aromatic rings (where the aromatic rings may be optionally substituted with halogen atoms and/or alkyl groups),

with the proviso that when $R^2$ contains more than one aromatic ring, the aromatic rings either form fused rings or are bonded by at least one bond selected from the group consisting of ether bonds, thioether bonds, sulfone bonds, carbonyl bonds and single bonds.]

**38.** An electronic part according to claim 36 or 37, wherein said dielectric ceramic powder is a metal oxide powder comprising at least one metal selected from the group consisting of magnesium, silicon, aluminum, titanium, zinc, calcium, strontium, zirconium, barium, tin, neodymium, bismuth, lithium, samarium and tantalum, and it is metal oxide powder having a dielectric constant of 3.7-300 and a Q value of 500-100,000.

**39.** An electronic part according to one of claim 36 or 38, wherein said organic insulating material further comprises a polyarylate.

**40.** An electronic part according to claim 39, wherein said polyarylate comprises a plurality of repeating units represented by -X-Y composed of structural unit X and structural unit Y (The plurality of each of the structural units X and structural units Y may be the same or different),

wherein said structural unit X is a phthaloyl group, isophthaloyl group or terephthaloyl group represented by the following formula (2) (wherein the number of moles of terephthaloyl groups constitutes less than 40 mole percent of the total moles of the phthaloyl, isophthaloyl and terephthaloyl groups),

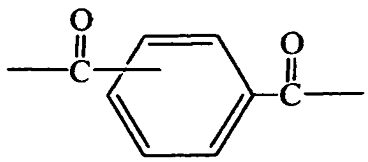

··· (2)

and said structural unit Y is a divalent group represented by the following general formula (3).

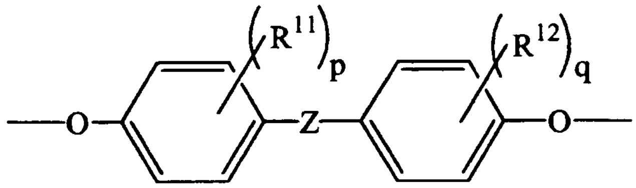

··· (3)

[wherein $R^{11}$ and $R^{12}$ each independently represent C1-4 alkyl, alkoxy or a halogen, Z represents a single bond, ether bond, thioether bond, sulfone bond or carbonyl bond, and p and q each independently represent an integer of 0-4, with the proviso that when more than one $R^{11}$, $R^{12}$ and Z are present in the polyarylate, $R^{11}$, $R^{12}$ and Z may be the same or different.]

**41.** An electronic part according to claim 40, wherein $R^{11}$ and $R^{12}$ are both methyl and Z is a single bond.

**42.** An electronic part according to one of claims 36 to 41, wherein said dielectric ceramic powder is added at 5-185 parts by volume with respect to 100 parts by volume of said organic insulating material.

**43.** An electronic part according to one of claims 36 to 42, wherein said cured resin is obtained by curing reaction between said epoxy resin and said active ester compound in the presence of an additive, and said additive is at least one additive selected from the group consisting of curing accelerators, surface treatment agents, flame retardants and flexibilizers.

**44.** An electronic part according to one of claims 36 to 43, wherein said composite dielectric layer further comprises a magnetic powder dispersed in said organic insulating material.

**45.** An electronic part according to one of claims 36 to 44, wherein said composite dielectric layer further comprises a cloth made of reinforcing fibers.

**46.** A multilayer board constructed by laminating
at least one resin-containing first dielectric layer,
at least one resin-containing second dielectric layer
and at least one conductor layer,
wherein the dielectric loss tangent tanδ of said second dielectric layer is no greater than 0.01,
and the critical flexure of said first dielectric layer is at least 1.3 times that of said second dielectric layer.

**47.** A multilayer board according to claim 46, wherein said second dielectric layer further comprises a ceramic powder having a larger relative dielectric constant than said resin.

**48.** A multilayer board according to claim 46 or 47, having two outermost layers, with at least one of said two outermost layers being composed of said first dielectric layer and at least one of said second dielectric layers being situated between said two outermost layers.

**49.** A multilayer board according to one of claims 46 to 48, wherein the peel strength of said first dielectric layer is at least 1.5 times the peel strength of said second dielectric layer.

**50.** A multilayer board constructed by laminating two resin-containing first dielectric layers,

at least one resin-containing second dielectric layer situated between said two first dielectric layers,
and at least one conductor layer,
wherein at least one of said two first dielectric layers constitutes the outermost layer,
the dielectric loss tangent tanδ of said second dielectric layer is no greater than 0.01,
and the peel strengths of said first dielectric layers are at least 1.5 times the peel strength of said second dielectric layer.

**51.** A multilayer board according to claim 49 or 50, wherein the peel strengths of said first dielectric layers are at least 8 N/cm.

**52.** An electronic part constructed by laminating at least one resin-containing first dielectric layer,
at least one resin-containing second dielectric layer,
and at least one conductor layer,
wherein the dielectric loss tangent tanδ of said second dielectric layer is no greater than 0.01,
and the critical flexure of said first dielectric layer is at least 1.3 times that of said second dielectric layer.

**53.** An electronic part according to claim 52, wherein said second dielectric layer further comprises a ceramic powder having a larger relative dielectric constant than said resin.

**54.** An electronic part according to claim 52 or 53, having two outermost layers, with at least one of said two outermost layers being composed of said first dielectric layer and at least one of said second dielectric layers being situated between said two outermost layers.

**55.** An electronic part according to one of claims 52 to 54, wherein the peel strength of said first dielectric layer is at least 1.5 times the peel strength of said second dielectric layer.

**56.** An electronic part constructed by laminating two resin-containing first dielectric layers,
at least one resin-containing second dielectric layer situated between said two first dielectric layers,
and at least one conductor layer,
wherein at least one of said two first dielectric layers constitutes the outermost layer,
the dielectric loss tangent tanδ of said second dielectric layer is no greater than 0.01,
and the peel strengths of said first dielectric layers are at least 1.5 times the peel strength of said second dielectric layer.

**57.** An electronic part according to claim 55 or 56, wherein the peel strengths of said first dielectric layers are at least 8 N/cm.

**58.** An electronic part comprising
a multilayer board according to one of claims 46 to 51,
and an electrical element formed on said multilayer board.

Fig.1A

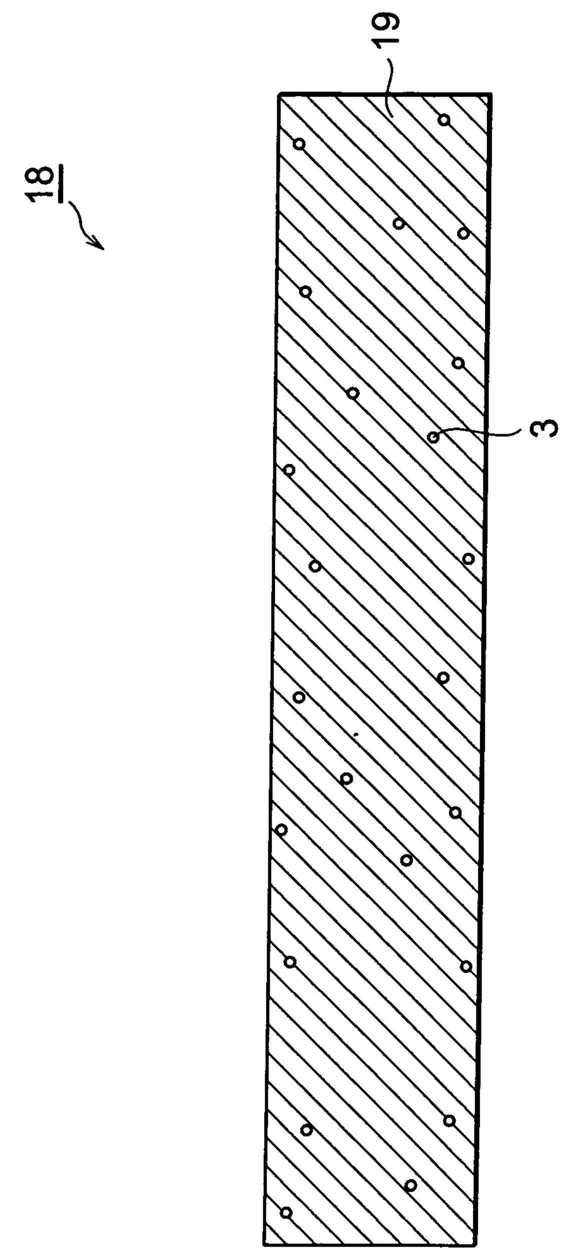

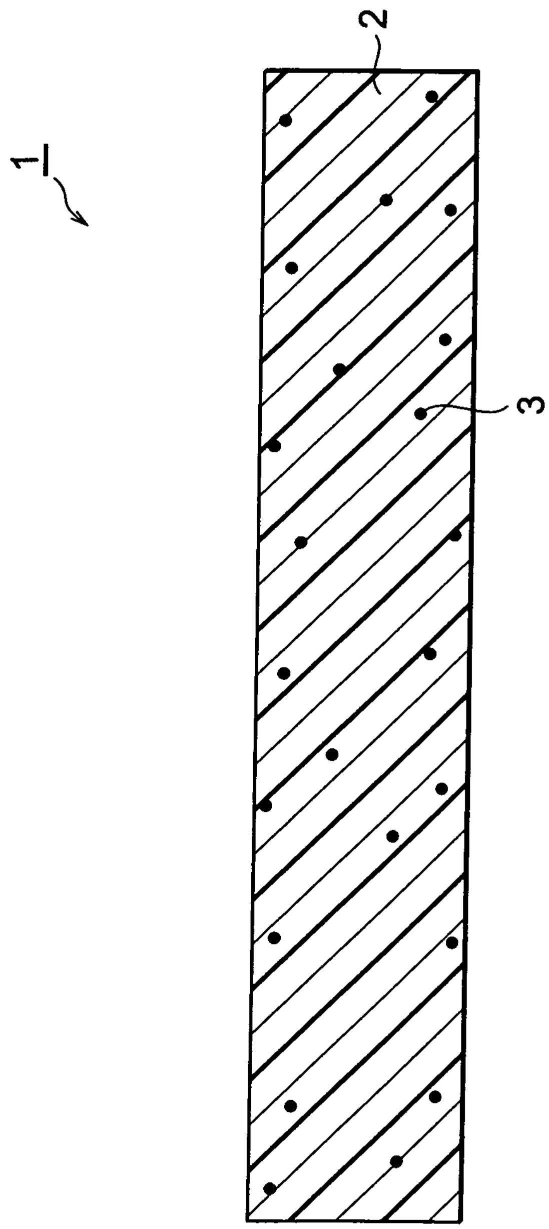


Fig.1B

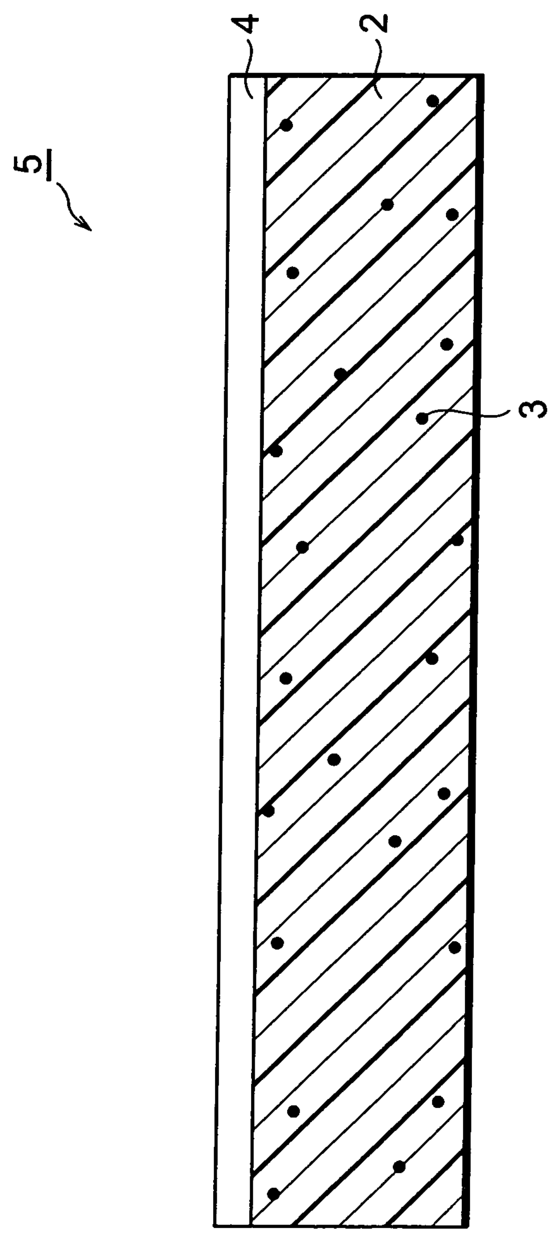


Fig.1C

Fig.1D

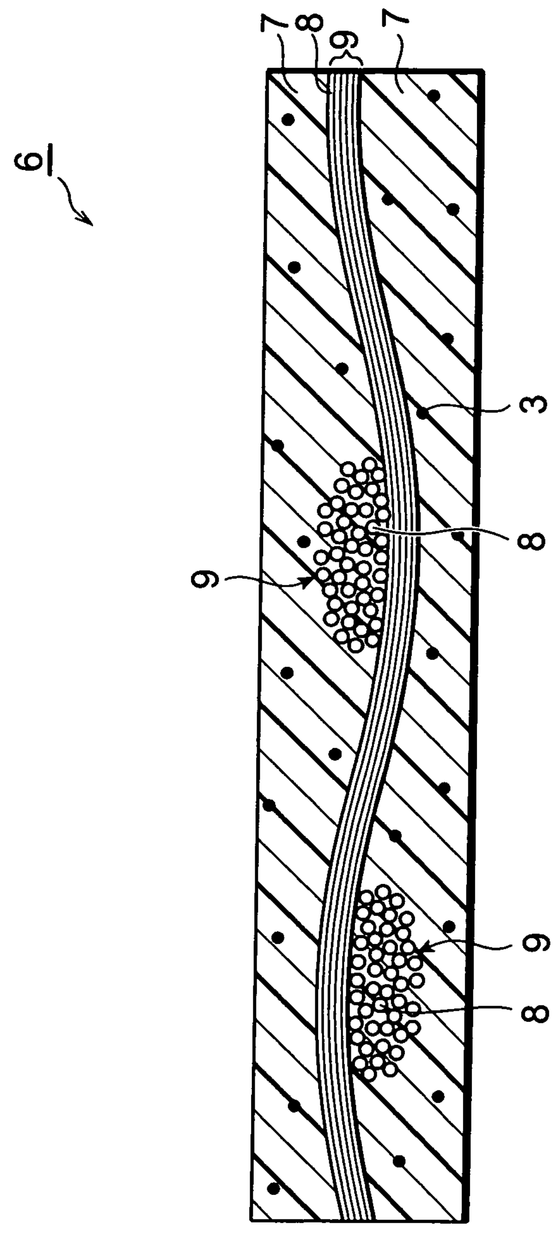

*Fig.1E*

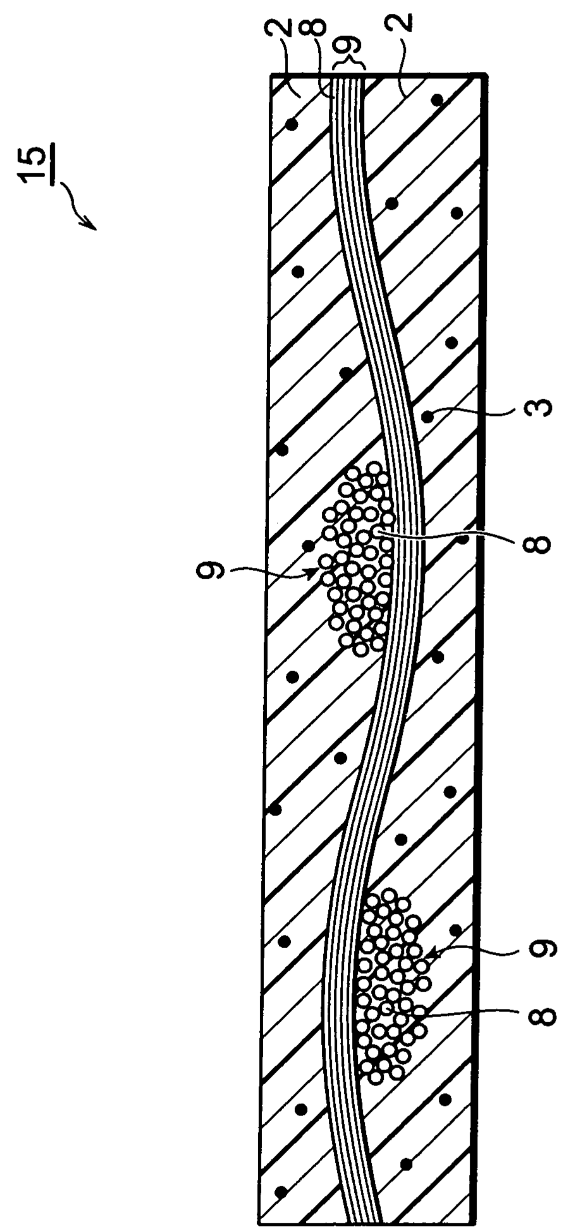

Fig.1F

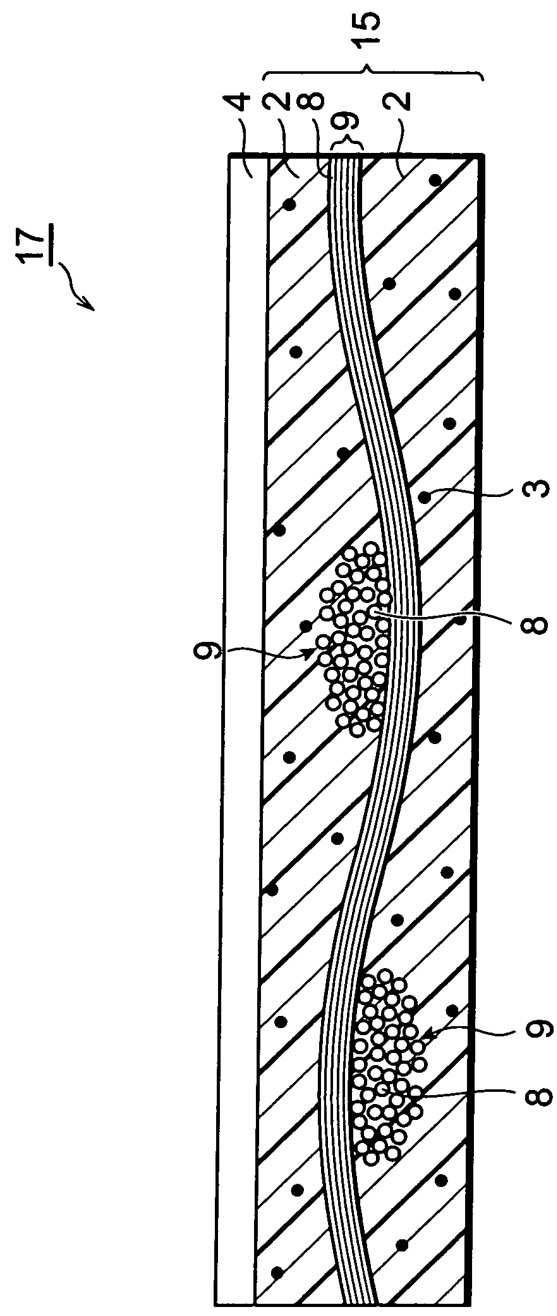

## Fig.1G

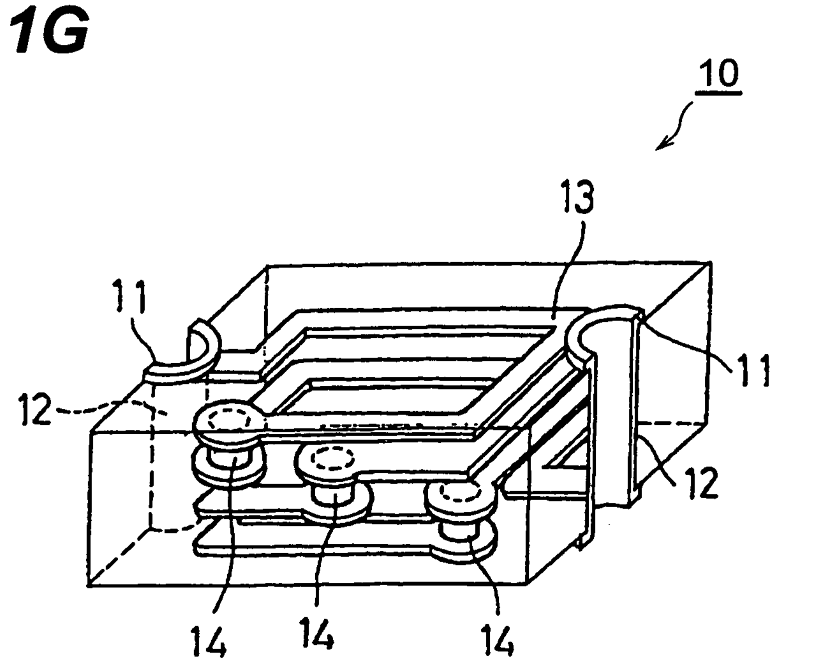
10
13
11
11
12
12
14
14
14

## Fig.2

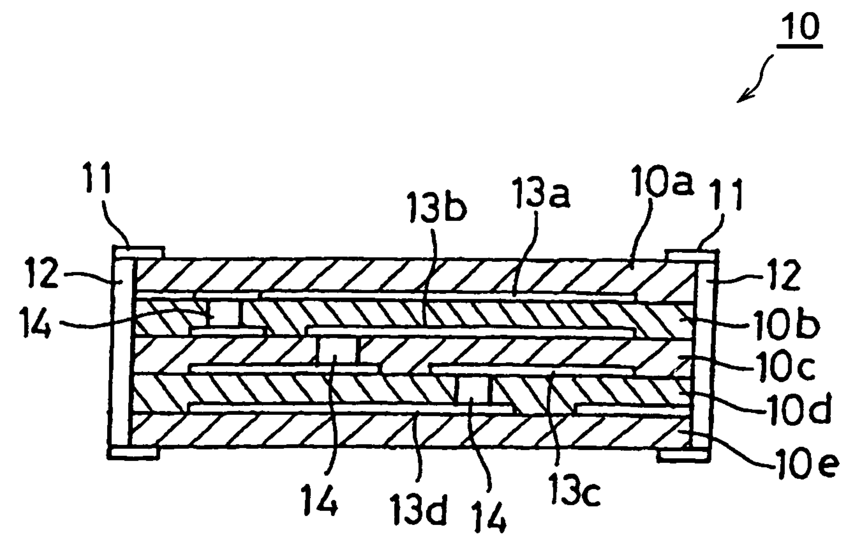
10
11
13b
13a
10a
11
12
12
14
10b
10c
10d
10e
14
13d
14
13c

Fig.3

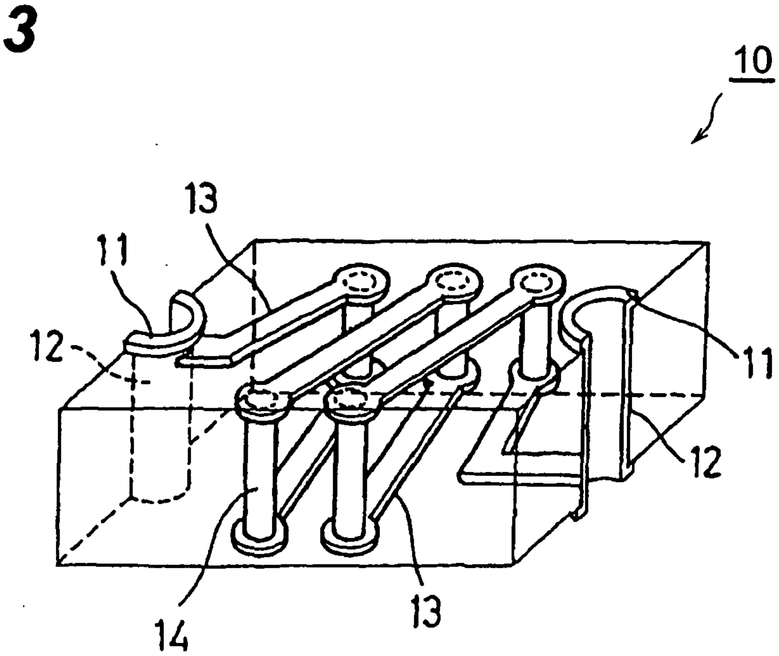


Fig.4

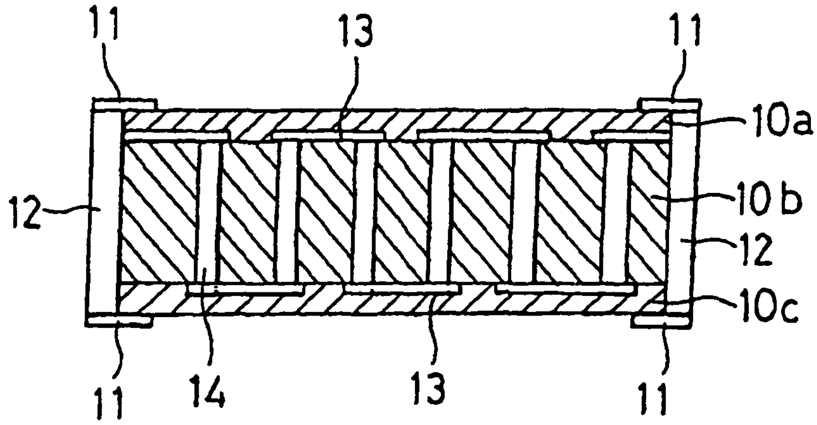

**Fig.5**

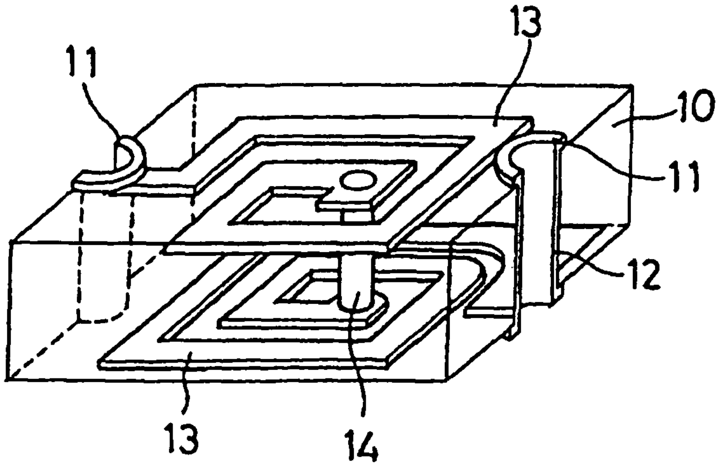


**Fig.6**

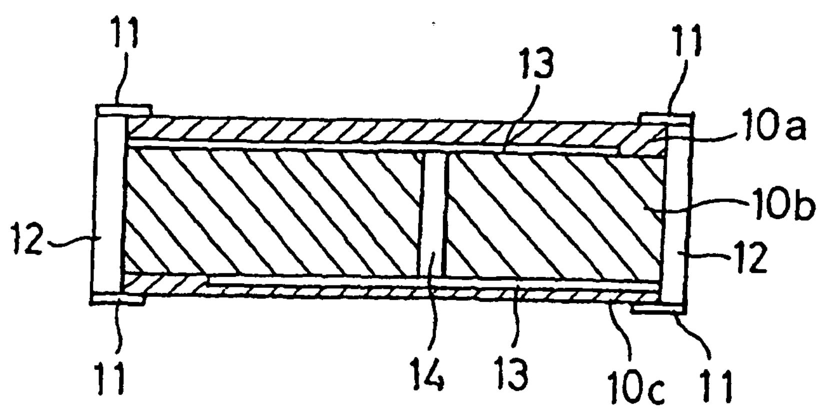

Fig.7

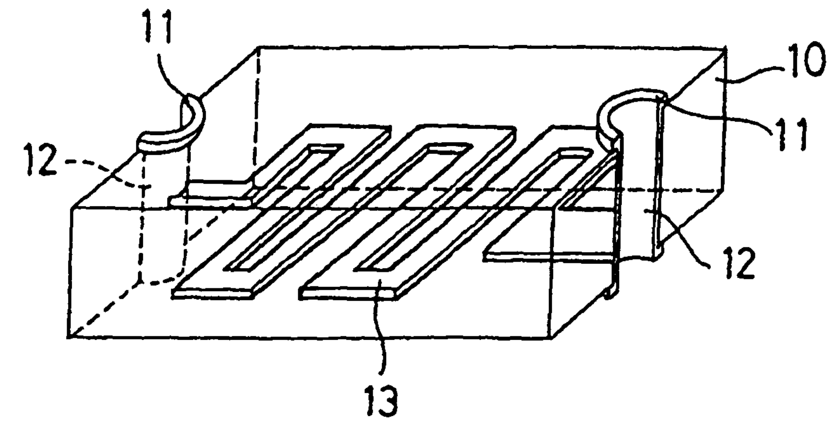


Fig.8

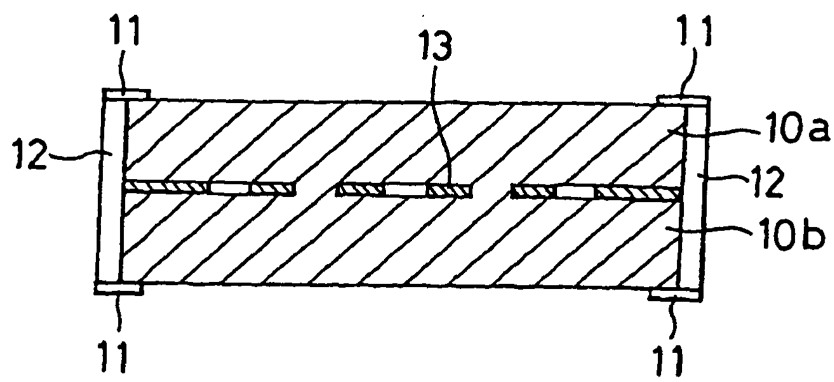

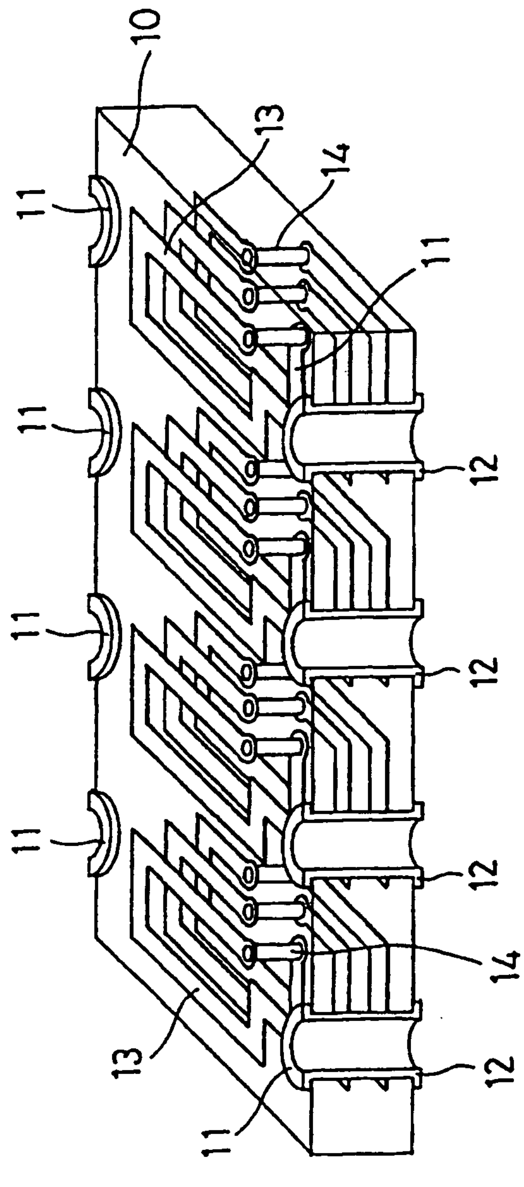


Fig.9

Fig.10A

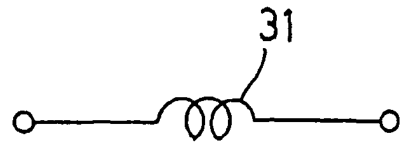


Fig.10B

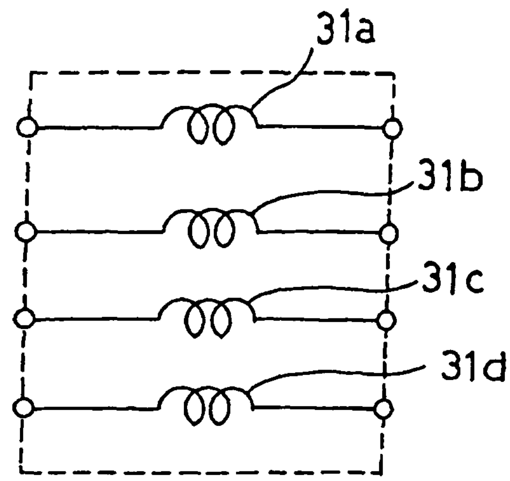


Fig.11

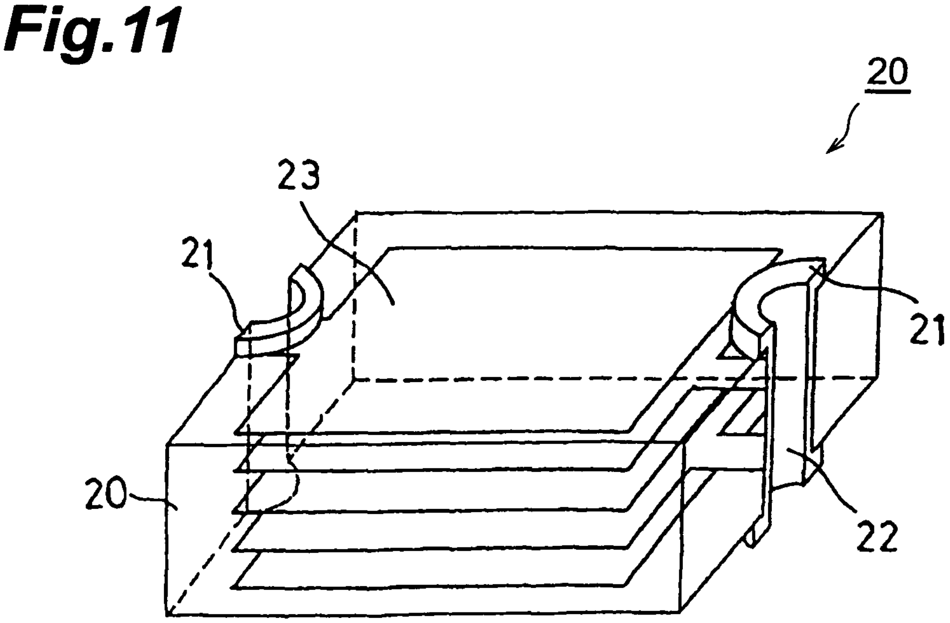

# Fig.12

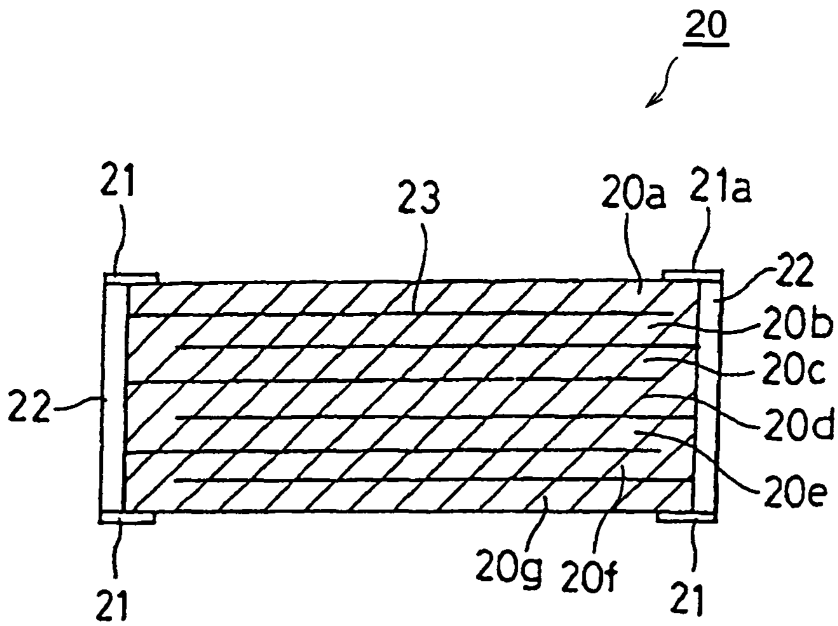

*Fig.13*

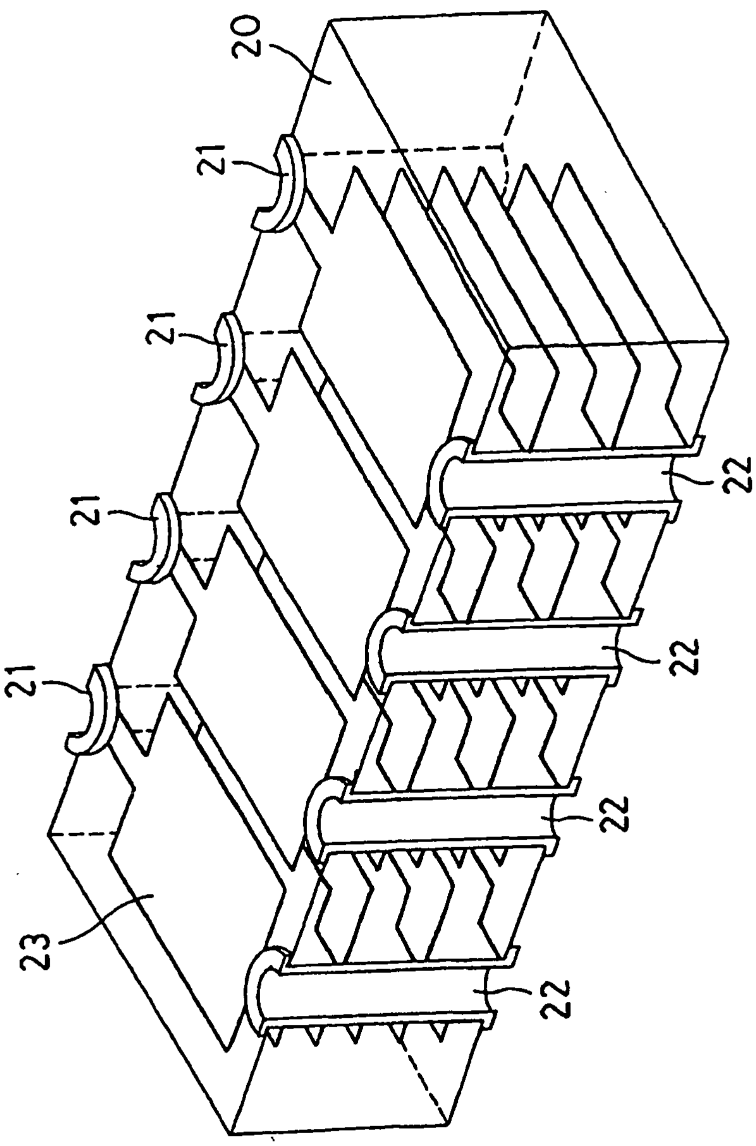

**Fig.14A**

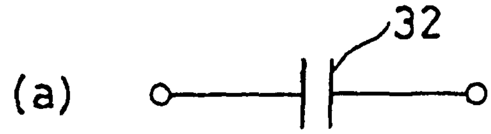


**Fig.14B**

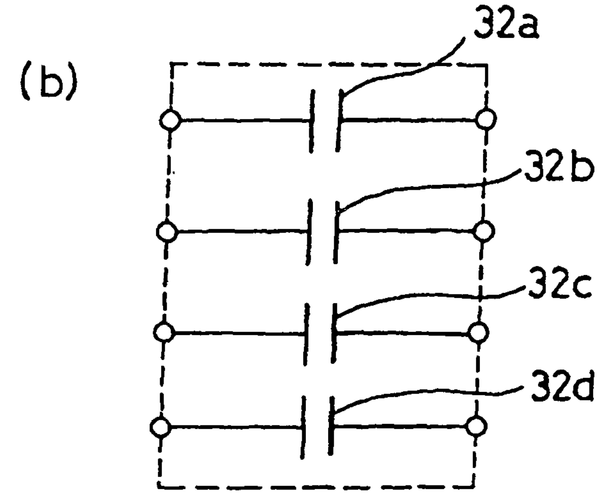


**Fig.15**

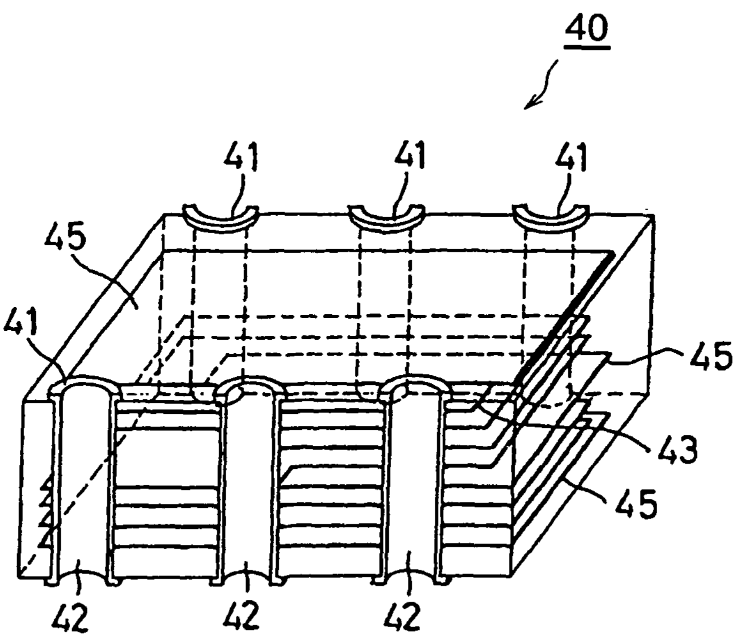

Fig.16

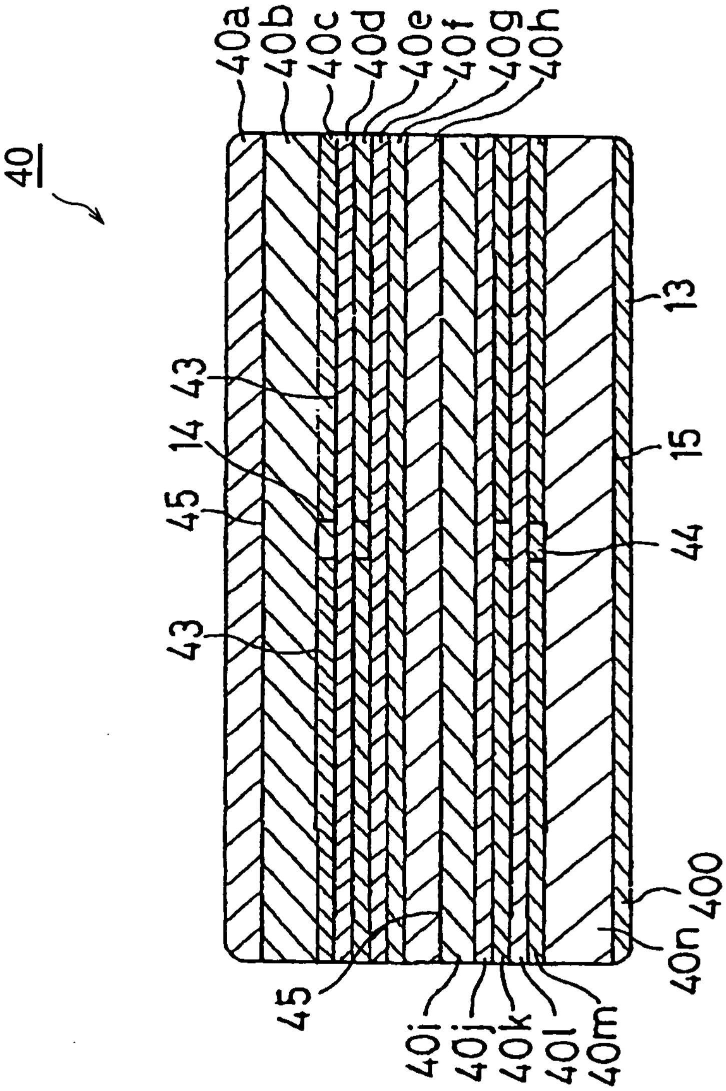
40
40a
40b
40c
40d
40e
40f
40g
40h
43
14
45
43
13
15
44
45
40i
40j
40k
40l
40m
40n
400

Fig.17

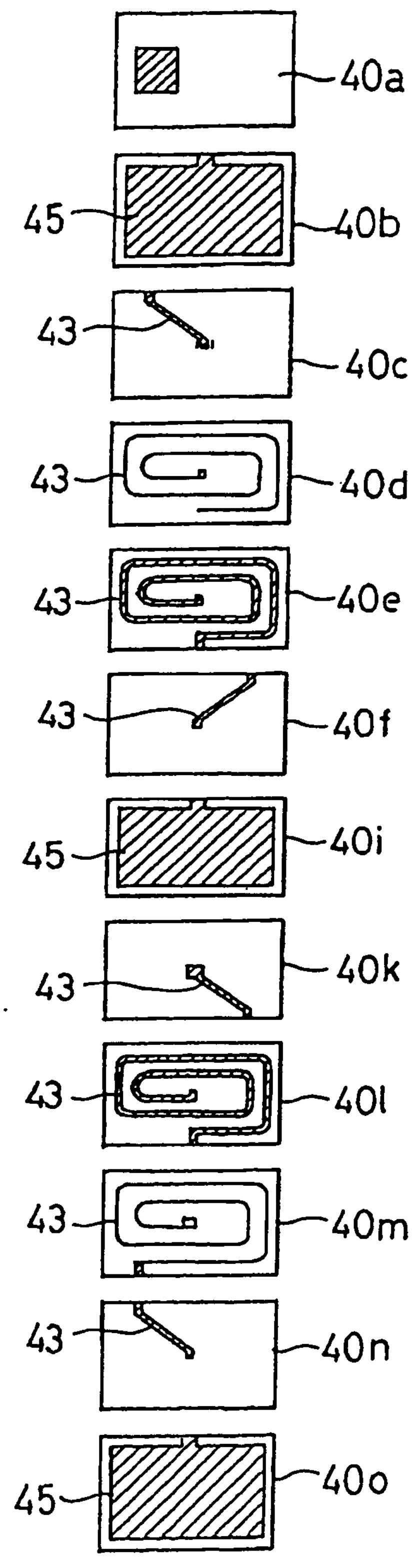
40a
45
40b
43
40c
43
40d
43
40e
43
40f
45
40i
43
40k
43
40l
43
40m
43
40n
45
40o

***Fig.18***

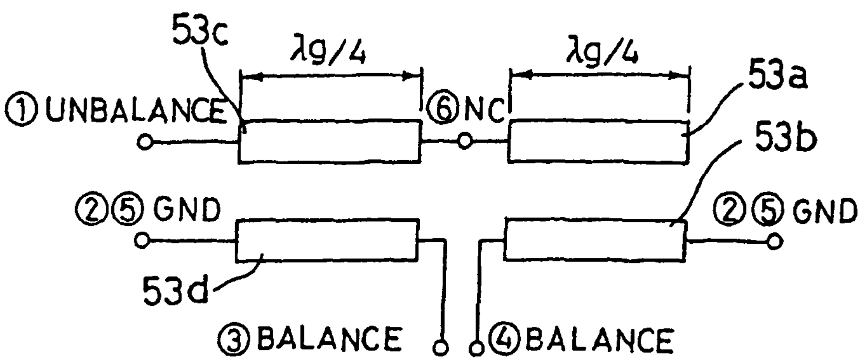
53c
λg/4
λg/4
53a
① UNBALANCE
⑥ NC
53b
②⑤ GND
②⑤ GND
53d
③ BALANCE
④ BALANCE

***Fig.19***

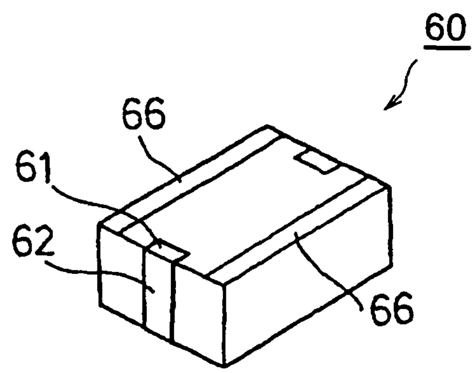
60
66
61
62
66

Fig.20

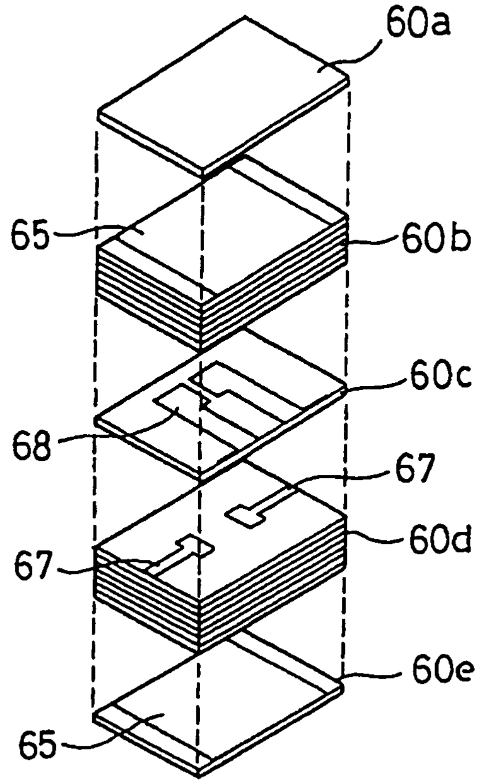


Fig.21

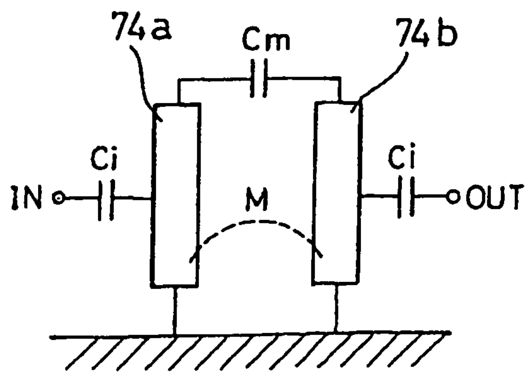

*Fig.22*

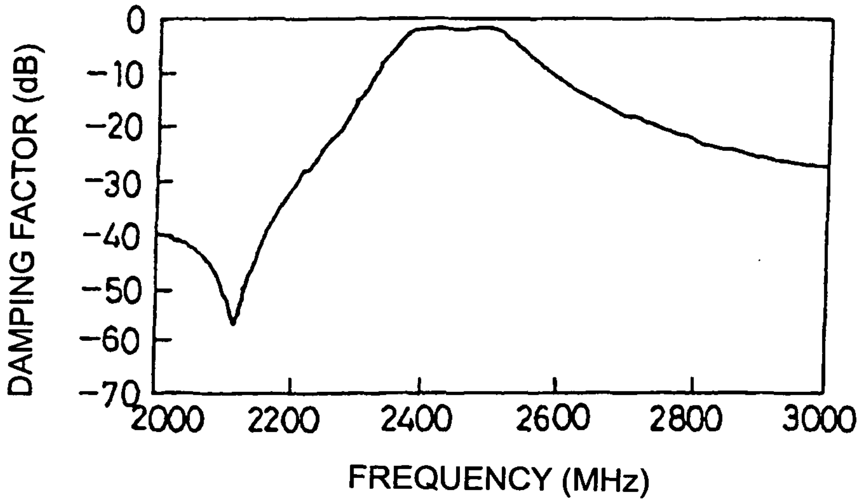
0
−10
−20
−30
−40
−50
−60
−70
DAMPING FACTOR (dB)
2000
2200
2400
2600
2800
3000
FREQUENCY (MHz)

*Fig.23*

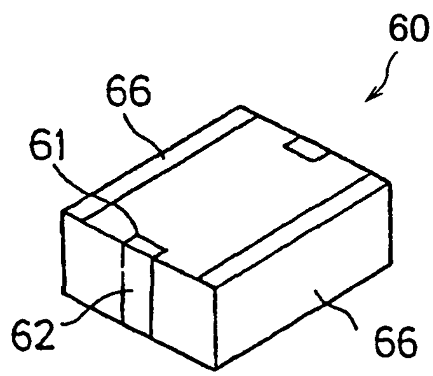
60
66
61
62
66

Fig.24

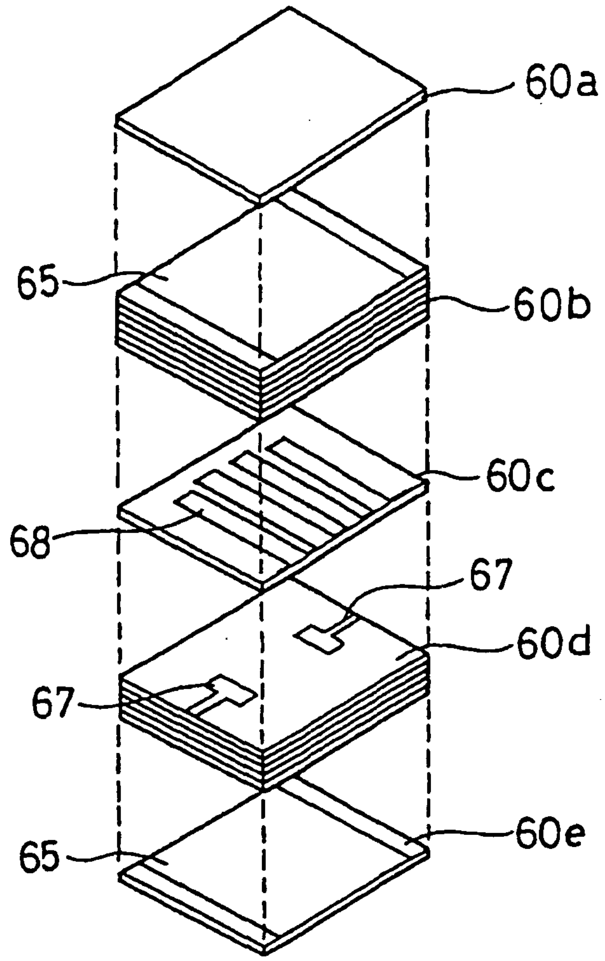
60a
65
60b
60c
68
67
60d
67
65
60e

Fig.25

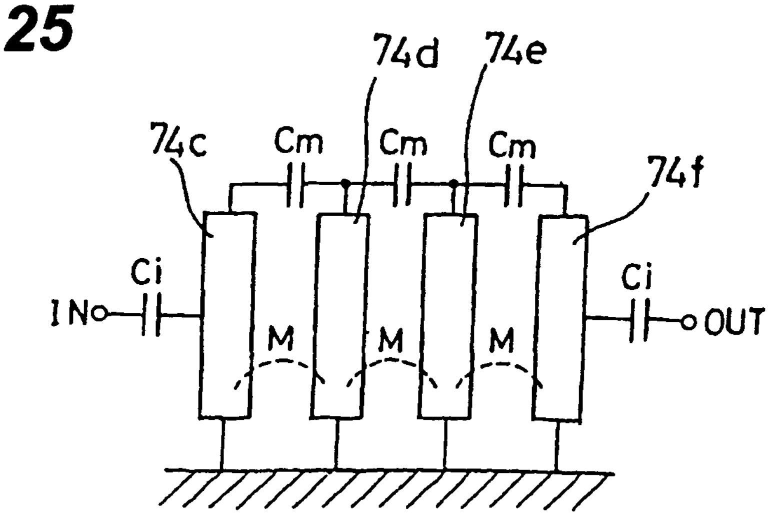
74d
74e
74c
Cm
Cm
Cm
74f
Ci
IN
Ci
OUT
M
M
M

*Fig.26*

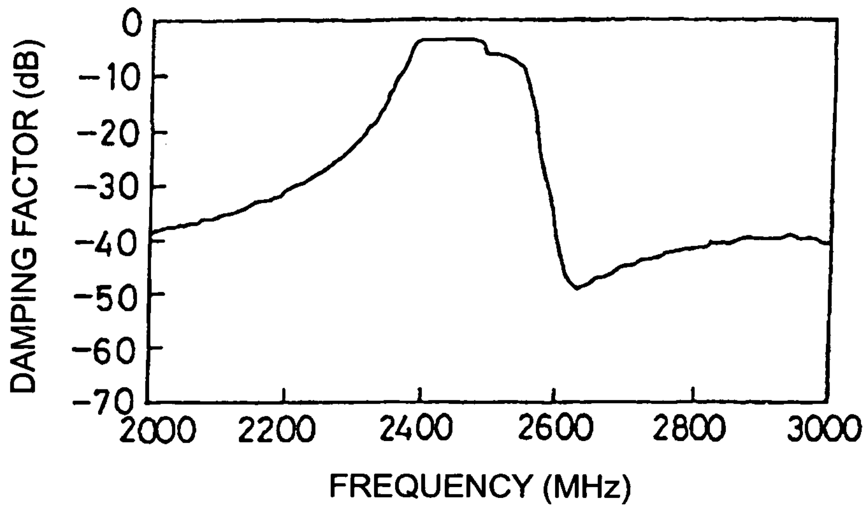
DAMPING FACTOR (dB)
0
−10
−20
−30
−40
−50
−60
−70
2000
2200
2400
2600
2800
3000
FREQUENCY (MHz)

*Fig.27*

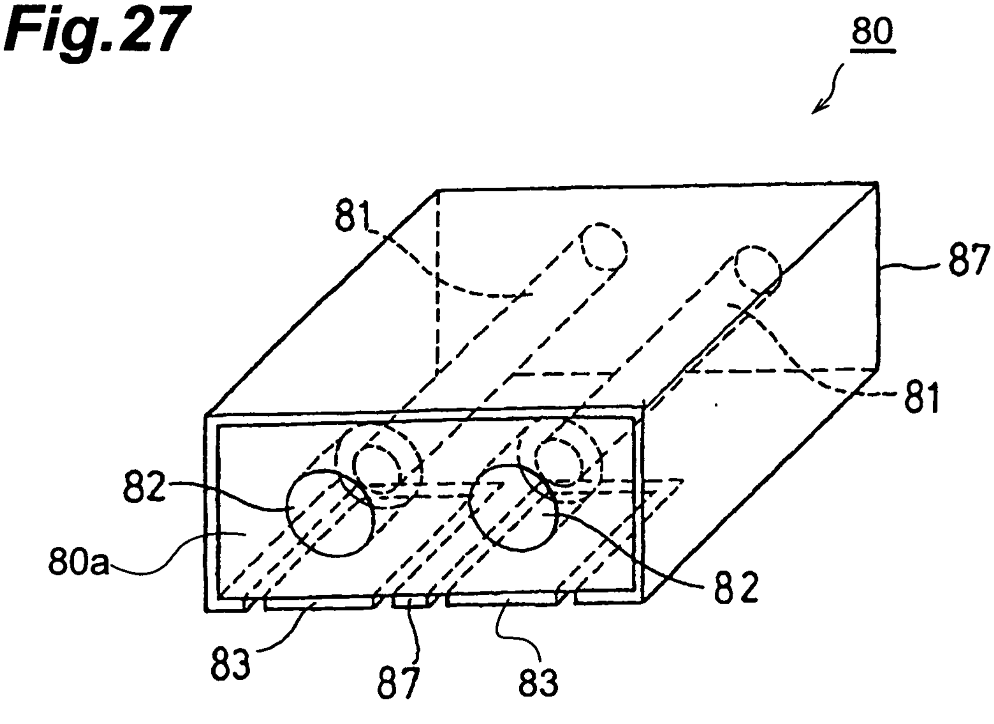
80
81
87
81
82
80a
82
83
87
83

Fig.28

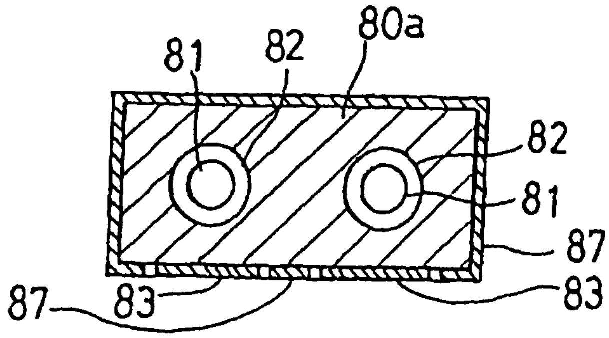


Fig.29

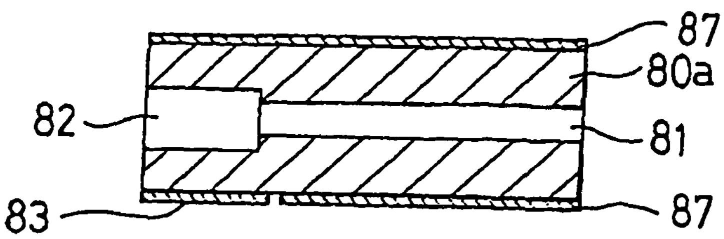


Fig.30

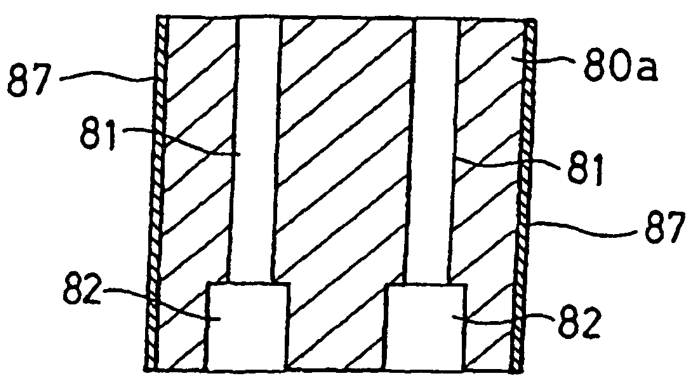

*Fig.31*

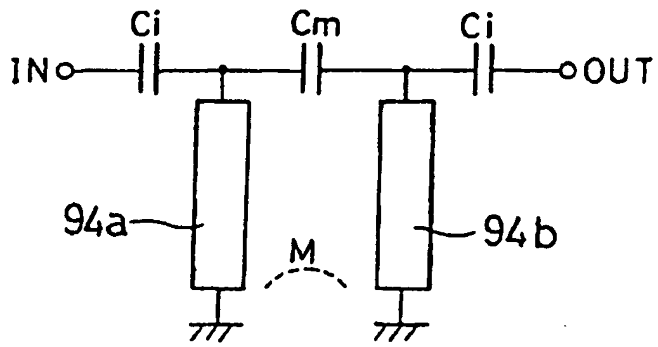


*Fig.32*

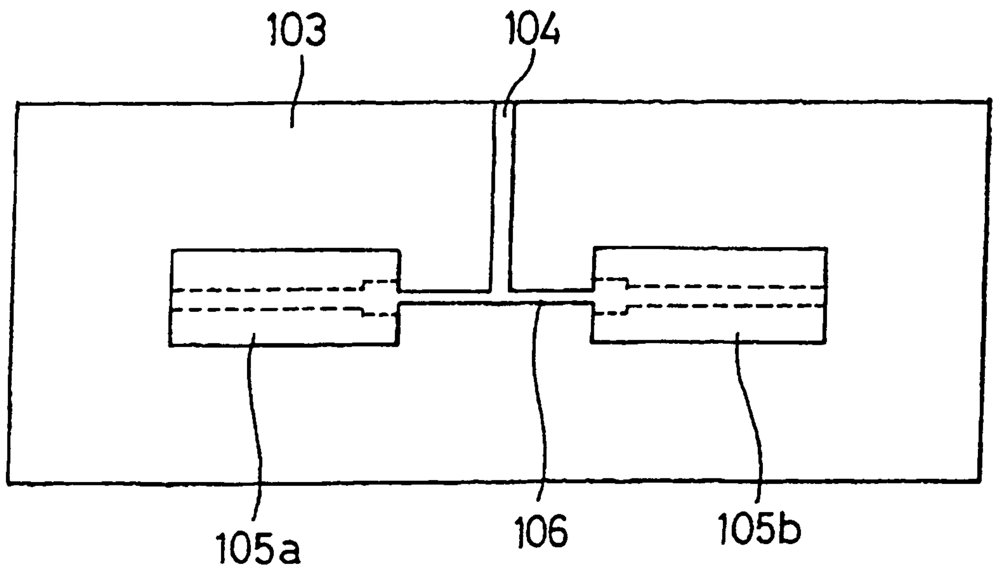

Fig.33

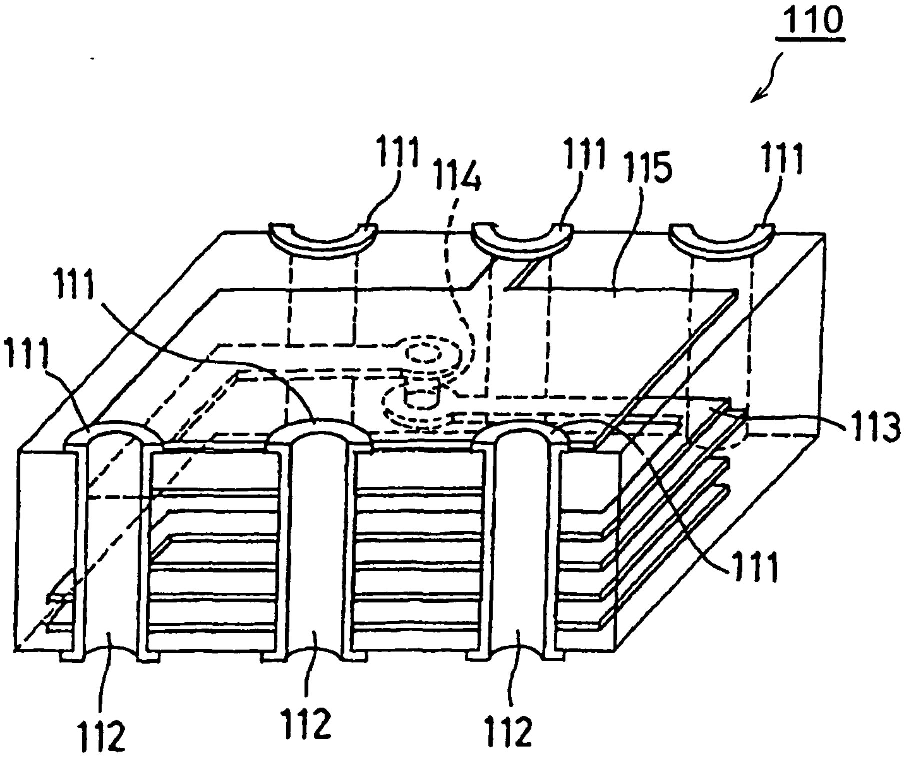
110
111
114
111
115
111
111
111
113
111
112
112
112

Fig.34

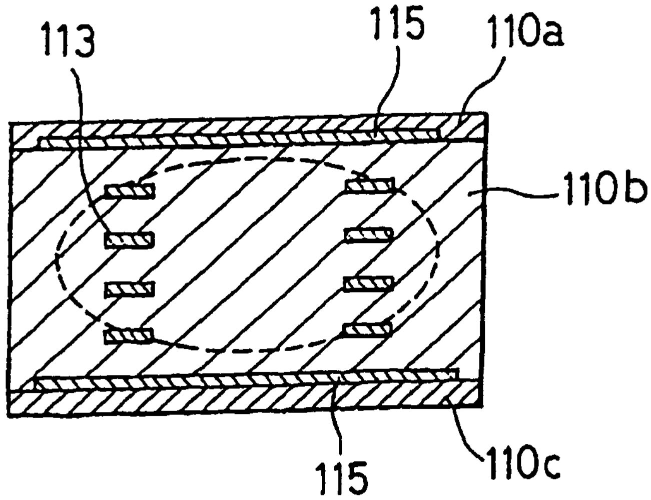
113
115
110a
110b
115
110c

*Fig.35*

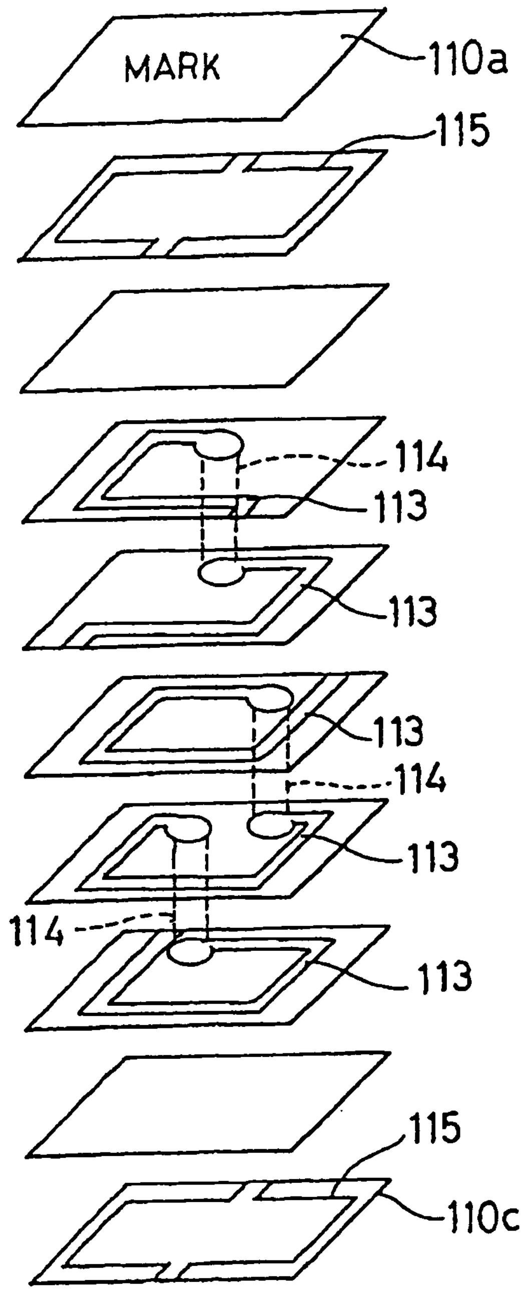

*Fig.36*

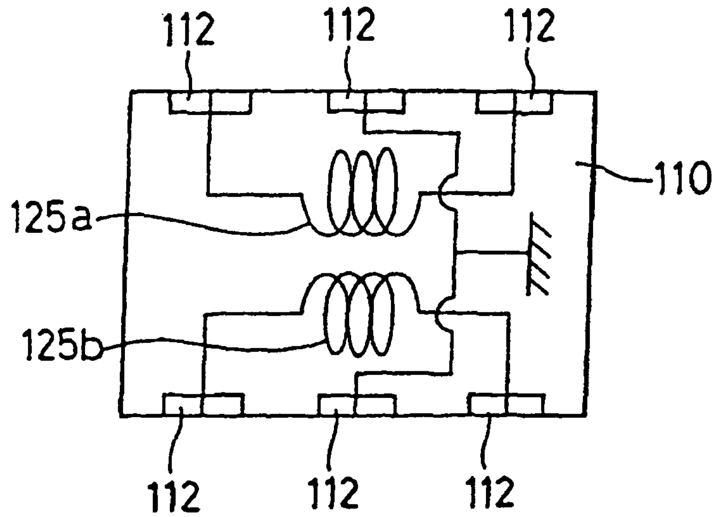


*Fig.37*

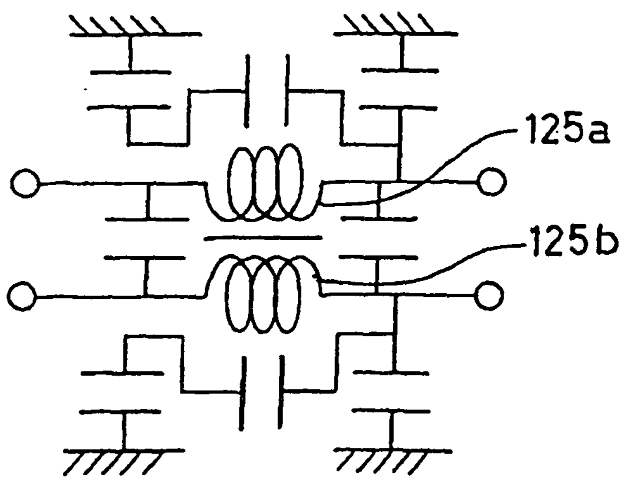

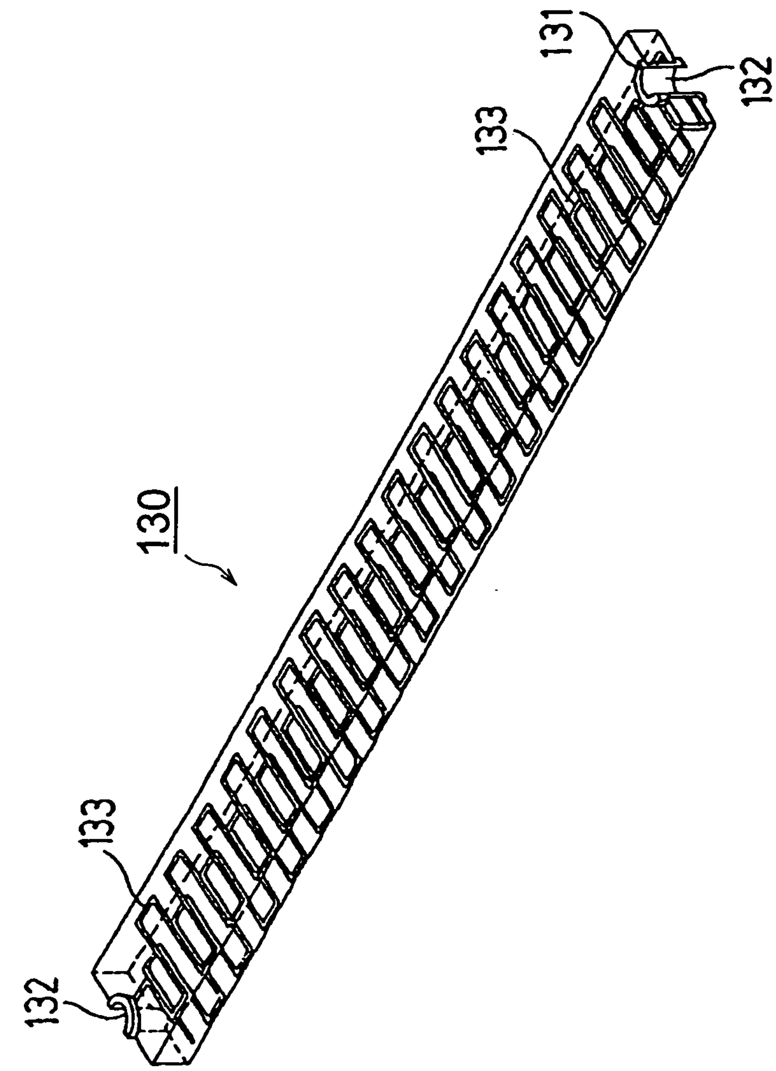


Fig.38

Fig.39

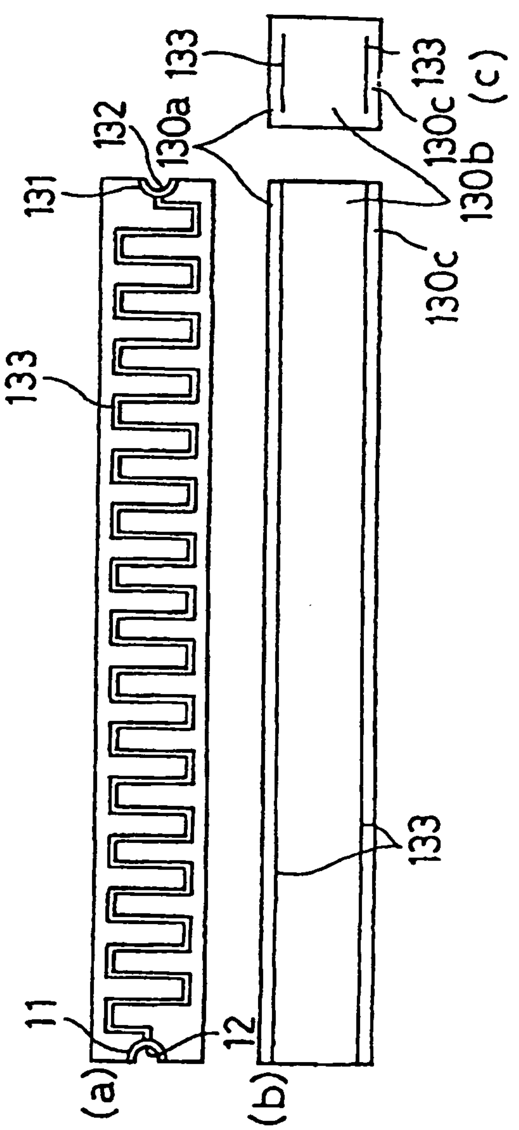

Fig.40

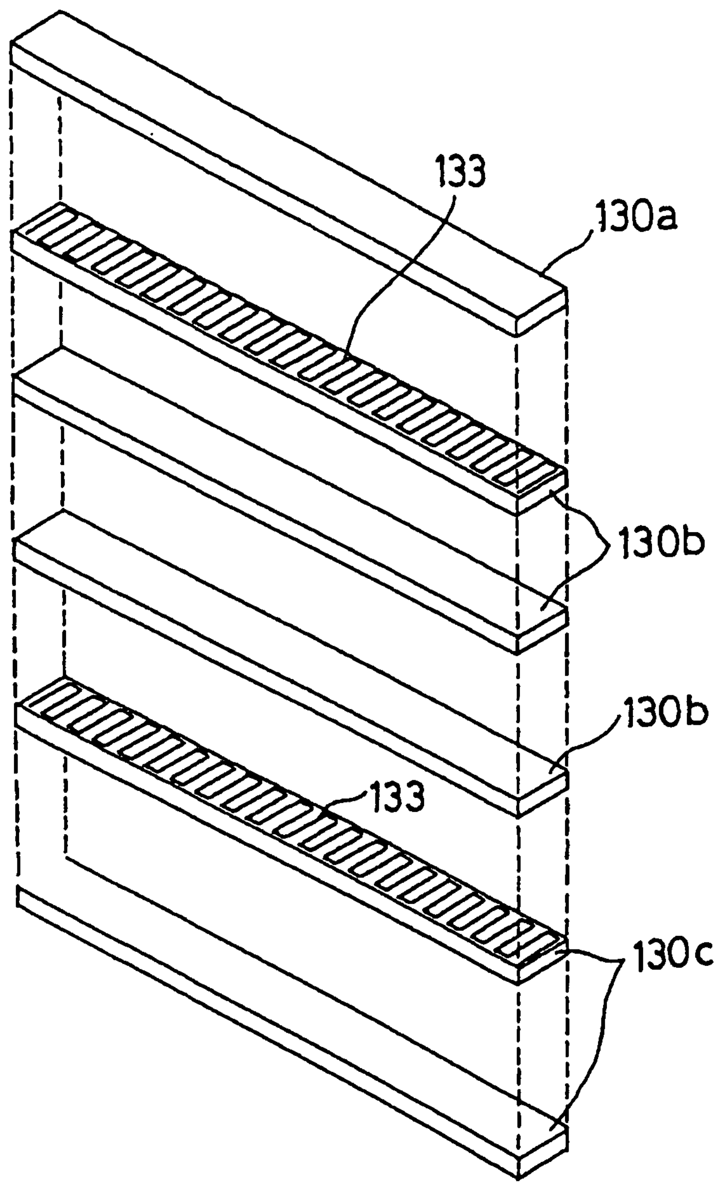

Fig.41

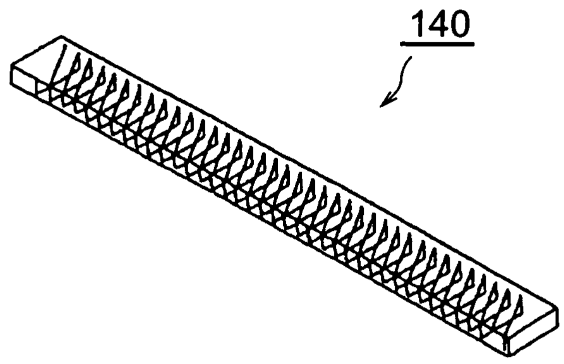

# Fig.42

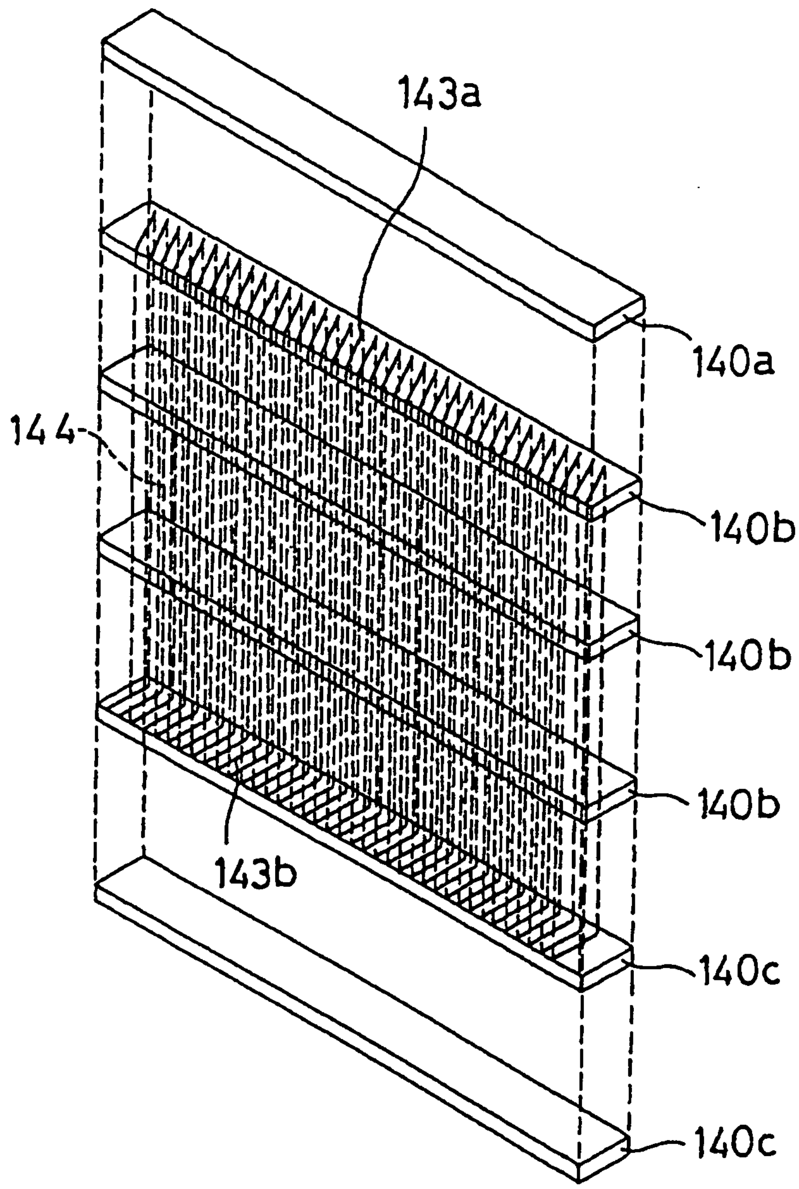

Fig.43

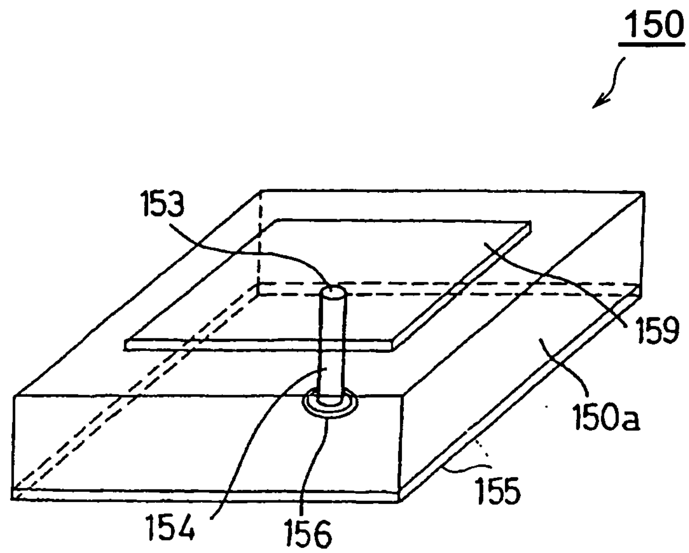


Fig.44

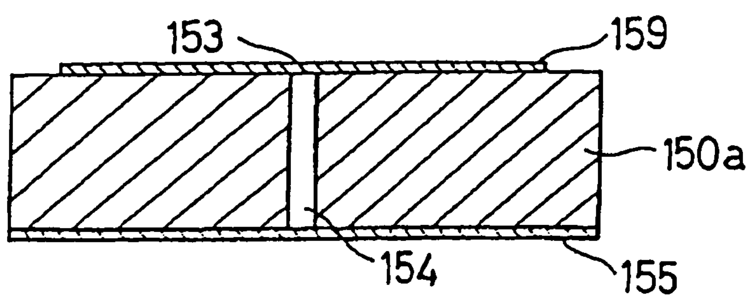

*Fig.45*

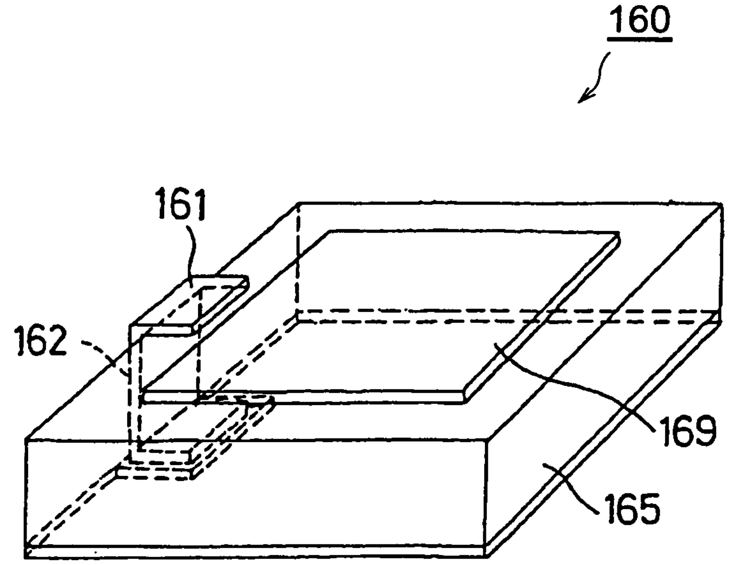


*Fig.46*

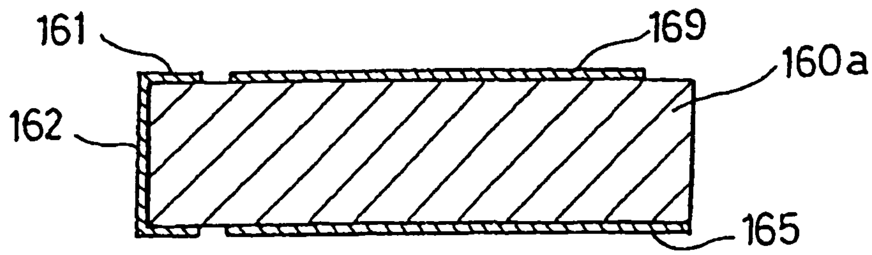

Fig.47

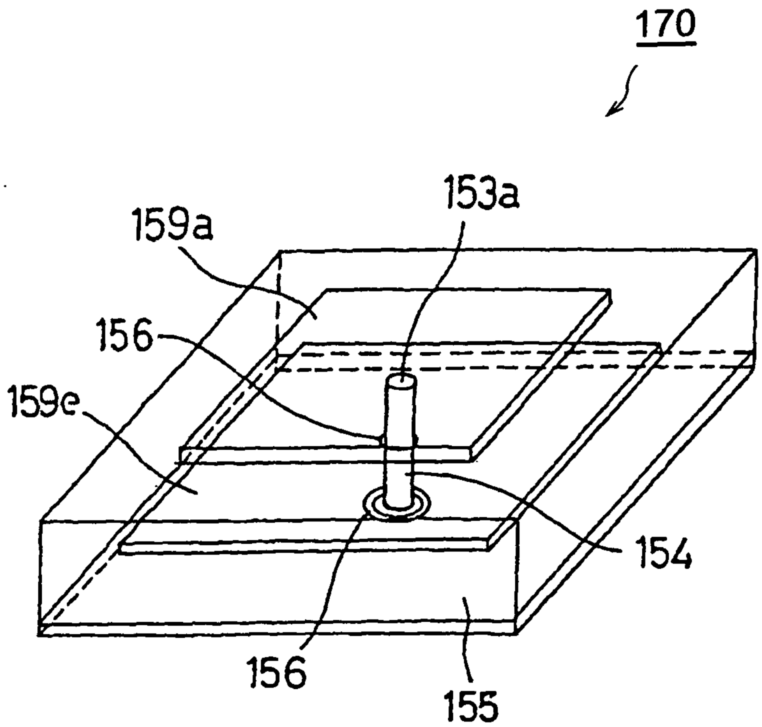
170
153a
159a
156
159e
154
156
155

Fig.48

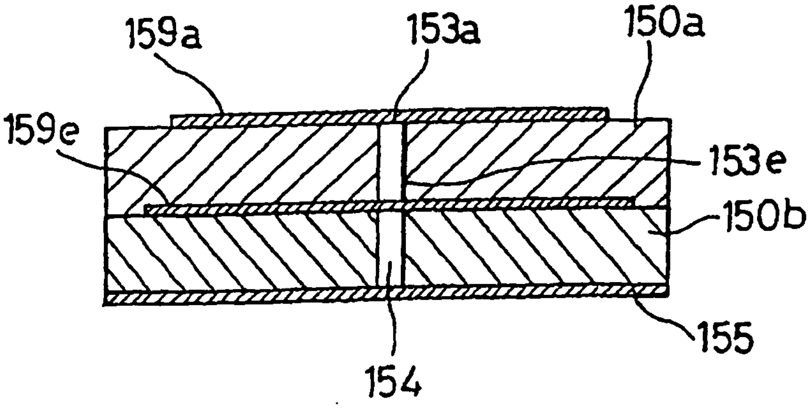
159a
153a
150a
159e
153e
150b
155
154

Fig.49

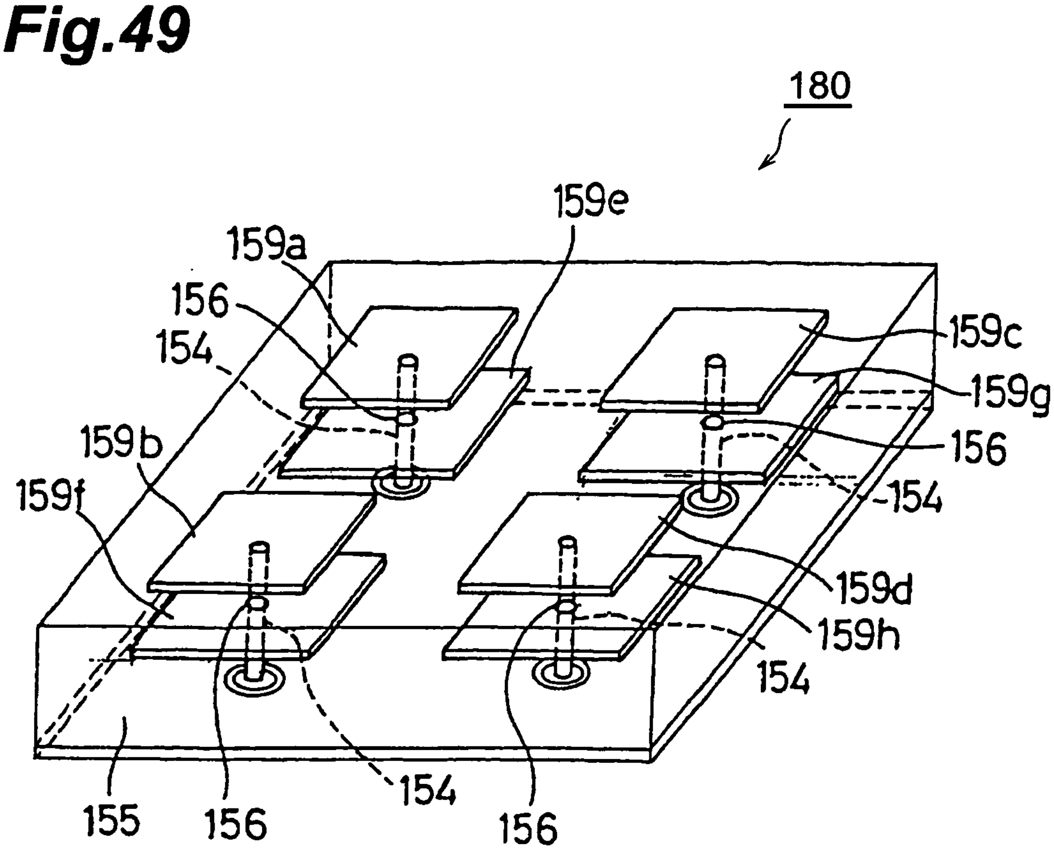
180
159e
159a
156
154
159c
159g
156
154
159b
159f
159d
159h
154
155
156
154
156

Fig.50

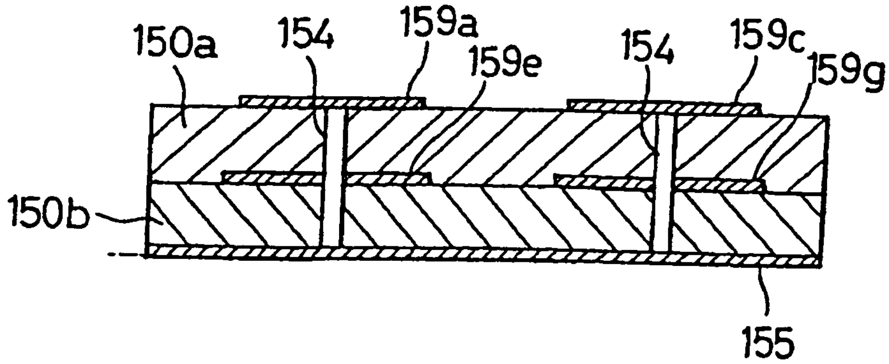
150a
154
159a
159e
154
159c
159g
150b
155

Fig.51

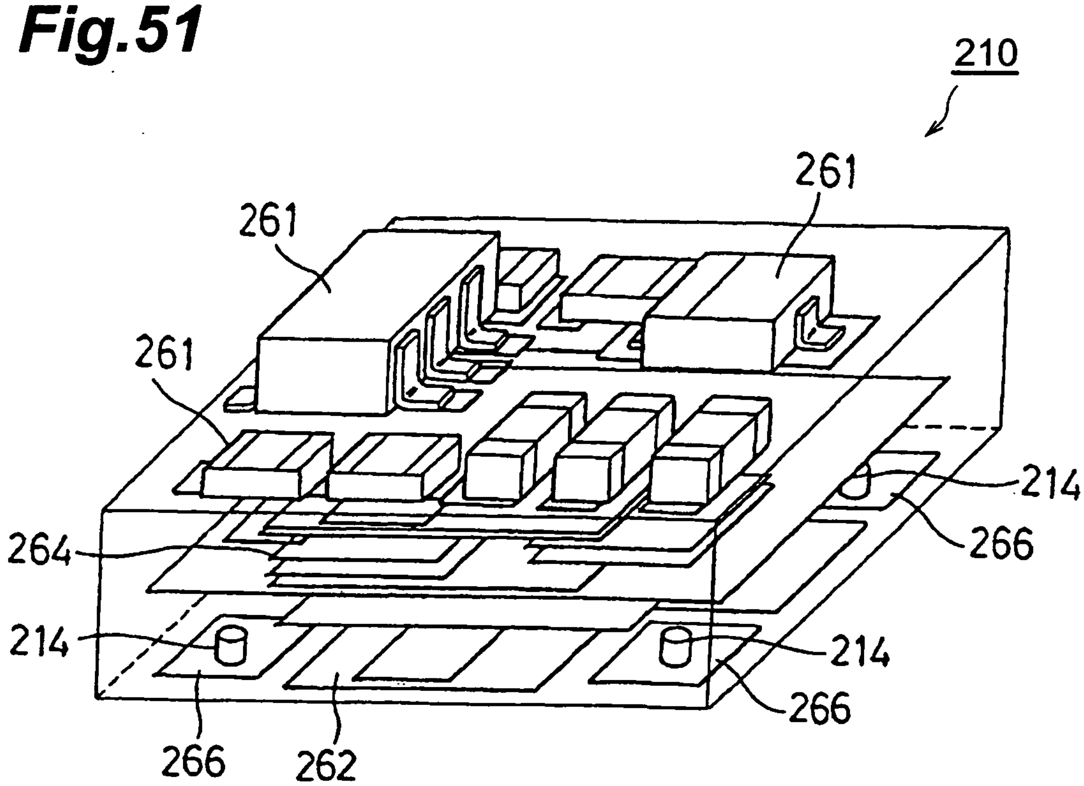
210
261
261
261
214
266
264
214
214
266
266
262

Fig.52

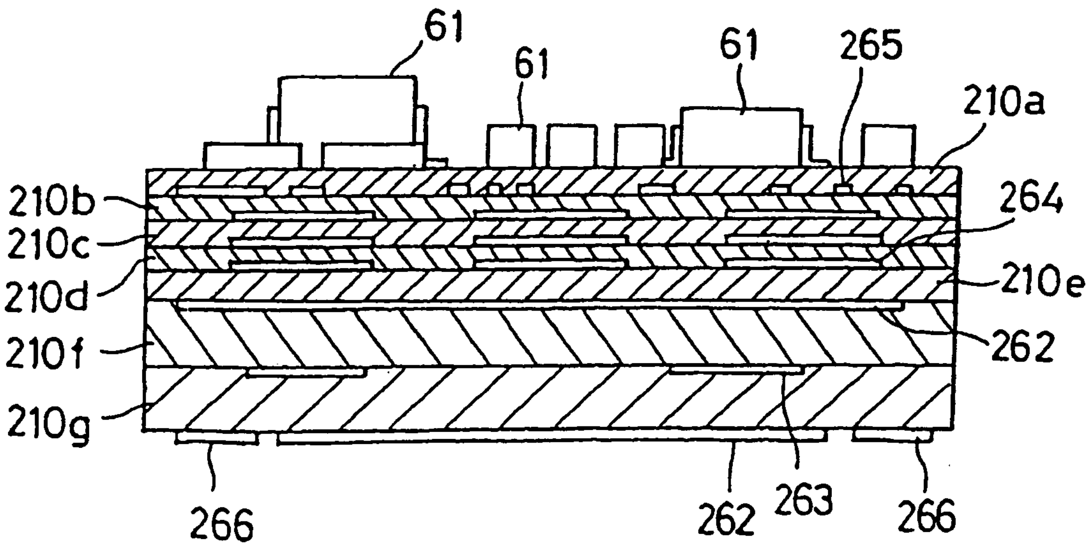
61
61
61
265
210a
210b
264
210c
210d
210e
262
210f
210g
266
262
263
266

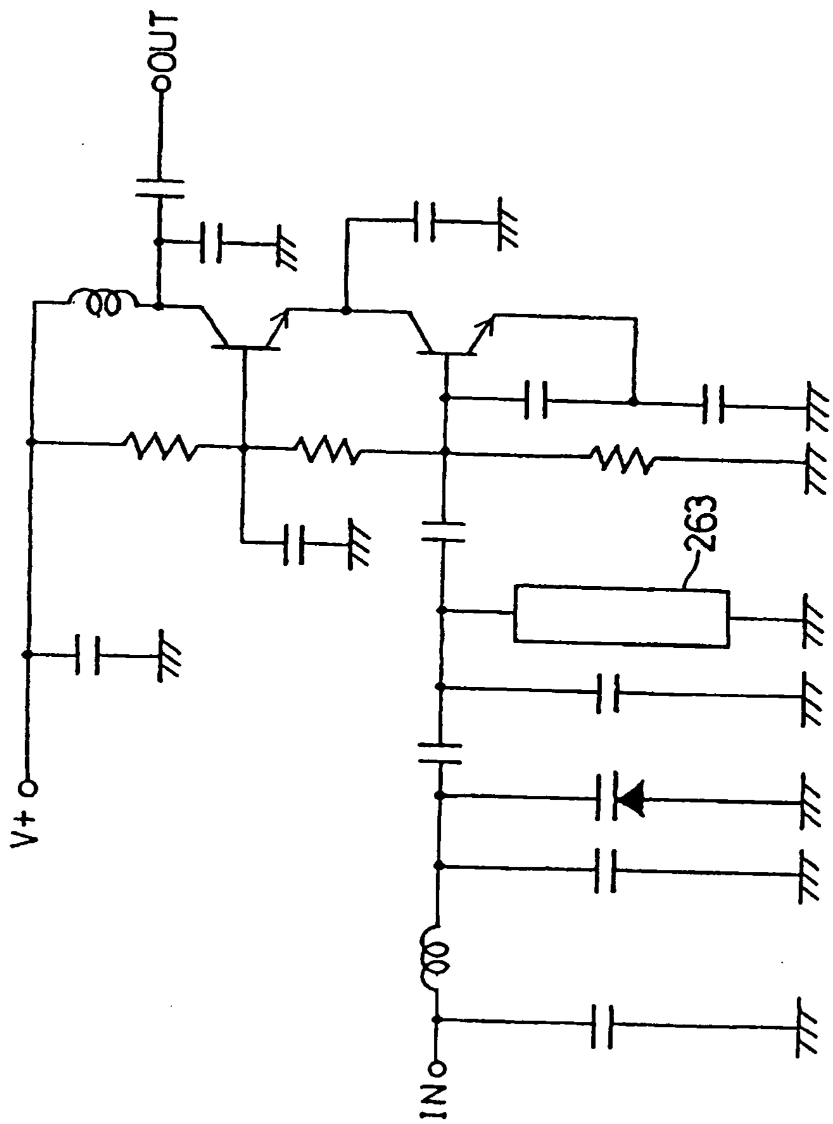


Fig.53

*Fig.54*

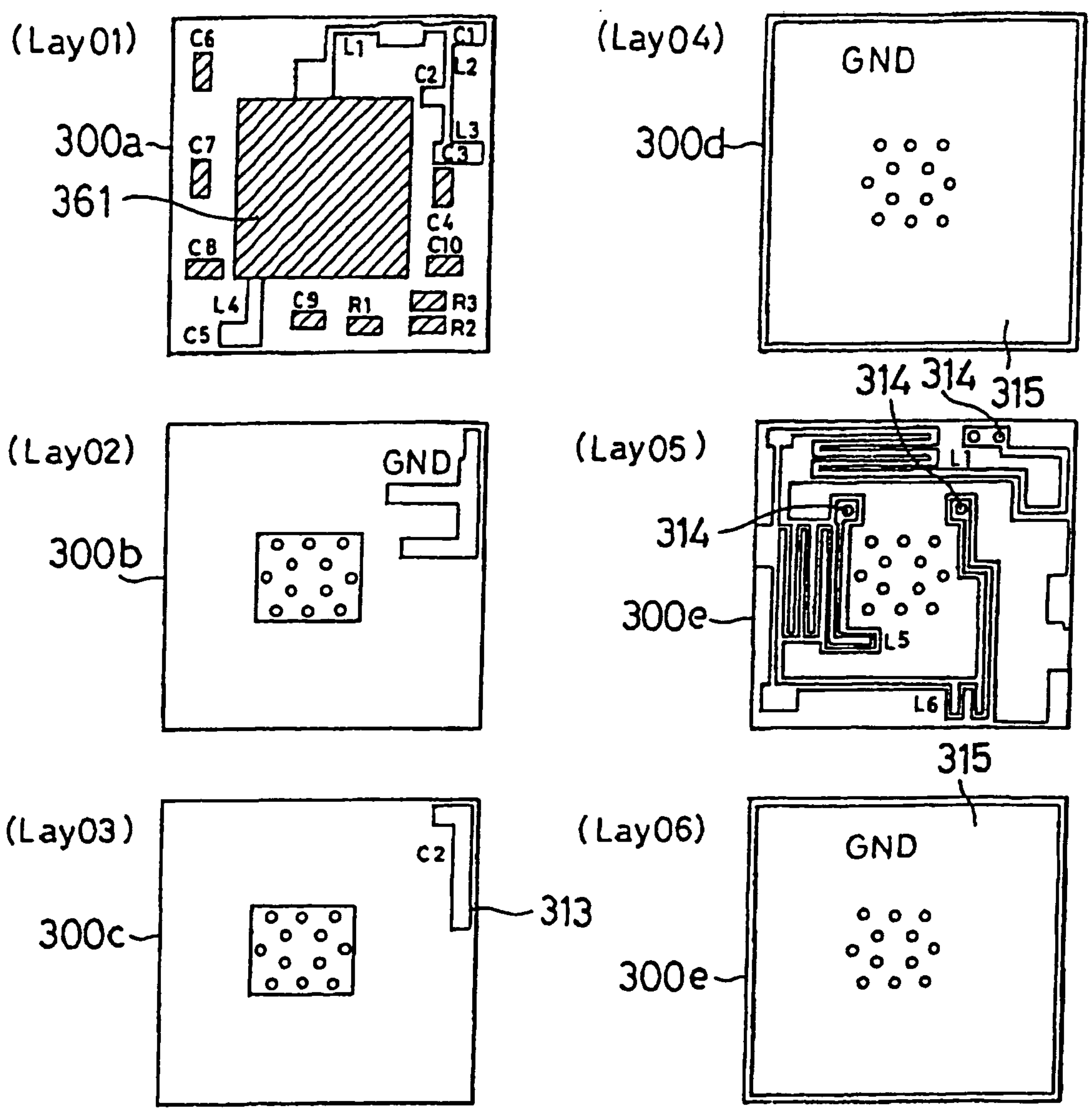
(Lay01)
300a
361
C6
C7
C8
L4
C5
C9
R1
L1
C1
L2
C2
L3
C3
C4
C10
R3
R2
(Lay02)
300b
GND
(Lay03)
300c
C2
313
(Lay04)
300d
GND
315
314
314
(Lay05)
314
300e
L1
L5
L6
315
(Lay06)
300e
GND

Fig.55

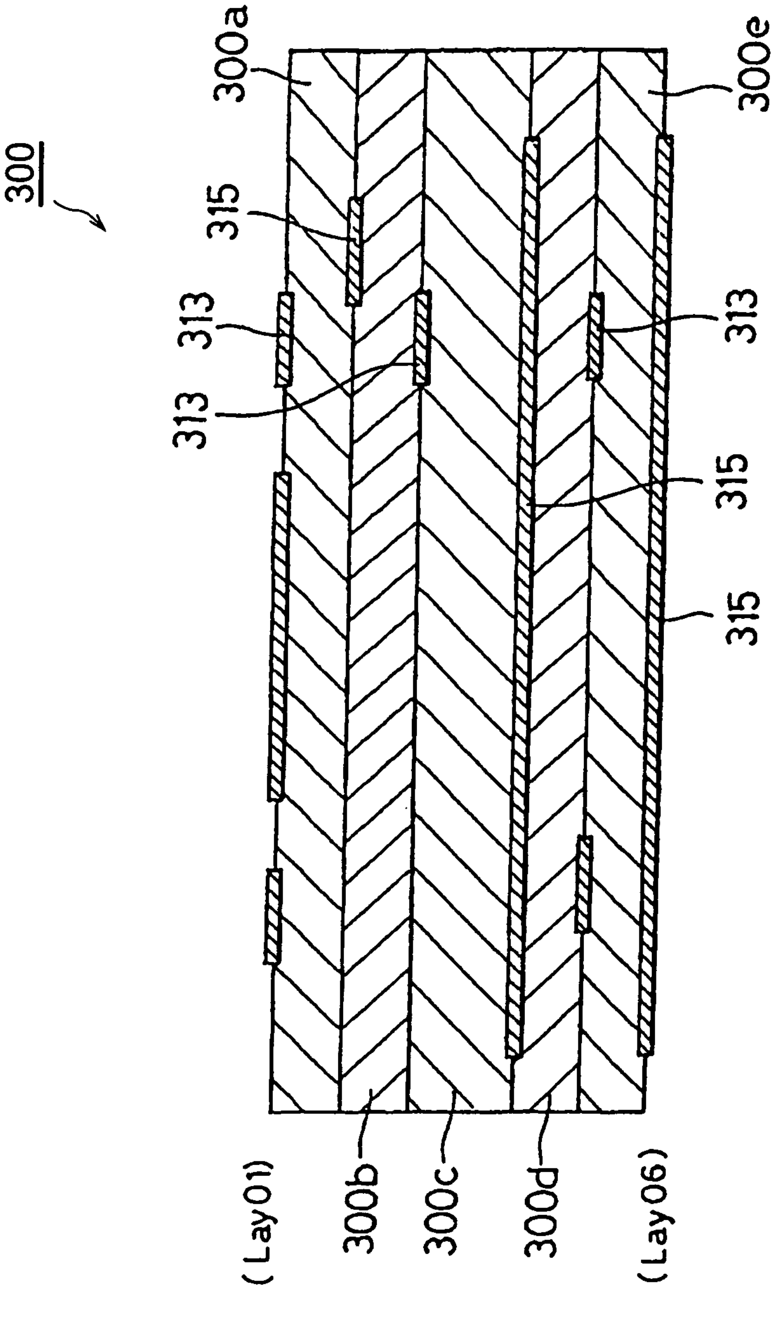
300
300a
315
313
313
313
315
315
313
300e
(Lay01)
300b
300c
300d
(Lay06)

**Fig.56**

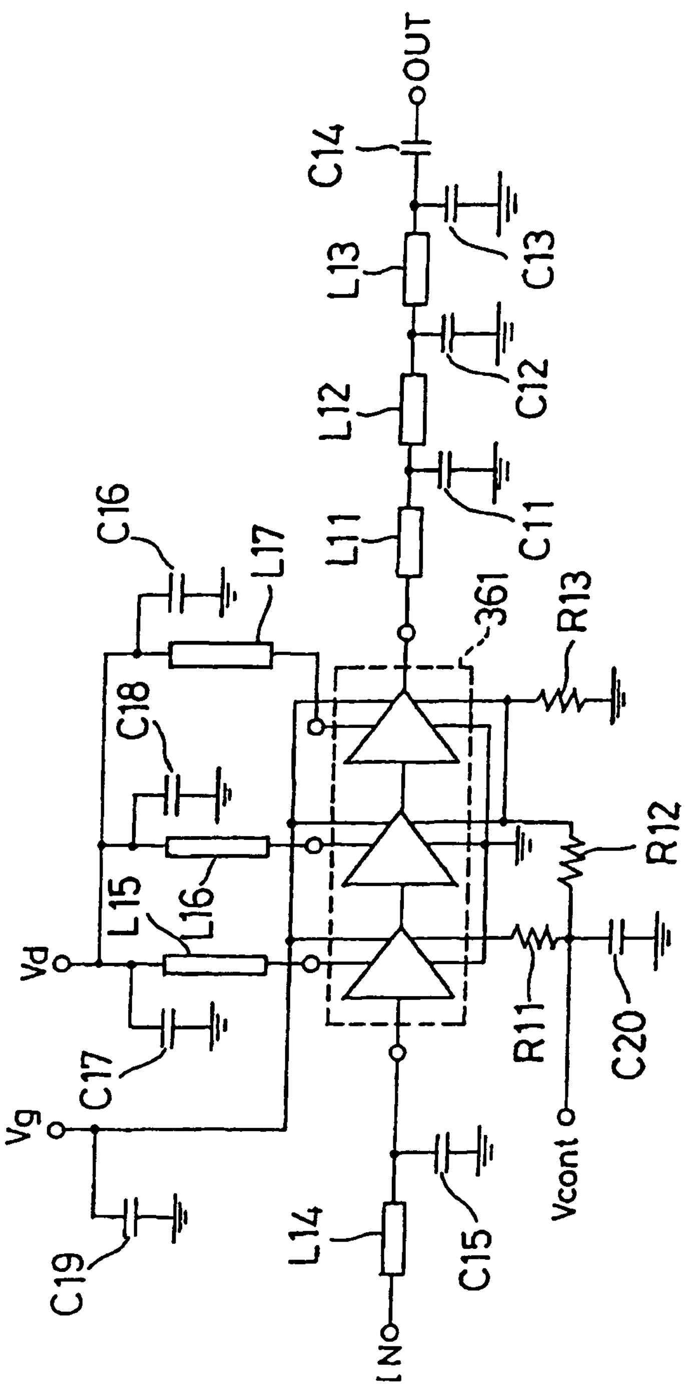

OUT
C14
C13
L13
C12
L12
C11
L11
C16
L17
361
R13
C18
R12
Vd
L15
L16
Vg
C17
R11
C20
C19
L14
C15
Vcont
IN

*Fig.57*

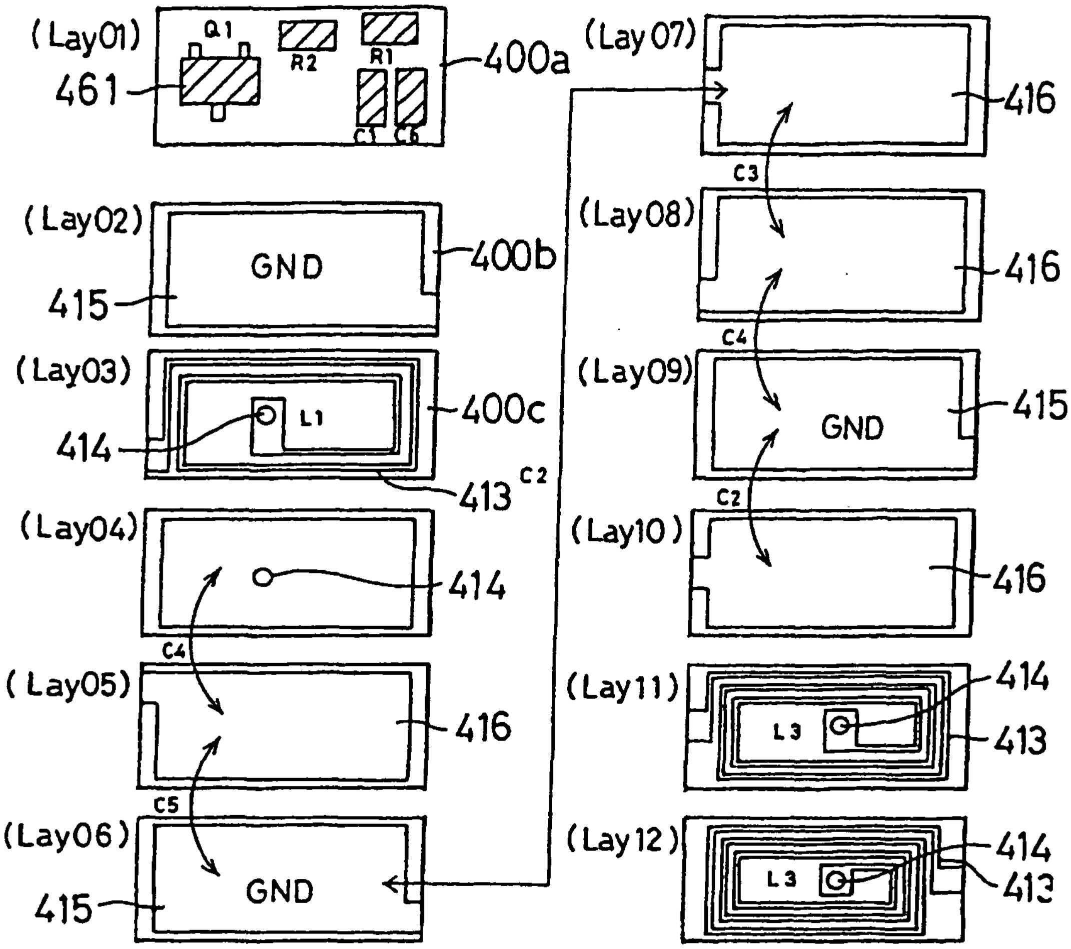

(Lay01)
Q1
R2
R1
C1
C6
461
400a
(Lay02)
GND
400b
415
(Lay03)
L1
400c
414
413
C2
(Lay04)
414
C4
(Lay05)
416
C5
(Lay06)
GND
415
(Lay07)
416
C3
(Lay08)
416
C4
(Lay09)
GND
415
C2
(Lay10)
416
(Lay11)
L3
414
413
(Lay12)
L3
414
413

*Fig.58*

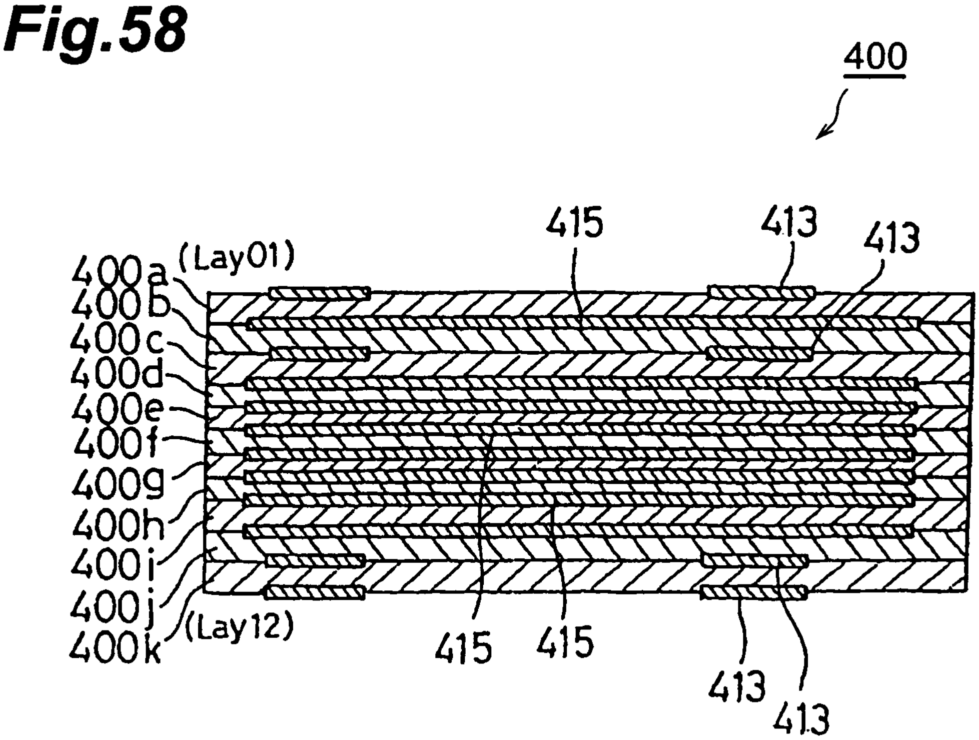
400
415
413
413
400a (Lay01)
400b
400c
400d
400e
400f
400g
400h
400i
400j
400k (Lay12)
415
415
413
413

*Fig.59*

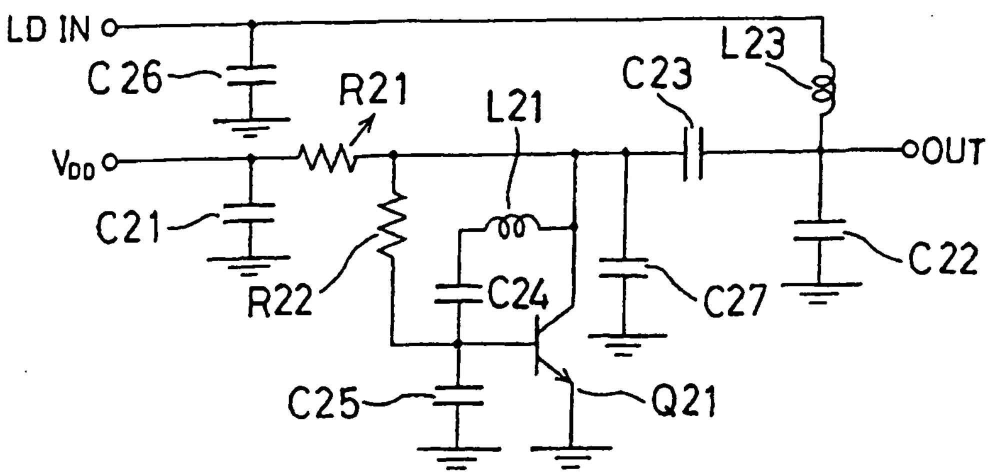
LD IN
C26
R21
L21
C23
L23
VDD
OUT
C21
R22
C24
C27
C22
C25
Q21

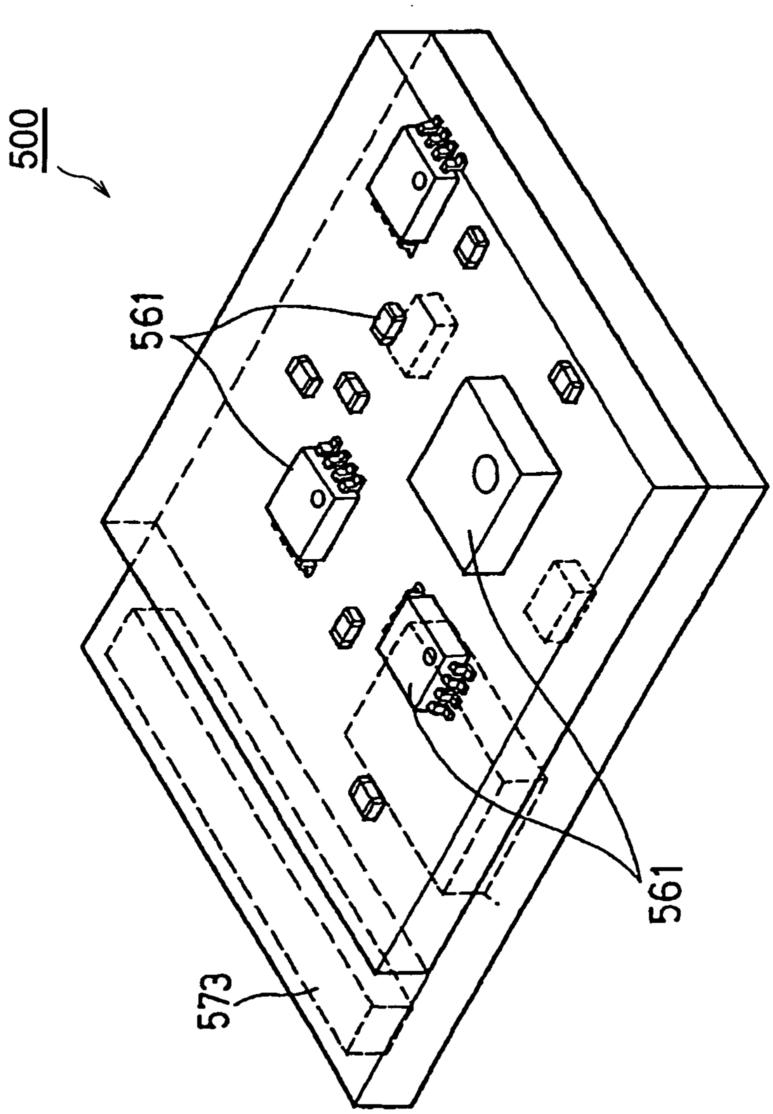


Fig.60

Fig.61

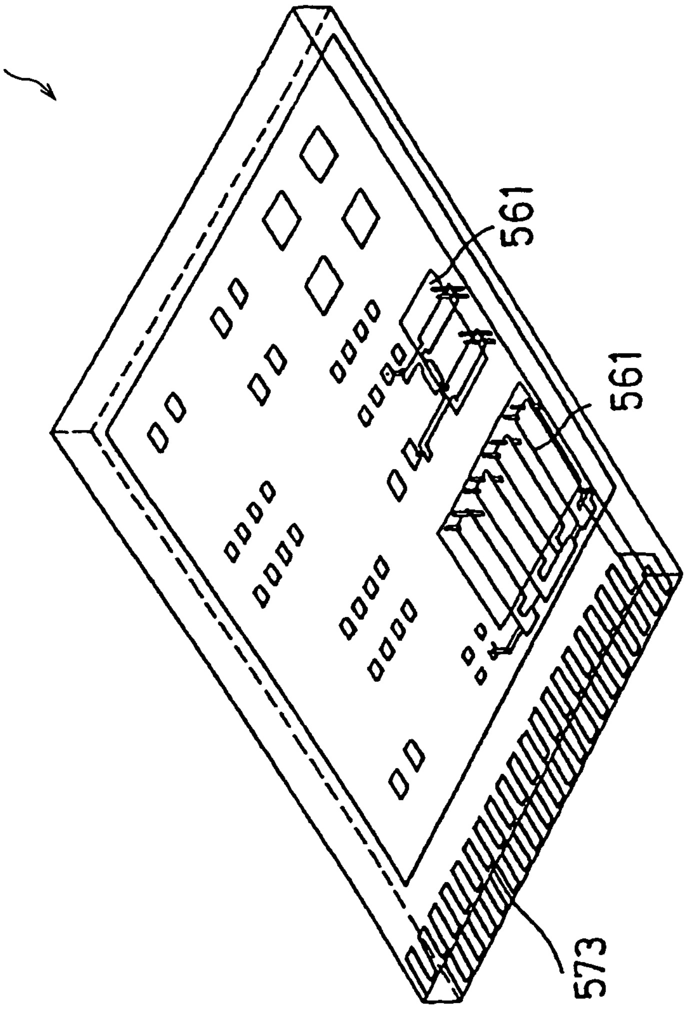

# Fig.62

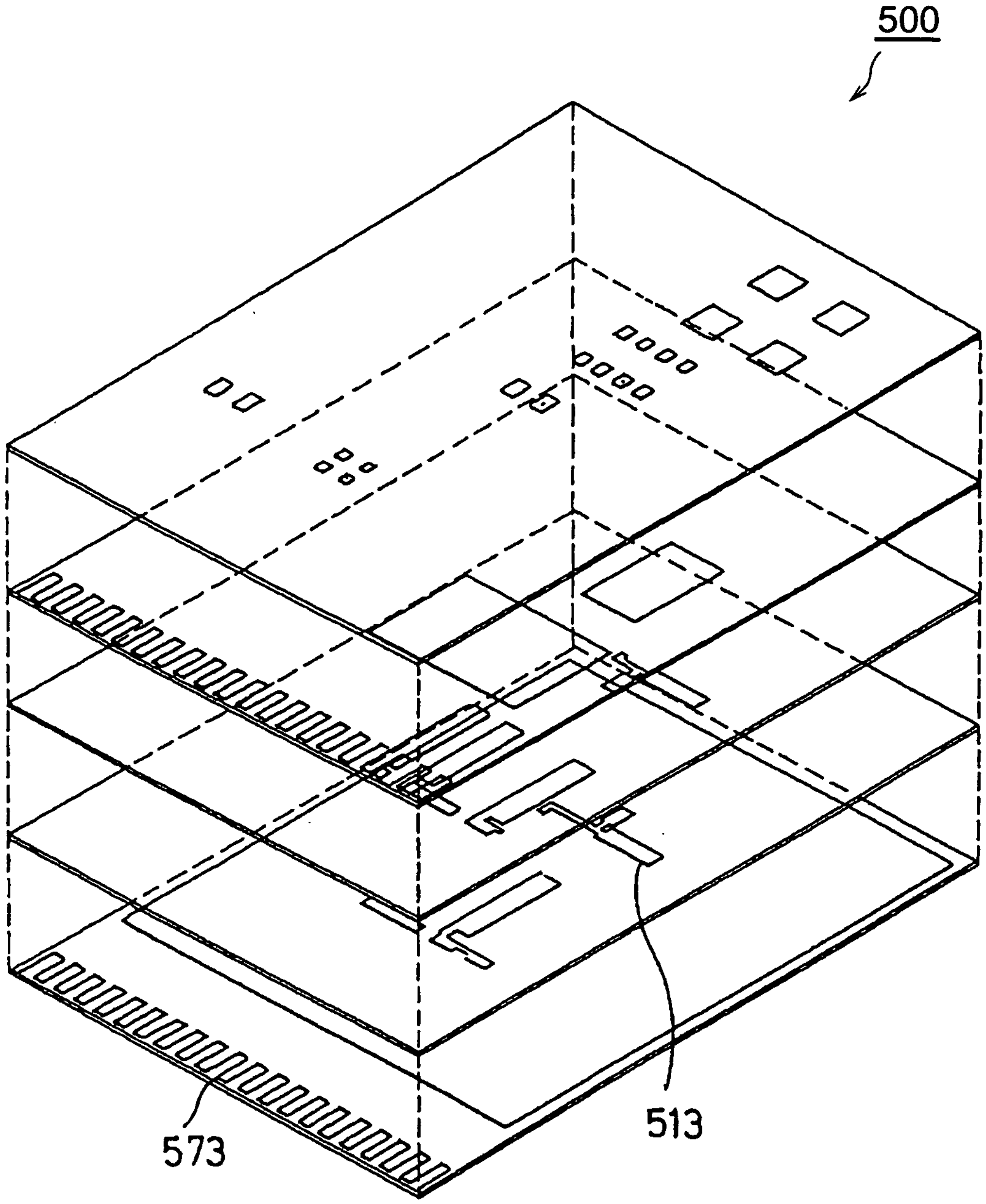

Fig.63

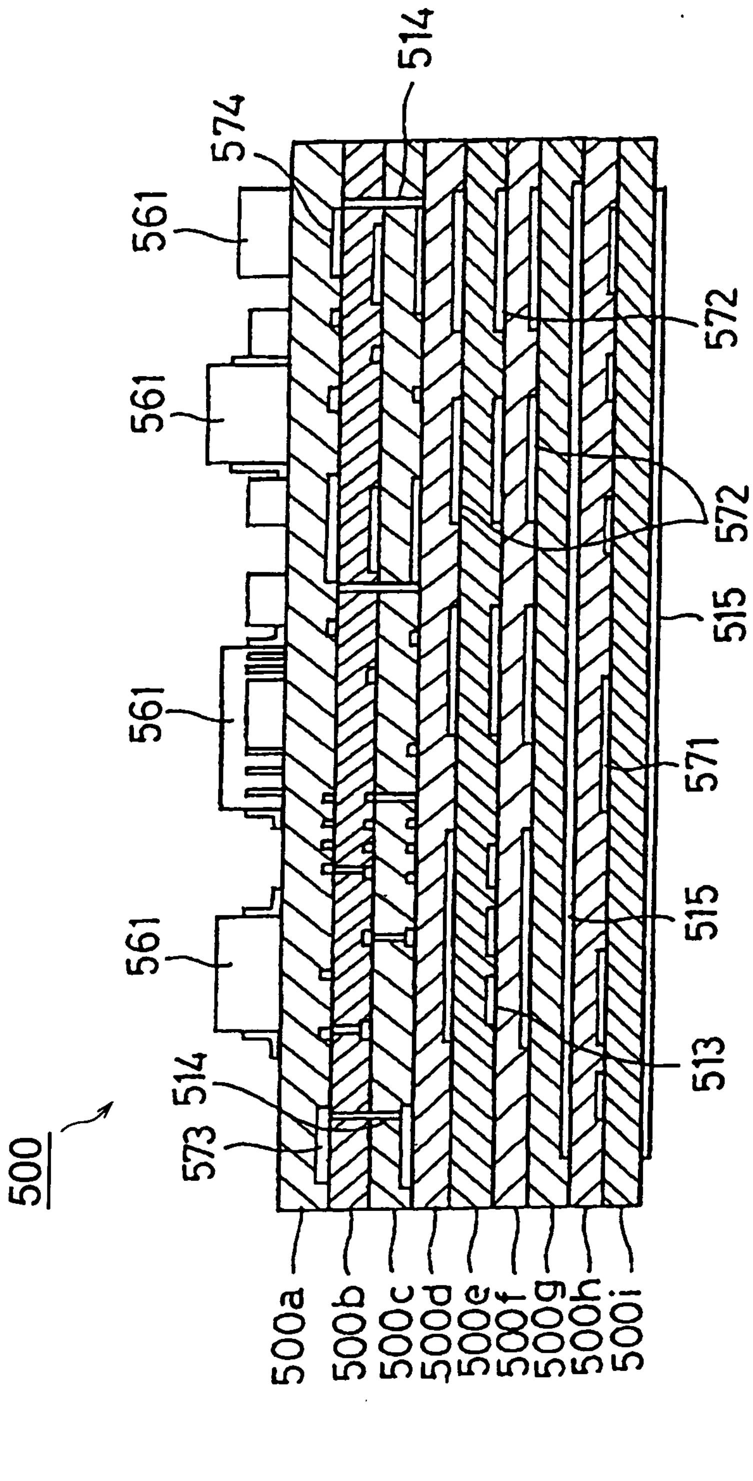
500
561
561
561
561
574
514
514
573
572
572
515
571
515
513
500a
500b
500c
500d
500e
500f
500g
500h
500i

Fig.64

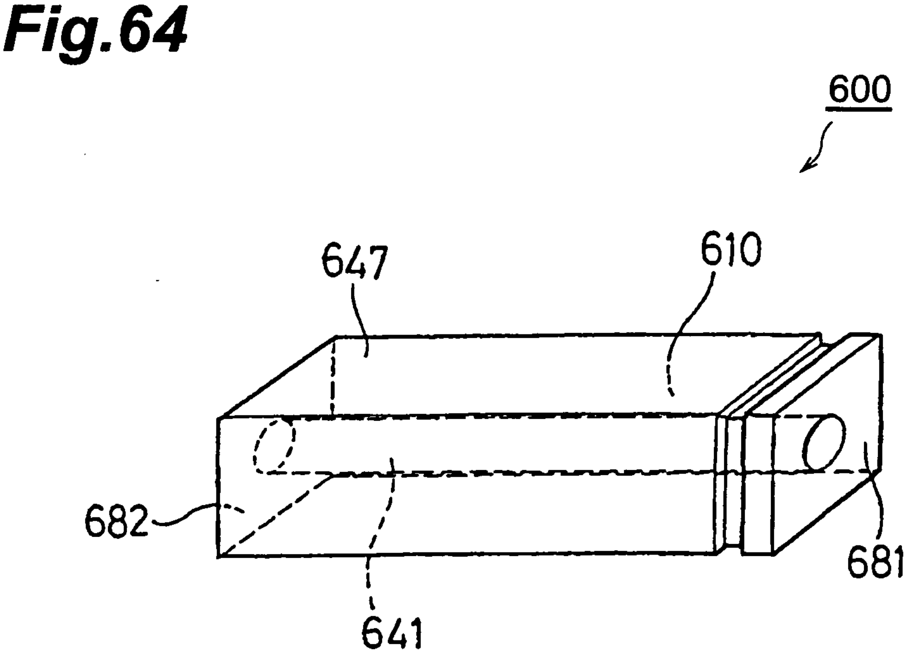


Fig.65

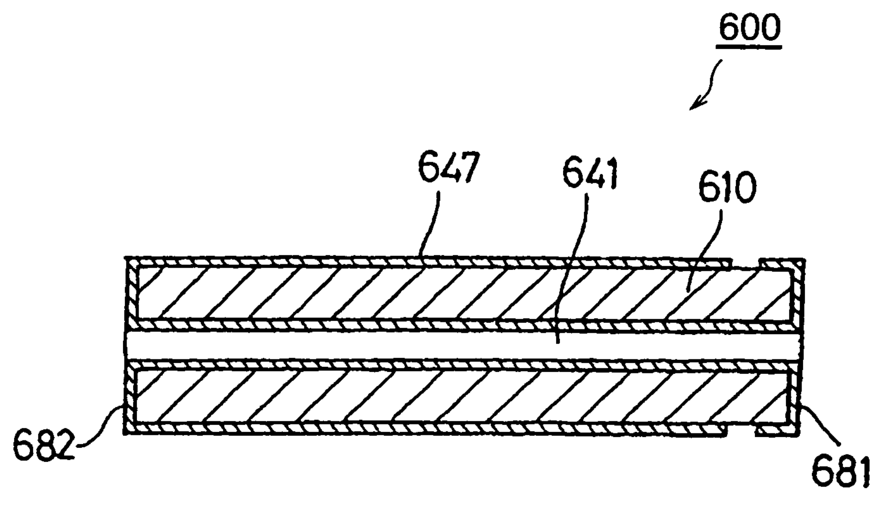

# Fig.66

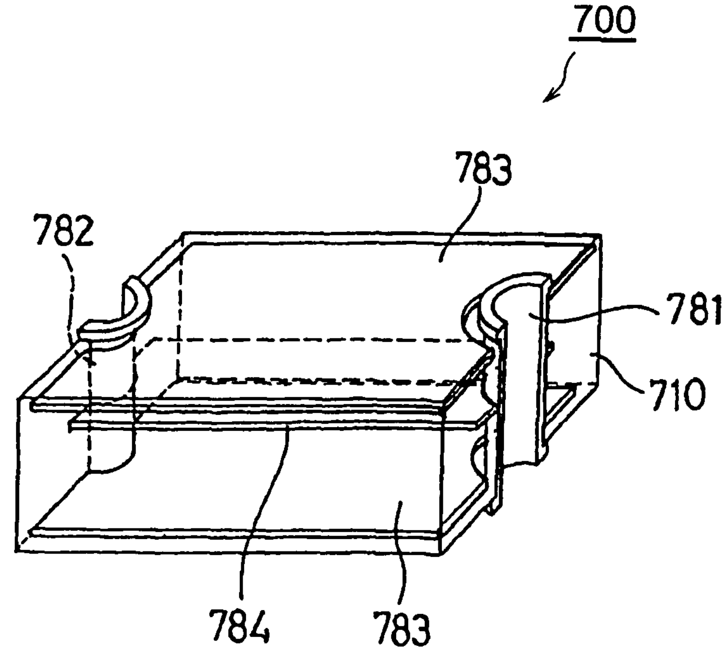
700
783
782
781
710
784
783

# Fig.67

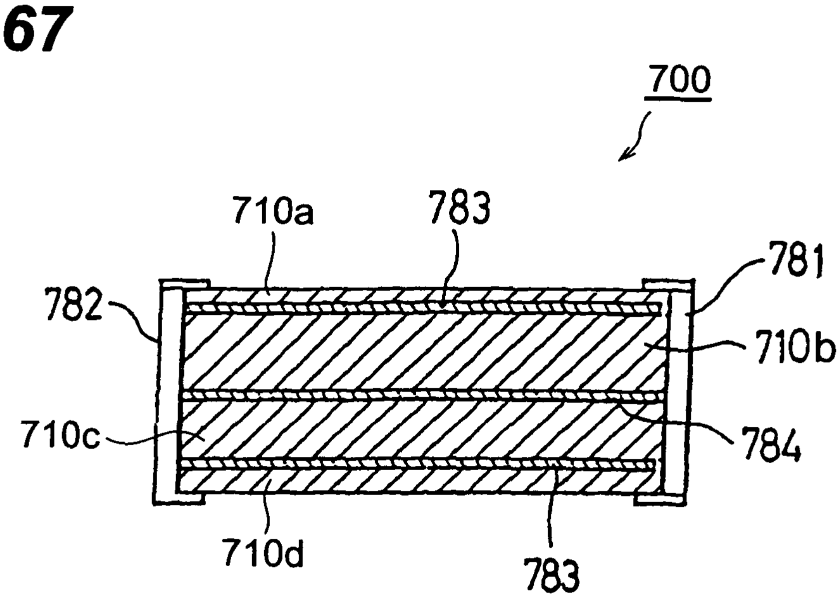
700
710a
783
781
782
710b
710c
784
710d
783

Fig.68

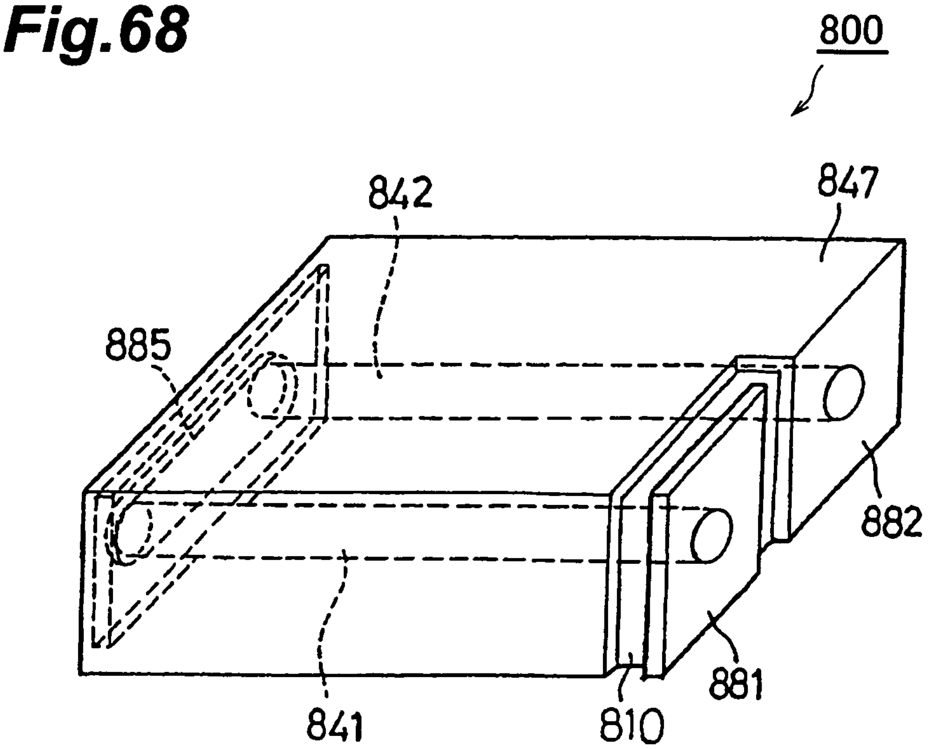
800
842
847
885
882
881
841
810

Fig.69

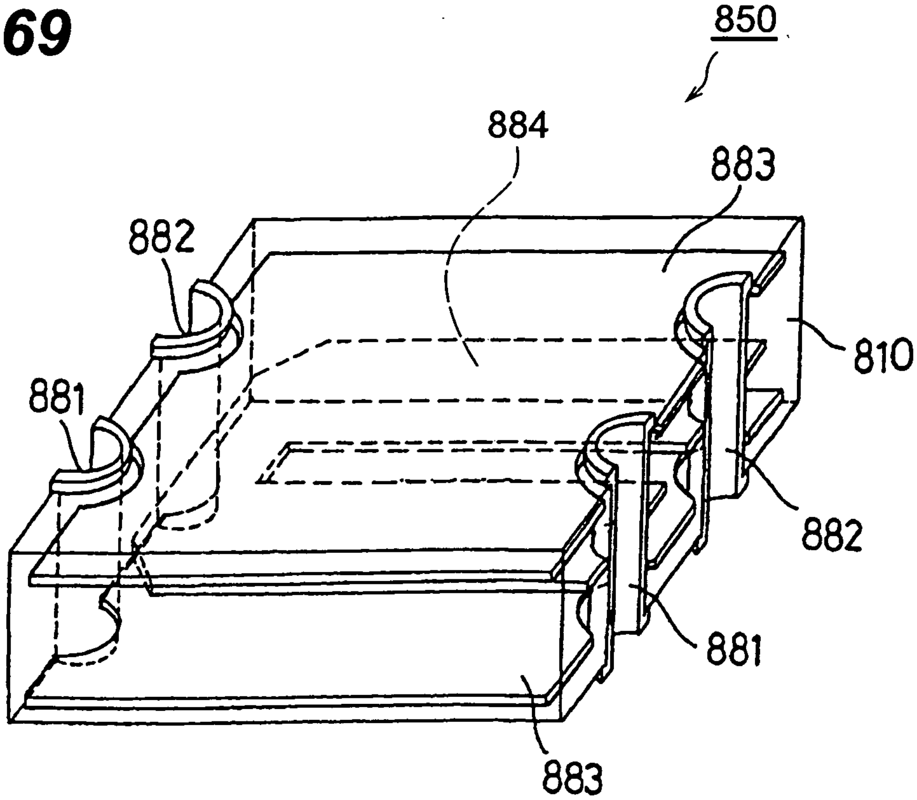
850
884
883
882
810
881
882
881
883

Fig.70

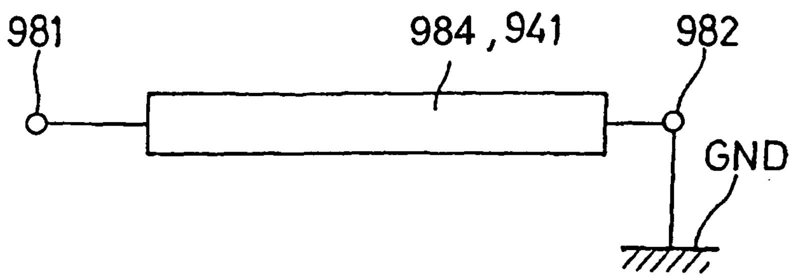

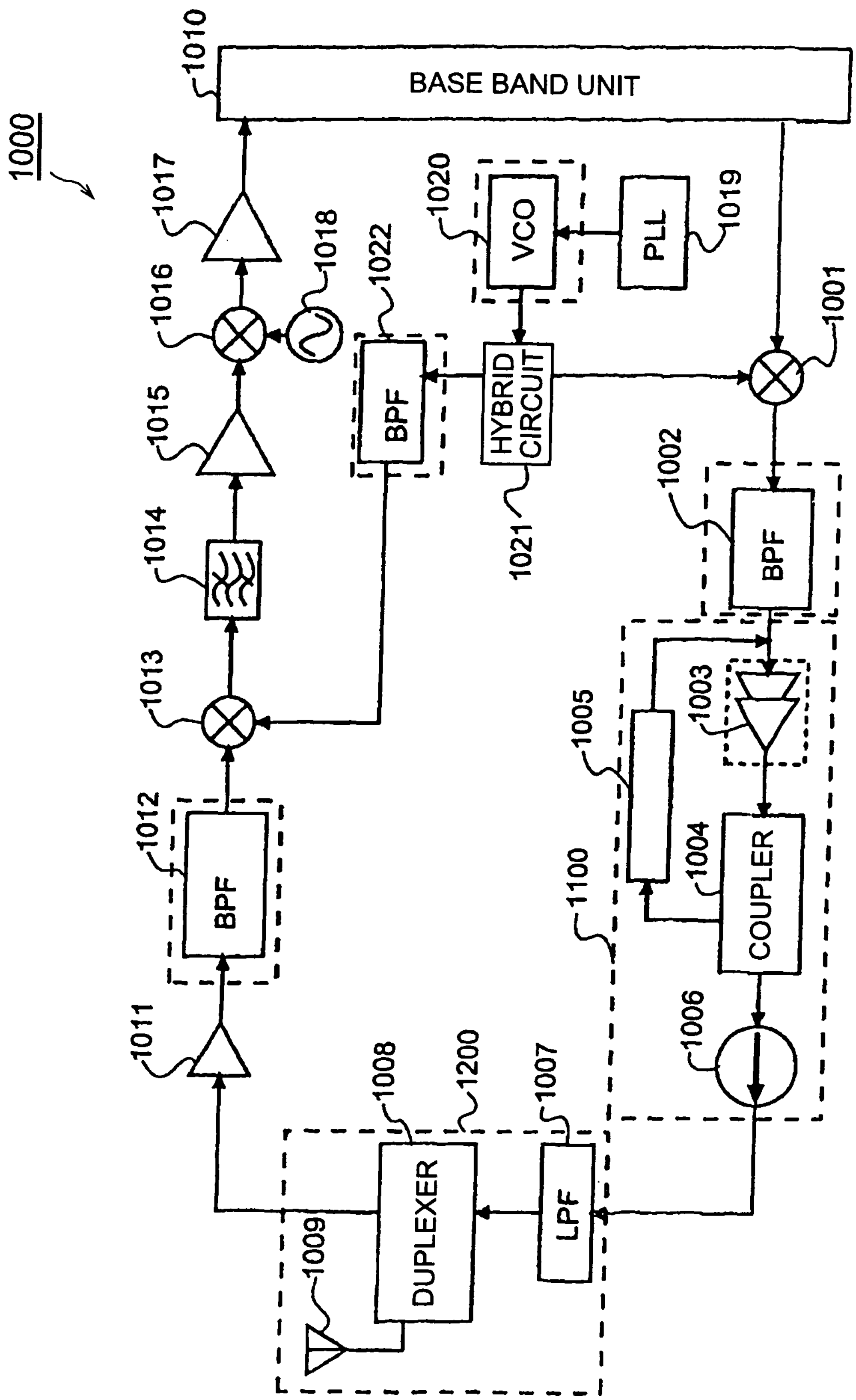
1000
BASE BAND UNIT
1010
1017
1018
1016
1015
1014
1013
1012
BPF
1011
1022
BPF
1020
VCO
PLL
1019
HYBRID CIRCUIT
1021
1001
1002
BPF
1003
1005
1004
COUPLER
1100
1006
1008
1200
1007
DUPLEXER
LPF
1009

Fig.71

*Fig.72*

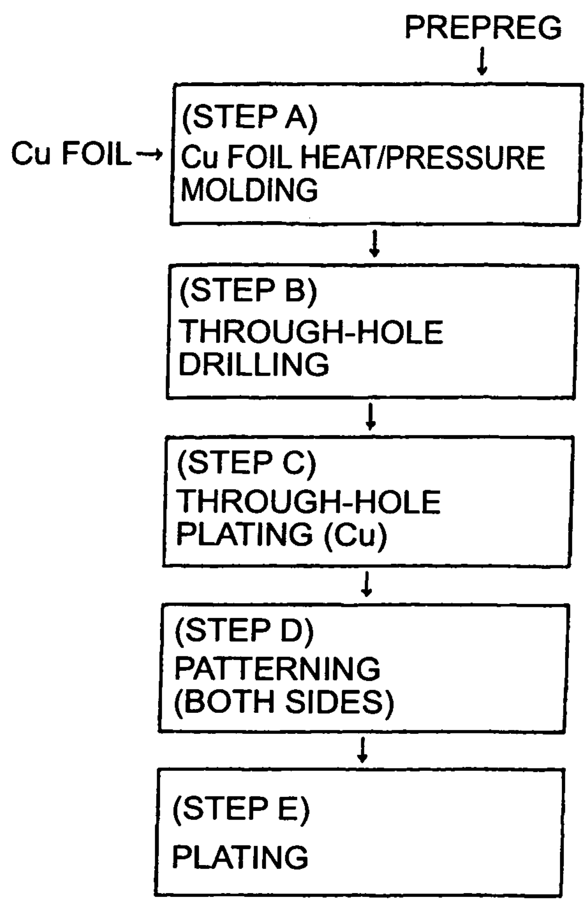
PREPREG
Cu FOIL
(STEP A)
Cu FOIL HEAT/PRESSURE MOLDING
(STEP B)
THROUGH-HOLE DRILLING
(STEP C)
THROUGH-HOLE PLATING (Cu)
(STEP D)
PATTERNING (BOTH SIDES)
(STEP E)
PLATING

*Fig.73*

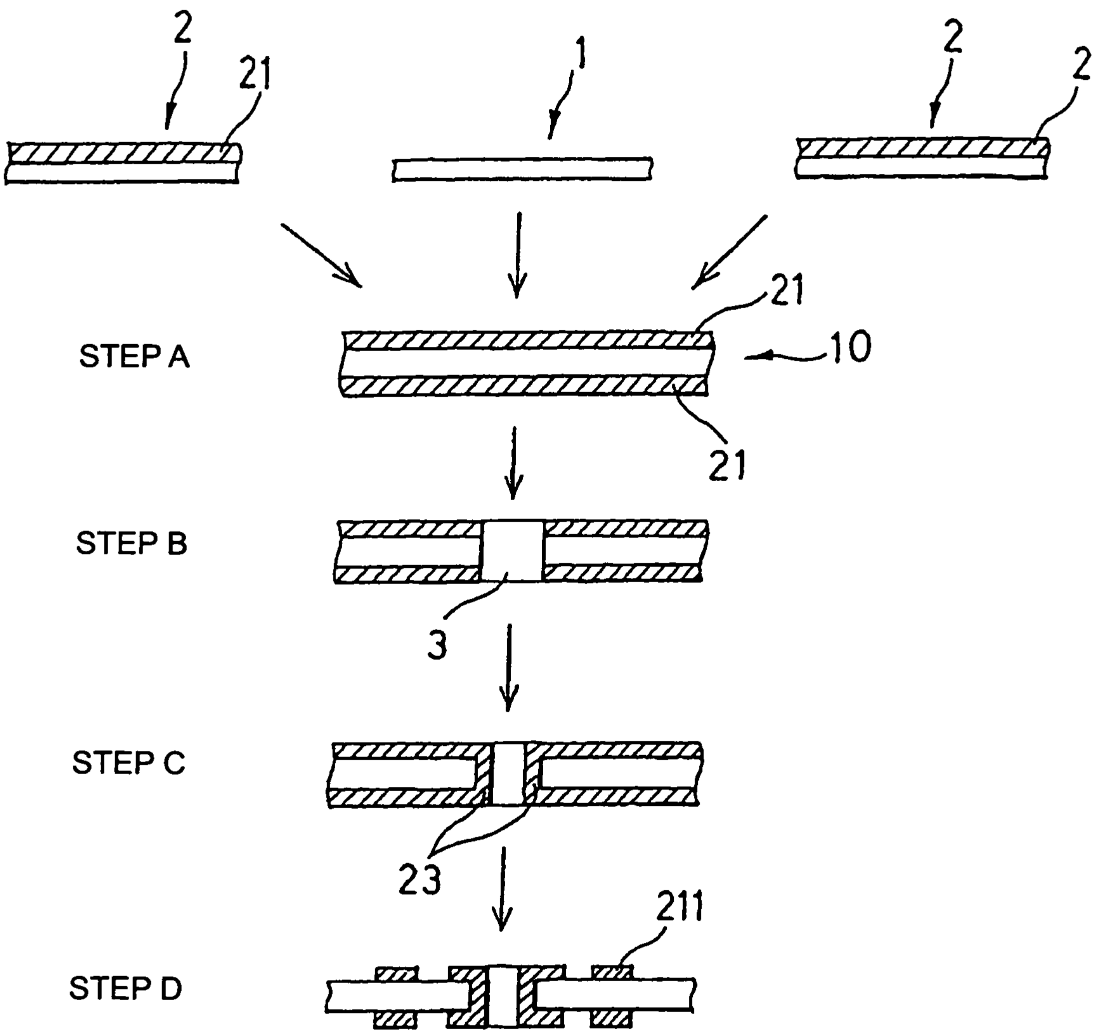

Fig.74

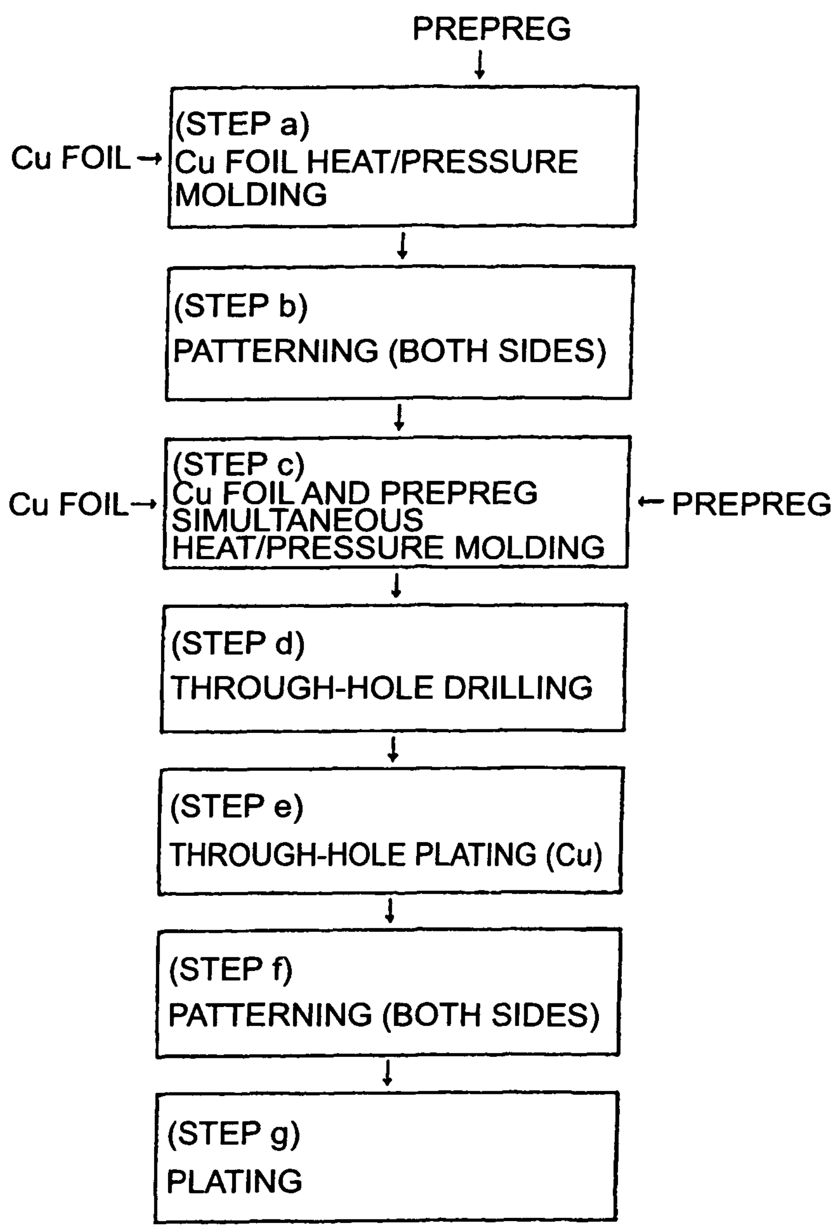
PREPREG
Cu FOIL
(STEP a)
Cu FOIL HEAT/PRESSURE MOLDING
(STEP b)
PATTERNING (BOTH SIDES)
Cu FOIL
(STEP c)
Cu FOIL AND PREPREG SIMULTANEOUS HEAT/PRESSURE MOLDING
PREPREG
(STEP d)
THROUGH-HOLE DRILLING
(STEP e)
THROUGH-HOLE PLATING (Cu)
(STEP f)
PATTERNING (BOTH SIDES)
(STEP g)
PLATING

*Fig.75*

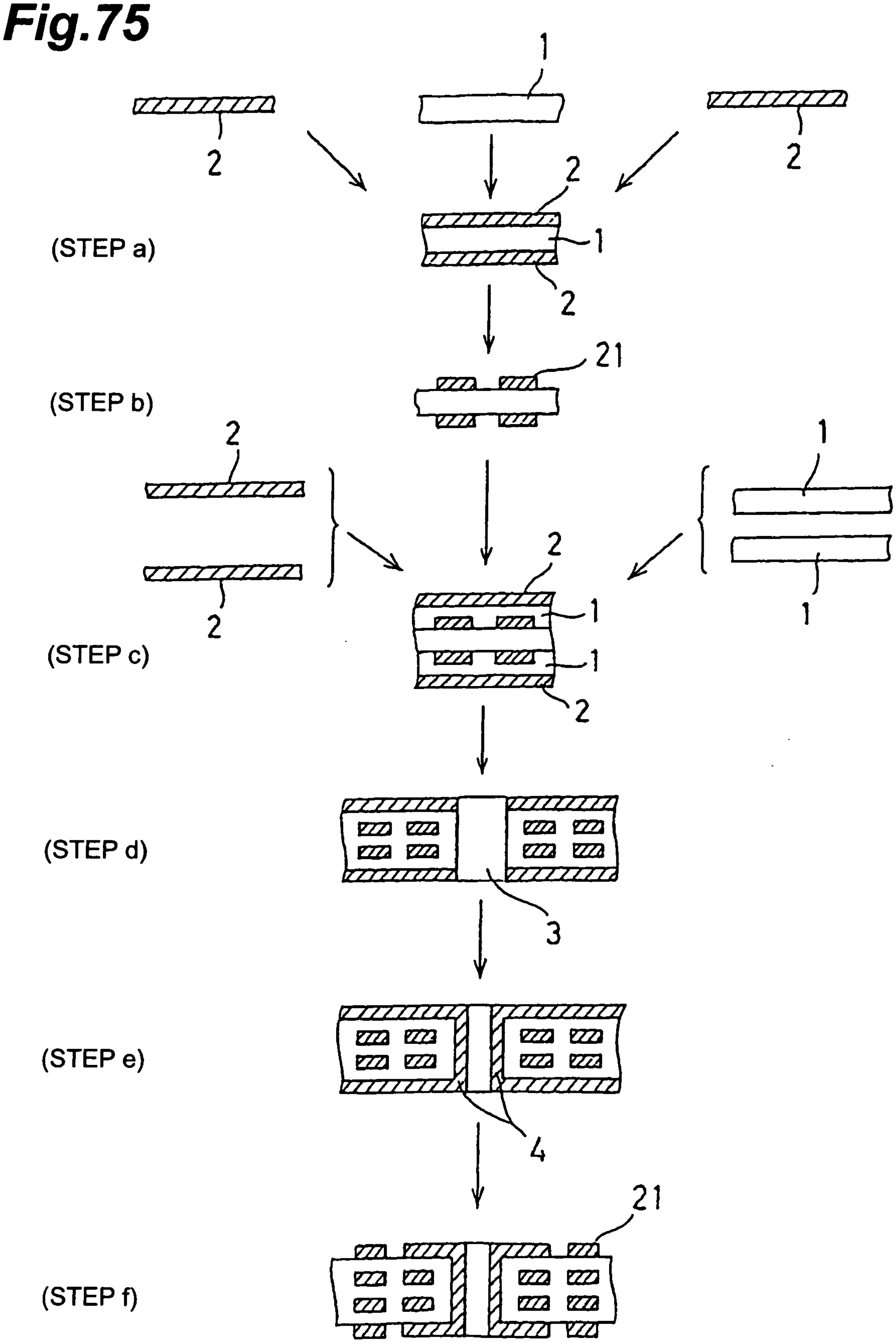

Fig.76

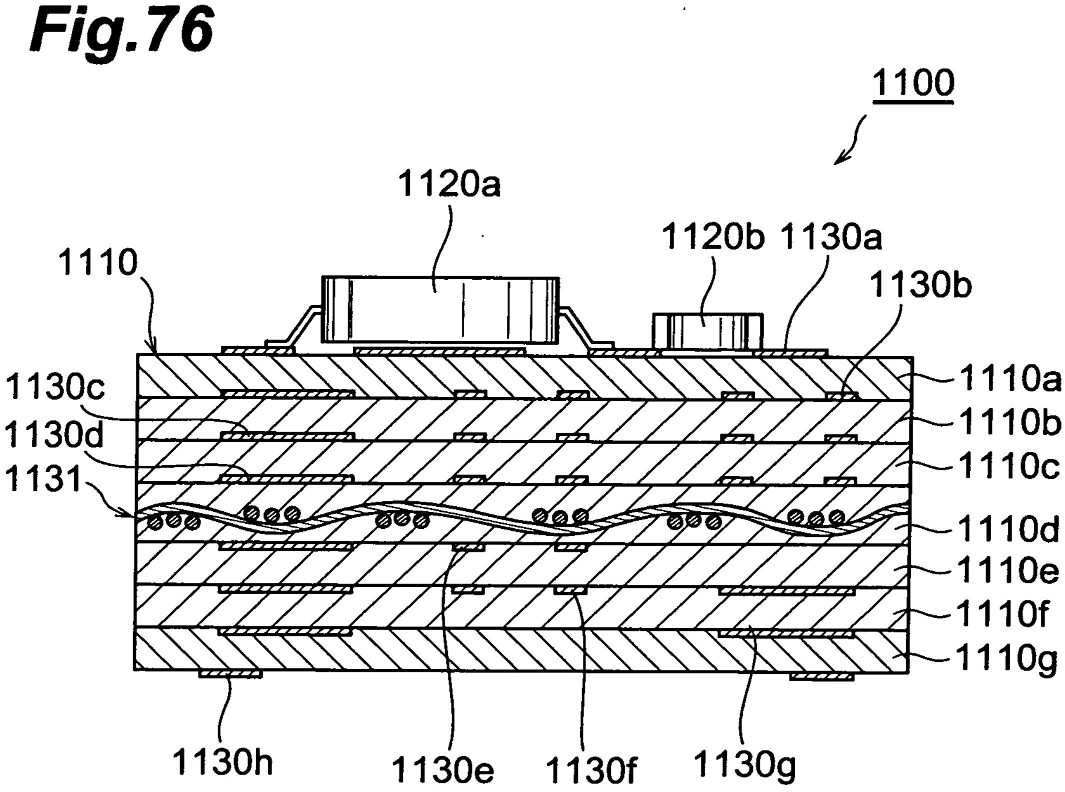
1100
1120a
1120b 1130a
1130b
1110
1130c
1130d
1131
1110a
1110b
1110c
1110d
1110e
1110f
1110g
1130h
1130e
1130f
1130g

*Fig.77*

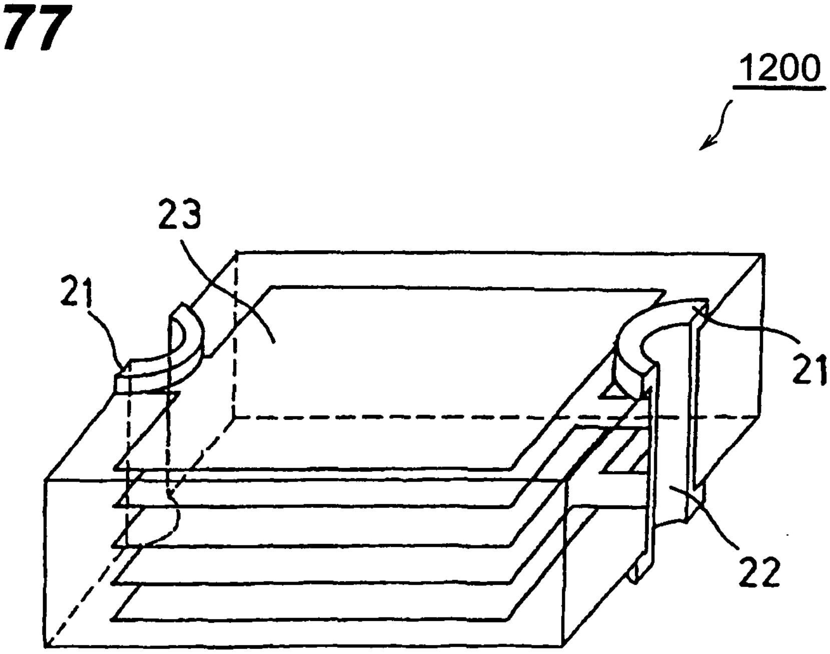
1200
23
21
21
22

*Fig.78*

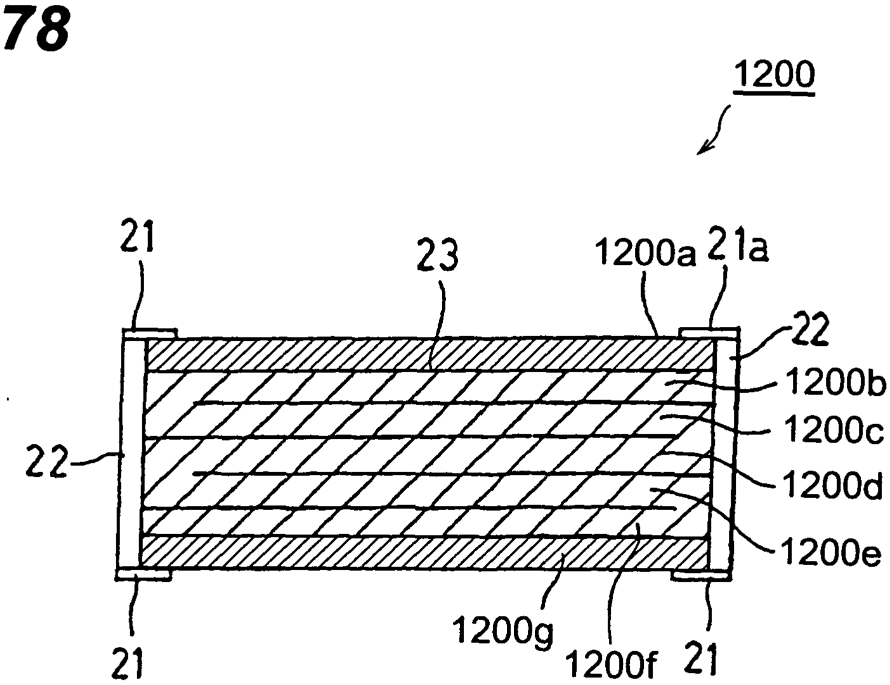
1200
21
23
1200a
21a
22
1200b
1200c
22
1200d
1200e
21
1200g
1200f
21

## Fig.79

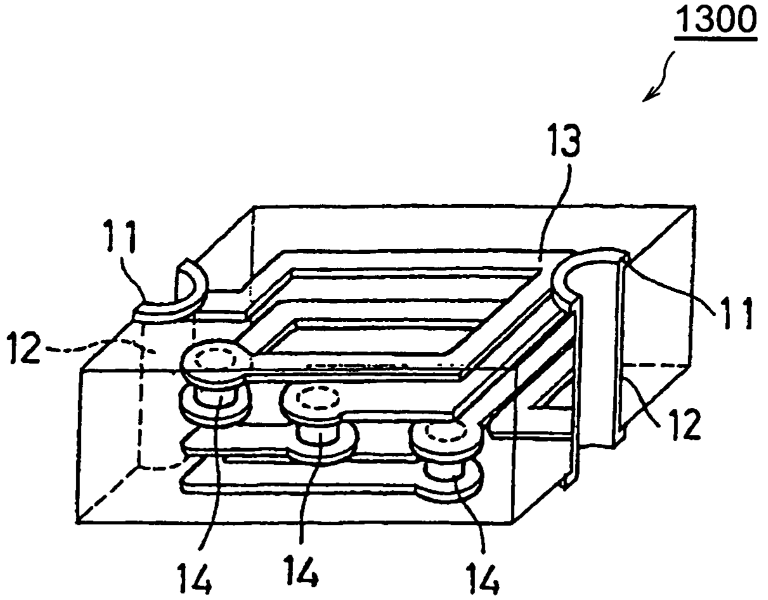
1300
13
11
11
12
12
14
14
14

## Fig.80

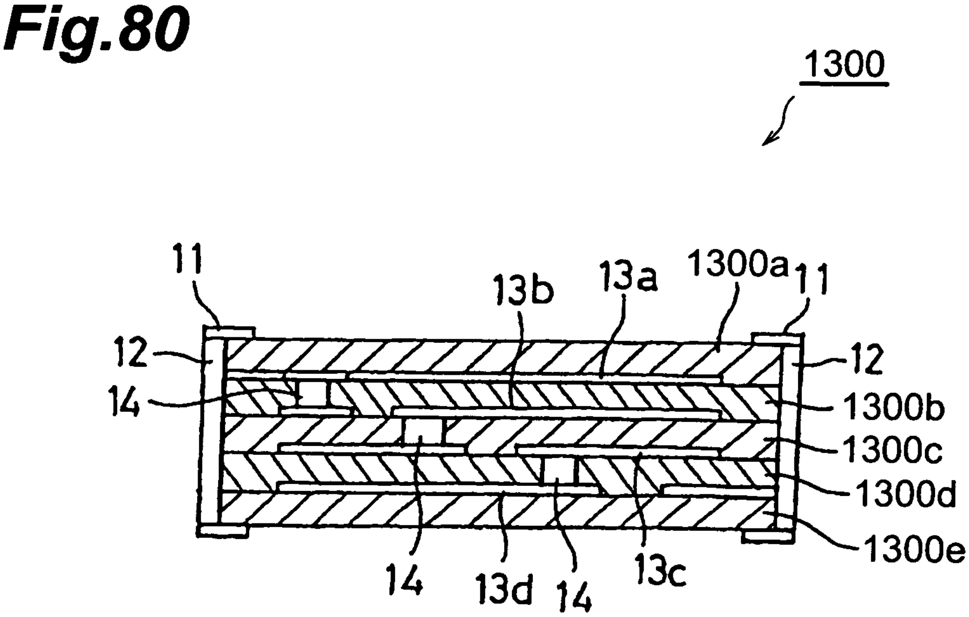
1300
11
13b
13a
1300a
11
12
12
14
1300b
1300c
1300d
1300e
14
13d
14
13c

*Fig.81*

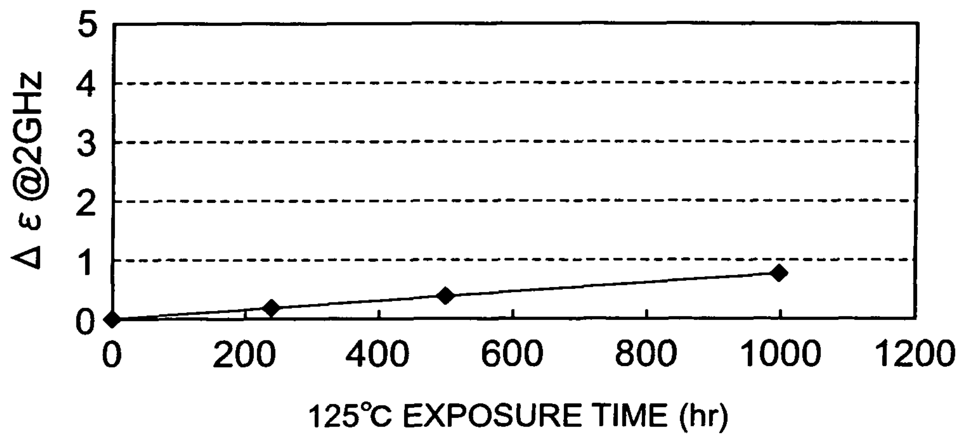

5
4
3
2
1
0
Δ ε @2GHz
0
200
400
600
800
1000
1200
125°C EXPOSURE TIME (hr)

Fig.82

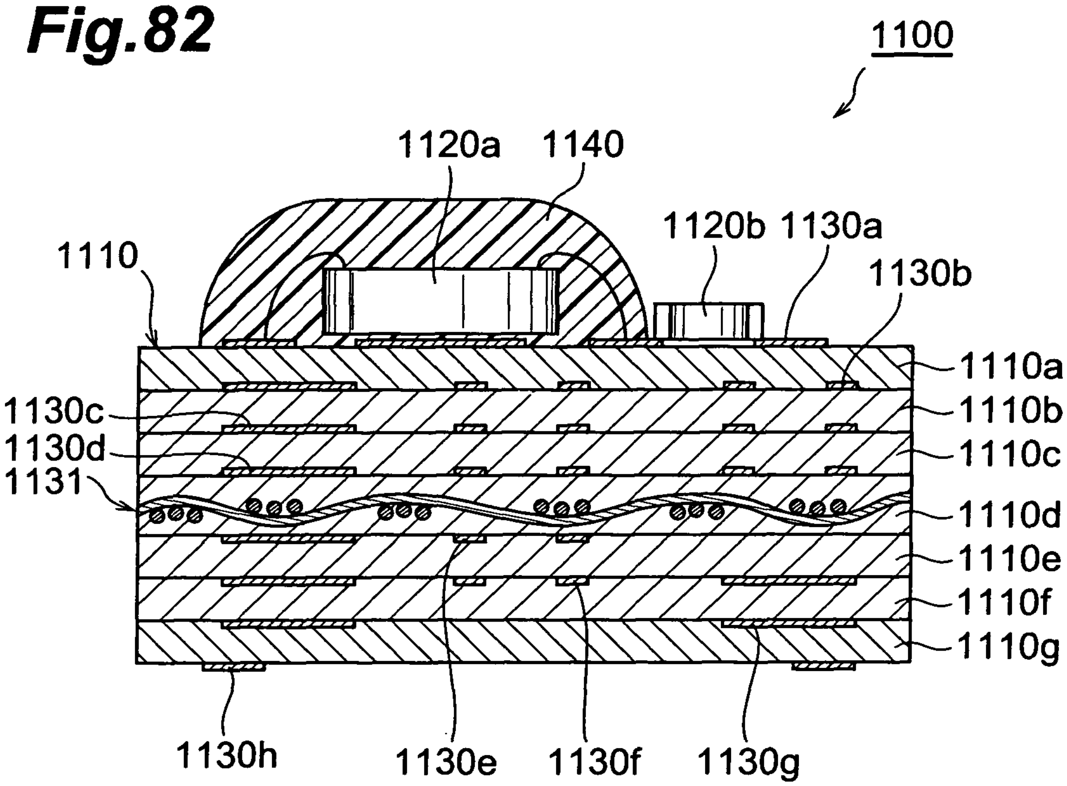
1100
1120a
1140
1120b
1130a
1130b
1110
1110a
1110b
1110c
1110d
1110e
1110f
1110g
1130c
1130d
1131
1130h
1130e
1130f
1130g

## INTERNATIONAL SEARCH REPORT

International application No.
PCT/JP03/17070

A. CLASSIFICATION OF SUBJECT MATTER
Int.Cl[7] C08L63/00, C08J5/24

According to International Patent Classification (IPC) or to both national classification and IPC

B. FIELDS SEARCHED

Minimum documentation searched (classification system followed by classification symbols)
Int.Cl[7] C08L63/00, C08G59/00, C08J5/24

Documentation searched other than minimum documentation to the extent that such documents are included in the fields searched

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2002-12650 A (Dainippon Ink And Chemicals, Inc.), 15 January, 2002 (15.01.02), Claims; Par. No. [0042] (Family: none) | 1-45 |
| Y | JP 11-130939 A (Hitachi Chemical Co., Ltd.), 18 May, 1999 (18.05.99), Claims (Family: none) | 1-45 |
| Y | JP 11-71501 A (Hitachi Chemical Co., Ltd.), 16 March, 1999 (16.03.99), Claims (Family: none) | 1-45 |

☒ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24 March, 2004 (24.03.04) | 13 April, 2004 (13.04.04) |
| Name and mailing address of the ISA/ Japanese Patent Office | Authorized officer |
| Facsimile No. | Telephone No. |

Form PCT/ISA/210 (second sheet) (July 1998)

## INTERNATIONAL SEARCH REPORT

International application No.
PCT/JP03/17070

C (Continuation). DOCUMENTS CONSIDERED TO BE RELEVANT

| Category* | Citation of document, with indication, where appropriate, of the relevant passages | Relevant to claim No. |
|---|---|---|
| Y | JP 10-101775 A (Research Development Corp. of Japan), 21 April, 1998 (21.04.98), Claims (Family: none) | 1-45 |
| Y | JP 2001-316500 A (Mitsubishi Gas Chemical Co., Inc.), 13 November, 2001 (13.11.01), Claims (Family: none) | 1-45 |
| Y | JP 2002-20510 A (Mitsubishi Gas Chemical Co., Inc.), 23 January, 2002 (23.01.02), Claims & EP 1097959 A1 & US 6562179 B | 1-45 |

Form PCT/ISA/210 (continuation of second sheet) (July 1998)

## INTERNATIONAL SEARCH REPORT

International application No.
PCT/JP03/17070

**Box I Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box II Observations where unity of invention is lacking (Continuation of item 3 of first sheet)**

This International Searching Authority found multiple inventions in this international application, as follows:

The technical feature common to claims 1-45 is a specific composition defined in claim 1.

Claims 46-58, however, do not involve this common feature as their special technical feature.

Consequently, there is no technical feature common to all of the claims 1-58.

Since there is no other common feature which can be considered as a special technical feature within the meaning of PCT Rule 13.2, second sentence, no technical relationship within the meaning of PCT Rule 13 among the different inventions can be seen. (Continued to extra sheet)

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.: 1-45

**Remark on Protest** ☐ The additional search fees were accompanied by the applicant's protest.

☐ No protest accompanied the payment of additional search fees.

Form PCT/ISA/210 (continuation of first sheet (1)) (July 1998)

## INTERNATIONAL SEARCH REPORT

International application No.
PCT/JP03/17070

Continuation of Box No.II of continuation of first sheet(1)

Therefore, claims 1-58 do not satisfy the requirement of unity of invention.

Form PCT/ISA/210 (extra sheet) (July 1998)